# EUROPEAN PATENT APPLICATION

(11) **EP 3 992 199 A1**
(43) Date of publication of application: **04.05.2022**
(21) Application number: 21203079.5
(22) Date of filing: 18.10.2021
(51) Int. Cl.: C07F 15/00, C09K 11/06, H01L 51/00

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 28.10.2020 KR 20200141452
(71) Applicant: Samsung Electronics Co., Ltd., Suwon-si, Gyeonggi-do 16677 (KR)
(72) Inventor: HWANG, Kyuyoung, Suwon-si 16678 (KR); KANG, Byungjoon, Suwon-si 16678 (KR); SIM, Myungsun, Suwon-si 16678 (KR); ARATANI, Sukekazu, Suwon-si 16678 (KR); LEE, Kum Hee, Suwon-si 16678 (KR); LEE, Banglin, Suwon-si 16678 (KR); CHOI, Byoungki, Suwon-si 16678 (KR)
(74) Representative: Elkington and Fife LLP

(57) **Abstract**

An organometallic compound represented by Formula 1: 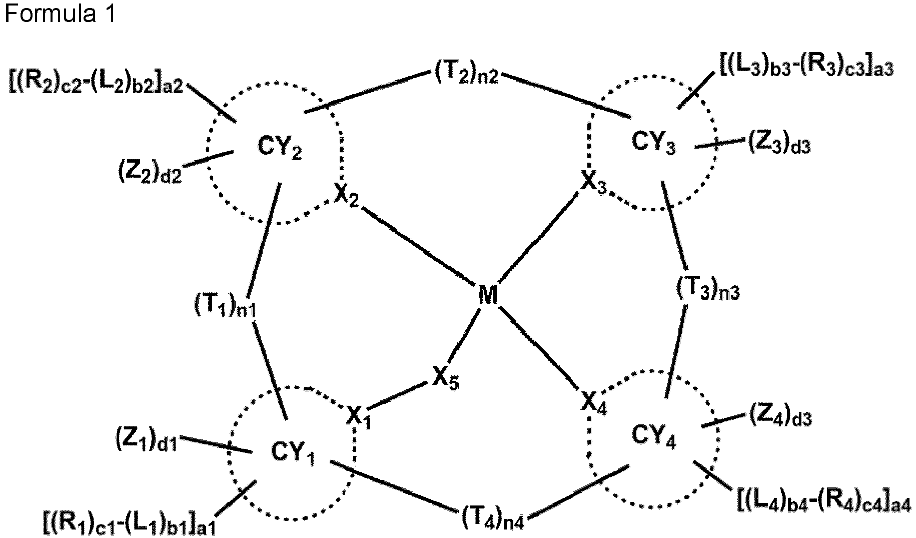 wherein, in Formula 1, M is a transition metal, X₁ to X₄ each independently C or N, X₅ is O, S, N(R'), C(R')(R"), or C(=O), wherein a bond between X₅ and M is a covalent bond, and one of a bond between X₂ and M, a bond between X₃ and M, and a bond between X₄ and M is a covalent bond, and the other two are each a coordinate bond, ring CY₁ to ring CY₄ are each independently a C₅-C₃₀ carbocyclic group or a C₁-C₃₀ heterocyclic group, and wherein T₁ to T₄, n1 to n4, Z₁ to Z₄, d1 to d4, L₁ to L₄, R₁ to R₄, a1 to a4, b1 to b4, and c1 to c4 are as provided herein.

## Description

### FIELD OF THE INVENTION

One or more embodiments that relate to an organometallic compound, an organic light-emitting device including the same, and an electronic apparatus including the organic light-emitting device are described herein.

### BACKGROUND OF THE INVENTION

Organic light-emitting devices (OLEDs) are self-emission devices that have improved characteristics compared to conventional devices, including wider viewing angles, faster response times, excellent brightness, driving voltage, and response speed, and the OLEDs produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons may then transition from an excited state to a ground state to thereby generate light, for example, visible light.

### SUMMARY OF THE INVENTION

One or more embodiments relate to an organometallic compound, an organic light-emitting device including the same, and an electronic apparatus including the organic light-emitting device.

Additional aspects will be set forth in part in the description which follows and, in part, will be apparent from the description, or may be learned by practice of the presented embodiments of the disclosure.

According to an aspect, provided is an organometallic compound represented by Formula 1. 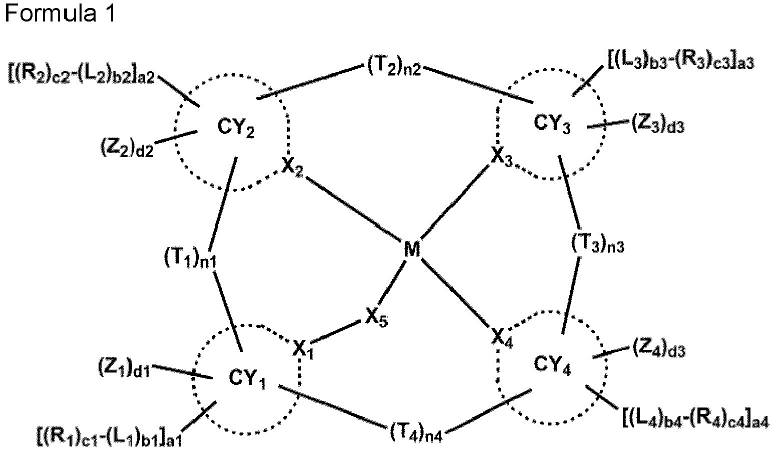 wherein, in Formula 1,
M is a transition metal,
X₁ to X₄ in Formula 1 are each independently C or N,
X₅ in Formula 1 is O, S, N(R'), C(R')(R"), or C(=O),
wherein,
a bond between X₅ and M in Formula 1 is a covalent bond, and
one of a bond between X₂ and M in Formula 1, a bond between X₃ and M in Formula 1, and a bond between X₄ and M in Formula 1 is a covalent bond, and the other two are each a coordinate bond,
ring CY₁ to ring CY₄ in Formula 1 are each independently be a C₅-C₃₀ carbocyclic group or a C₁-C₃₀ heterocyclic group,
T₁ to T₄ in Formula 1 may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
n1 to n4 in Formula 1 may each independently be 0 or 1, wherein at least three of n1 to n4 may each be 1,
when n1 in Formula 1 is 0, T₁ is not present, when n2 in Formula 1 is 0, T₂ is not present, when n3 in Formula 1 is 0, T₃ is not present, and when n4 in Formula 1 is 0, T₄ is not present,
Z₁ to Z₄ in Formula 1 may each independently be a group represented by Formula 51, 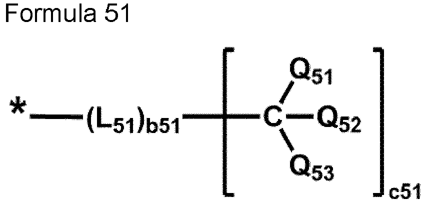 d1 to d4 in Formula 1 are each independently an integer from 0 to 20,
L₁ to L₄ and L₅₁ in Formulae 1 and 51 are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b1 to b4 and b51 in Formulae 1 and 51 are each independently an integer from 1 to 10,
R₁ to R₄, R₅ₐ, R_{5b}, R', R", and Q₅₁ to Q₅₃ in Formulae 1 and 51 are each independently a group represented by Formula 51, hydrogen, deuterium, -F, - CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), or -P(Q₈)(Q₉), and
provided that none of Q₅₁ to Q₅₃ is a group represented by Formula 51,
at least one of Q₅₁ to Q₅₃ in Formula 51 may each independently be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
c1 to c4 and a1 to a4 in Formula 1 may each independently be an integer from 0 to 20,
c51 in Formula 51 may be an integer from 1 to 20,
Formula 1 may satisfy at least one of Condition 1 and Condition 2,
Condition 1
   a sum of d1 to d4 in Formula 1 is 1 or more
Condition 2
   at least one of T₁ to T₄ in Formula 1 is *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-C(R₅ₐ)=*', *=C(R₅ₐ)-*', or *-C(R₅ₐ)=C(R_{5b})-*', and
   at least one of R₅ₐ and R_{5b} is a group represented by Formula 51
two or more of a plurality of R₁(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₂(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₃(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₄(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of R₁ to R₄, R₅ₐ and one or more of R₁ to R₄, R_{5b} and one or more of R₁ to R₄, or R₅ₐ and R_{5b} are each optionally bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ are as defined in connection with R₁,
* and *' each indicate a binding site to a neighboring atom, and
the substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉), or a combination thereof,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof,
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉), or
a combination thereof,
wherein Q₁ to Q₉, Q₁₁ to Q₁₉, Q₂₁ to Q₂₉, and Q₃₁ to Q₃₉ are each independently hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₁-C₆₀ heteroaryl group; a heteroaryloxy group; a C₁-C₆₀ heteroarylthio group; a monovalent non-aromatic condensed polycyclic group; or a monovalent non-aromatic condensed heteropolycyclic group.

According to another aspect, provided is an organic light-emitting device including a first electrode, a second electrode, and an organic layer located between the first electrode and the second electrode, wherein the organic layer includes an emission layer, and wherein the organic layer includes at least one organometallic compound represented by Formula 1.

According to another aspect, provided is an electronic apparatus including the organic light-emitting device.

The organometallic compound may be included in the emission layer of the organic layer, and the organometallic compound included in the emission layer may act as a dopant.

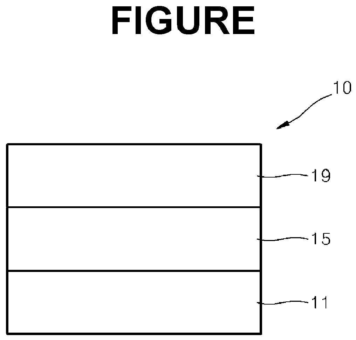

### BRIEF DESCRIPTION OF THE DRAWING

The above and other aspects, features, and advantages of certain embodiments of the disclosure will be more apparent from the following description taken in conjunction with the accompanying drawing, in which

FIGURE is a schematic cross-sectional view of an organic light-emitting device according to aspects of one or more embodiments.

### DETAILED DESCRIPTION OF THE EMBODIMENTS

Reference will now be made in detail to exemplary embodiments, examples of which are illustrated in the accompanying drawing, wherein like reference numerals refer to like elements throughout. In this regard, the present exemplary embodiments may have different forms and should not be construed as being limited to the descriptions set forth herein. Accordingly, the exemplary embodiments are described below, by referring to the figure, to explain one or more aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An aspect of the present disclosure provides an organometallic compound represented by Formula 1: 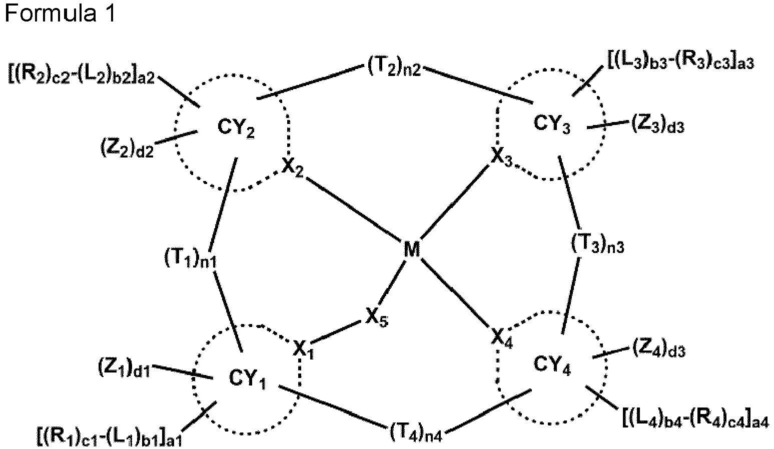 wherein M in Formula 1 is a transition metal.

In one or more embodiments, M may be Period 1 transition metal, Period 2 transition metal, or Period 3 transition metal of Periodic Table Elements.

In one or more embodiments, M may be iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

In one or more embodiments, M in Formula 1 may be Pt, Pd, or Au.

X₁ to X₄ in Formula 1 may each independently be C or N.

In one or more embodiments, X₁ and X₃ in Formula 1 may be C, and X₂ and X₄ in Formula 1 may be N.

X₅ in Formula 1 is O, S, N(R'), C(R')(R"), or C(=O).

The bond between X₅ and M in Formula 1 may be a covalent bond.

One of a bond between X₂ and M in Formula 1, a bond between X₃ and M in Formula 1, and a bond between X₄ and M in Formula 1 may be a covalent bond, and the other two may each be a coordinate bond.

In one or more embodiments, a bond between X₂ and M in Formula 1 may be a coordinate bond.

In one or more embodiments, a bond between X₅ and M in Formula 1 and a bond between X₃ and M in Formula 1 may each be a covalent bond, and a bond between X₂ and M in Formula 1 and a bond between X₄ and M in Formula 1 may each be a coordinate bond.

Ring CY₁ to ring CY₄ in Formula 1 are each independently a C₅-C₃₀ carbocyclic group or a C₁-C₃₀ heterocyclic group.

In one or more embodiments, ring CY₁ to ring CY₄ in Formula 1 may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring CY₁ to ring CY₄ in Formula 1 may each independently be a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, ring CY₁ and ring CY₃ may each independently be:
a benzene group, a naphthalene group, a fluorene group, a carbazole group, a dibenzothiophene group, or a dibenzofuran group; or
a benzene group, a naphthalene group, a fluorene group, a carbazole group, a dibenzothiophene group, or a dibenzofuran group, each condensed with a cyclohexane group, a cyclohexene group, a norbornane group, or a combination thereof.

In one or more embodiments, X₂ may be **N**, and ring CY₂ may be:
a benzimidazole group, a pyridine group, a pyrimidine group, a pyridazine group, a pyrazine group, a triazine group, a quinoline group, an isoquinoline group, a quinoxaline group, or a quinazoline group; or
a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, or a combination thereof.

In one or more embodiments, ring CY₄ may be:
a pyridine group, a pyrimidine group, a pyridazine group, a pyrazine group, a triazine group, a quinoline group, an isoquinoline group, a quinoxaline group, or a quinazoline group; or
a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, or a combination thereof.

T₁ to T₄ in Formula 1 may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In one or more embodiments, T₁ and T₂ in Formula 1 may each be a single bond, and T₃ in Formula 1 may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

Each of n1 to n4 in Formula 1 indicate a number for each of T₁ to T₄, respectively, and are each independently 0 or 1, wherein at least three of n1 to n4 may each be 1. In other words, a ligand of the organometallic compound represented by Formula 1 may be a tetradentate ligand. For example, a sum of n1 to n4 may be 3 or 4.

When n1 in Formula 1 is 0, T₁ is not present, when n2 in Formula 1 is 0, T₂ is not present, when n3 in Formula 1 is 0, T₃ is not present, and when n4 in Formula 1 is 0, T₄ is not present.

In one or more embodiments, n1 to n3 in Formula 1 may each be 1, and n4 in Formula 1 may be 0.

Z₁ to Z₄ in Formula 1 are each independently a group represented by Formula 51: 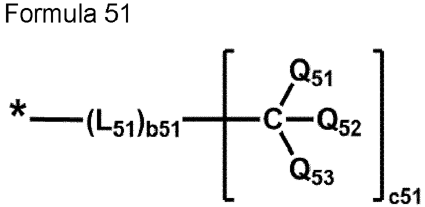 wherein Formula 51 is the same as described herein.

Each of d1 to d4 in Formula 1 indicates a number for each of Z₁ to Z₄, respectively, and are each independently an integer from 0 to 20. When d1 is 2 or more, two or more of Z₁(s) are identical to or different from each other, when d2 is 2 or more, two or more of Z₂(s) are identical to or different from each other, when d3 is 2 or more, two or more of Z₃(s) are identical to or different from each other, and when d4 is 2 or more, two or more of Z₄(s) are identical to or different from each other. In one or more embodiments, d1 to d4 may each independently be 0, 1, 2, or 3.

L₁ to L₄ and L₅₁ in Formulae 1 and 51 are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In one or more embodiments, L₁ to L₄ and L₅₁ in Formulae 1 and 51 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In one or more embodiments, L₁ to L₄ and L₅₁ in Formulae 1 and 51 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

Each of b1 to b4 and b51 in Formulae 1 and 51 may indicate a number for each of L₁ to L₄ and L₅₁, respectively, and are each independently an integer from 1 to 10. When b1 is 2 or more, two or more of L₁(s) may be identical to or different from each other, when b2 is 2 or more, two or more of L₂(s) may be identical to or different from each other, when b3 is 2 or more, two or more of L₃(s) may be identical to or different from each other, when b4 is 2 or more, two or more of L₄(s) may be identical to or different from each other, and when b51 is 2 or more, two or more of L₅₁(s) may be identical to or different from each other. In one or more embodiments, b1 to b4 and b51 may each independently be 1, 2, or 3.

R₁ to R₄, R₅ₐ, R_{5b}, R', R", and Q₅₁ to Q₅₃ in Formulae 1 and 51 are each independently a group represented by Formula 51, hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), or -P(Q₈)(Q₉), wherein at least one of Q₅₁ to Q₅₃ in Formula 51 are each independently a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group. Q₁ to Q₉ may each be the same as described in the present specification.

None of Q₅₁ to Q₅₃ is a group represented by Formula 51. In other words, each of Q₅₁ to Q₅₃ is not a group represented by Formula 51.

In one or more embodiments, R₁ to R₄, R' and R" Formula 1 and Q₅₁ to Q₅₃ may not be a group represented by Formula 51.

In one or more embodiments, R₁ to R₄, R₅ₐ, R_{5b}, R', R", and Q₅₁ to Q₅₃ in Formulae 1 and 51 may each independently be:
a group represented by Formula 51, hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkenyl group, a C₁-C₂₀ alkoxy group, or a C₁-C₂₀ alkylthio group;
a C₁-C₂₀ alkyl group, a C₁-C₂₀ alkenyl group, a C₁-C₂₀ alkoxy group, or a C₁-C₂₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group (a (C₁-C₂₀ alkyl)bicyclo[2.2.1]heptyl group), a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉),
   wherein Q₁ to Q₉ may each independently be:
   deuterium, -F, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, - CD₂CD₃, -CD₂CD₂H, -CD₂CDH₂, -CF₃, -CF₂H, -CFH₂, -CH₂CF₃, -CH₂CF₂H, - CH₂CFH₂, -CHFCH₃, -CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or a combination thereof,
   provided that none of Q₅₁ to Q₅₃ is a group represented by Formula 51.

In one or more embodiments, R₁ to R₄, R₅ₐ, R_{5b}, R', and R" in Formula 1 may each independently be:
a group represented by Formula 51, hydrogen, deuterium, -F, or a cyano group;
a C₁-C₂₀ alkyl group that is unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or a combination thereof; or
-Si(Q₃)(Q₄)(Q₅) or -Ge(Q₃)(Q₄)(Q₅).

In one or more embodiments, in Formula 51, Q₅₁ to Q₅₃ may each independently be:
hydrogen, deuterium, -F, or a cyano group;
a C₁-C₂₀ alkyl group that is unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, or a combination thereof; or
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or a combination thereof,
wherein at least one of Q₅₁ to Q₅₃ (for example, Q₅₃) may be a phenyl group, a biphenyl group, a naphthyl group, a pyridinyl group, a fluorenyl group, a carbazolyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or a combination thereof.

In one or more embodiments, in Formula 51, i) Q₅₁ and Q₅₂ may each independently be hydrogen or deuterium, ii) Q₅₁ may be hydrogen or deuterium, and Q₅₂ may be neither hydrogen nor deuterium, or iii) both of Q₅₁ and Q₅₂ may be neither hydrogen nor deuterium.

In one or more embodiments, R₁ to R₄, R₅ₐ, R_{5b}, R', R", and Q₅₁ to Q₅₃ in Formulae 1 and 51 may each independently be a group represented by Formula 51, hydrogen, deuterium, -F, -CH₃, -CD₃, -CD₂H, -CDH₂, -CF₃, -CF₂H, -CFH₂, a C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (wherein Q₃ to Q₅ may each be the same as described in the present specification), and provided that none of Q₅₁ to Q₅₃ is a group represented by Formula 51.

In one or more embodiments, in Formula 51, Q₅₁ and Q₅₂ may each independently be hydrogen or deuterium, and Q₅₃ may be a group represented by one of Formulae 10-12 to 10-129, a group represented by one of Formulae 10-12 to 10-129 in which at least one hydrogen is substituted with deuterium, a group represented by one of Formulae 10-12 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F.

In one or more embodiments, in Formula 51, Q₅₁ may be hydrogen or deuterium, and Q₅₂ may be -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, or a group represented by one of Formulae 9-1 to 9-39 in which at least one hydrogen is substituted with -F, and Q₅₃ may be a group represented by one of Formulae 10-12 to 10-129, a group represented by one of Formulae 10-12 to 10-129 in which at least one hydrogen is substituted with deuterium, a group represented by one of Formulae 10-12 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F.

In one or more embodiments, in Formula 51, Q₅₁ and Q₅₂ may each independently be -CH₃, -CD₃, -CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, or a group represented by one of Formulae 9-1 to 9-39 in which at least one hydrogen is substituted with -F, and Q₅₃ may be a group represented by one of Formulae 10-12 to 10-129, a group represented by one of Formulae 10-12 to 10-129 in which at least one hydrogen is substituted with deuterium, a group represented by one of Formulae 10-12 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F.

In one or more embodiments, at least one of Q₅₁ to Q₅₃ in Formula 51 (for example, one of Q₅₁ to Q₅₃) may be a group represented by one of Formulae 10-12 to 10-129, a group represented by one of Formulae 10-12 to 10-129 in which at least one hydrogen is substituted with deuterium, a group represented by one of Formulae 10-12 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F: 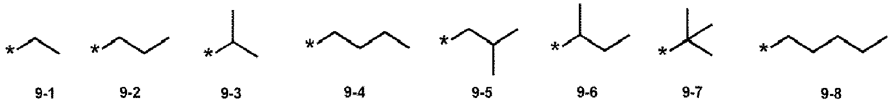 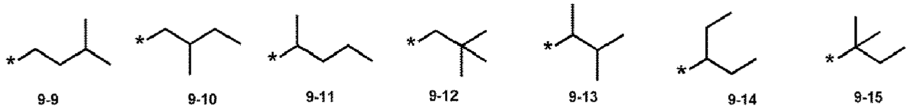 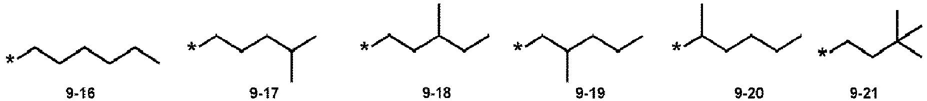 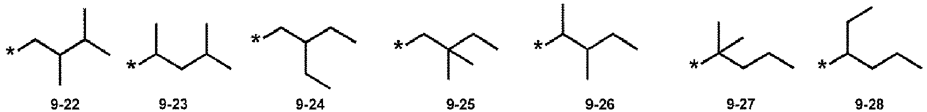 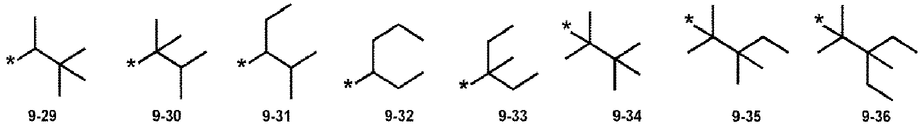 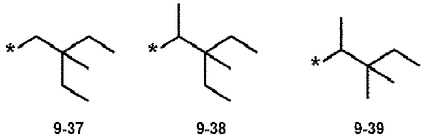 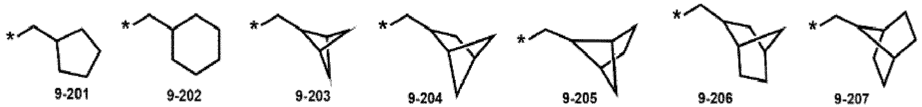 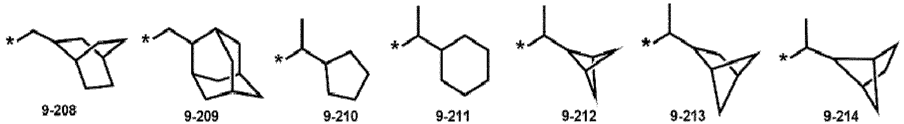 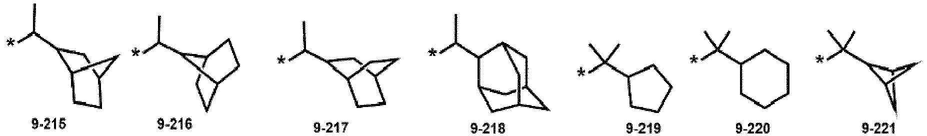 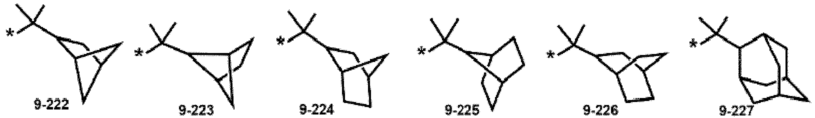 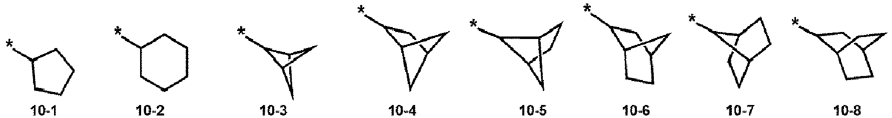 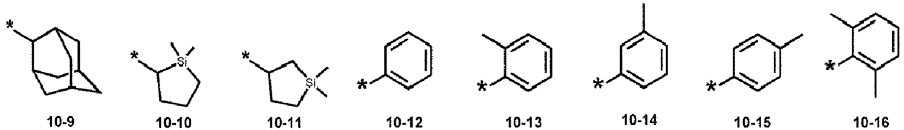 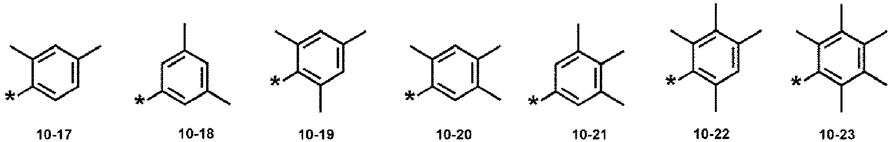 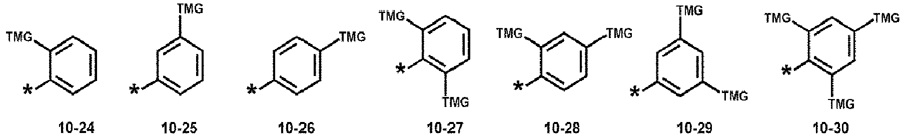 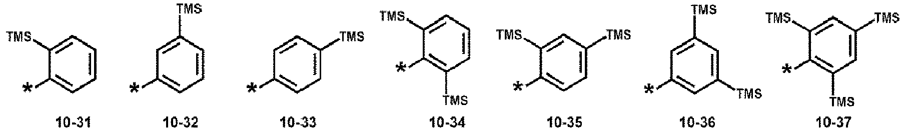 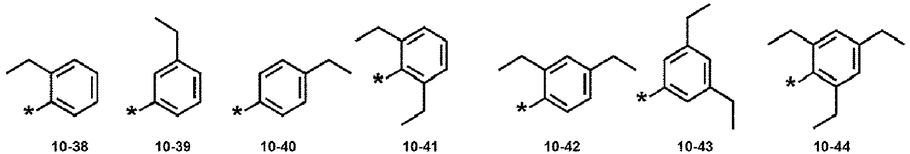 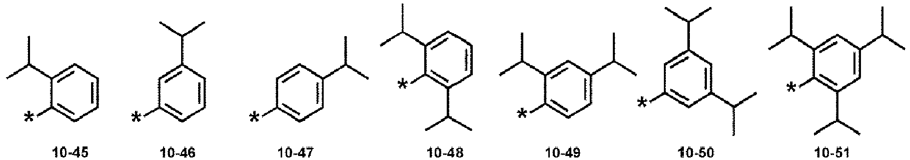 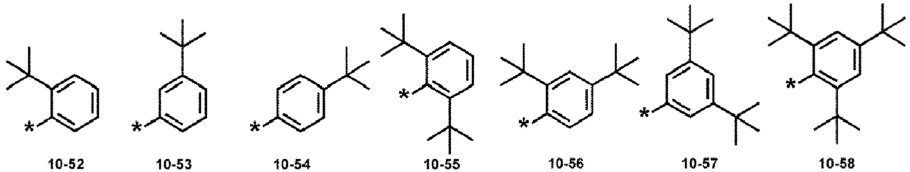 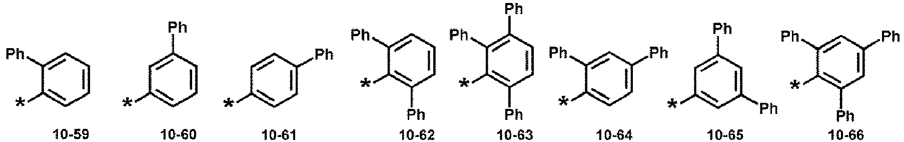 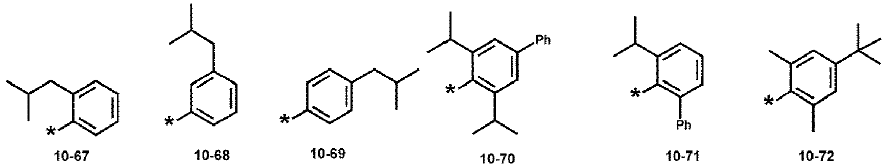 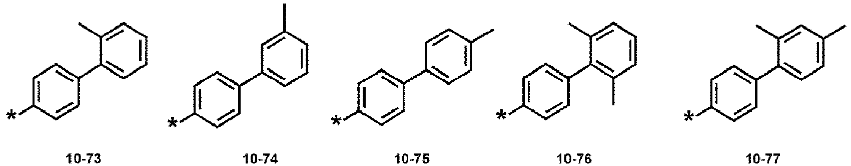 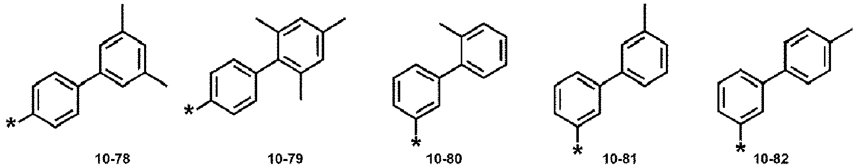 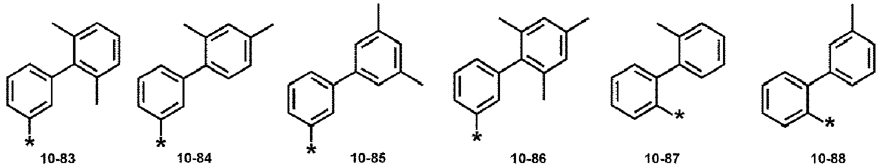 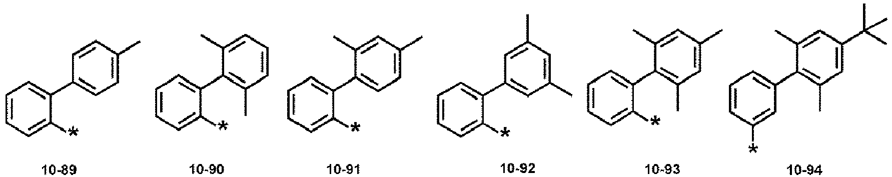 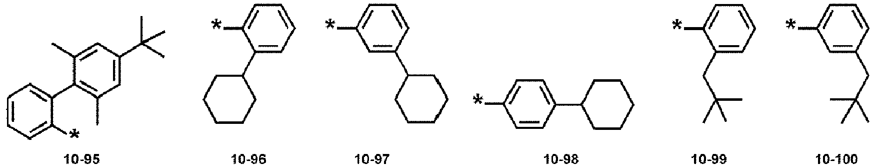 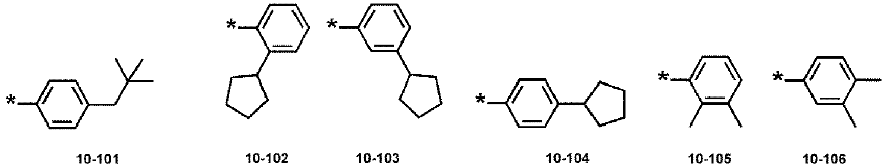 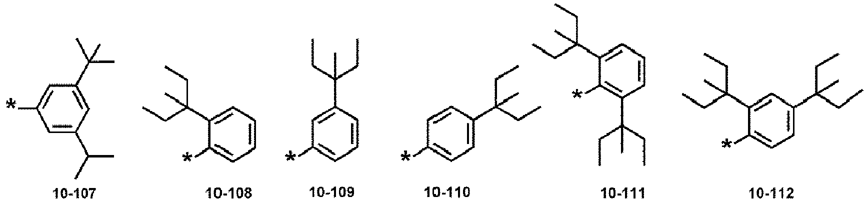 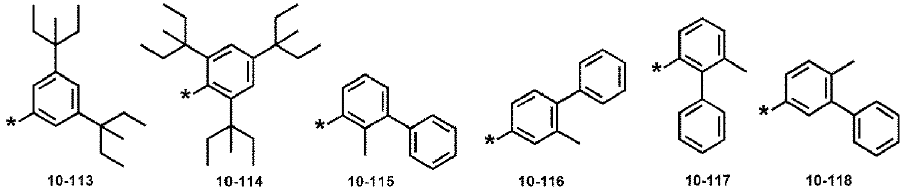 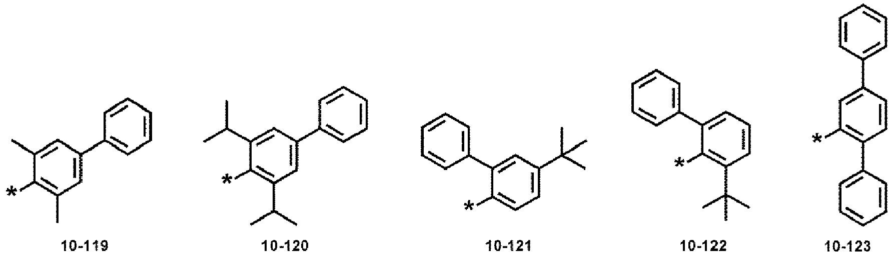 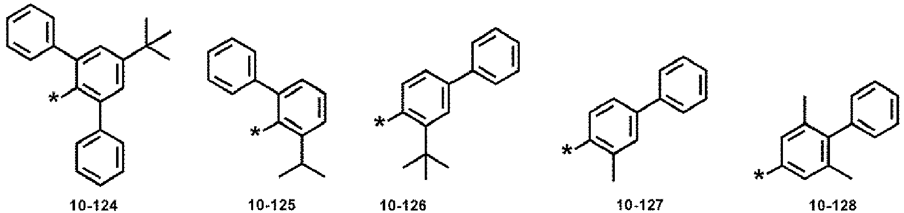 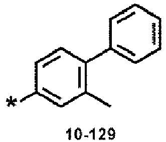 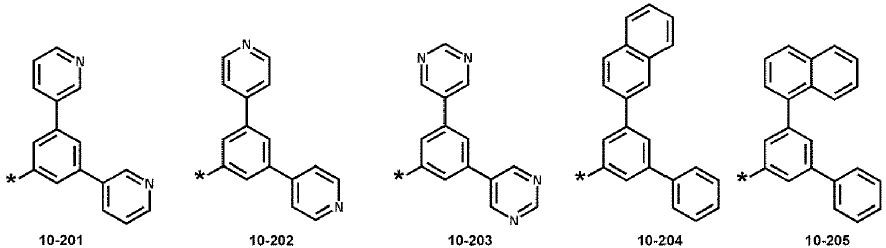 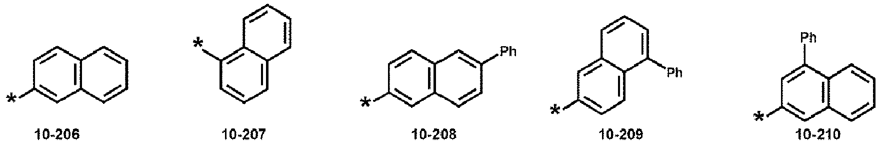 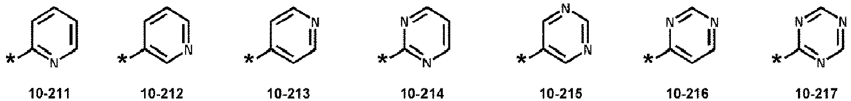 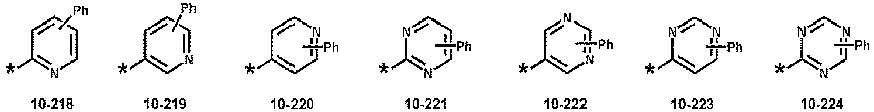 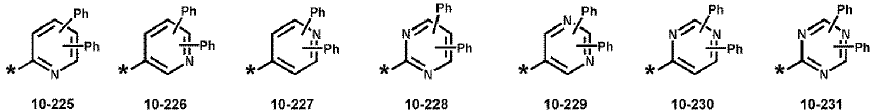 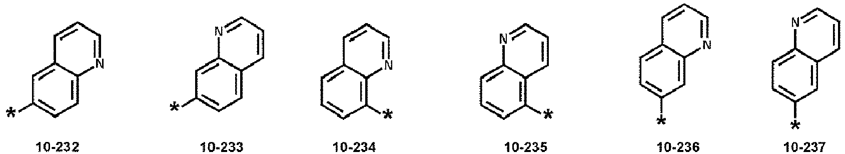 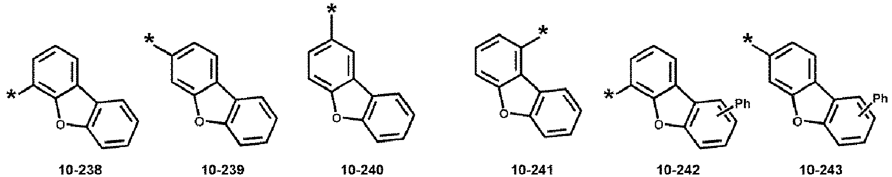 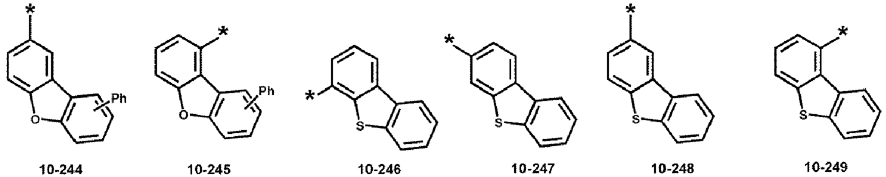 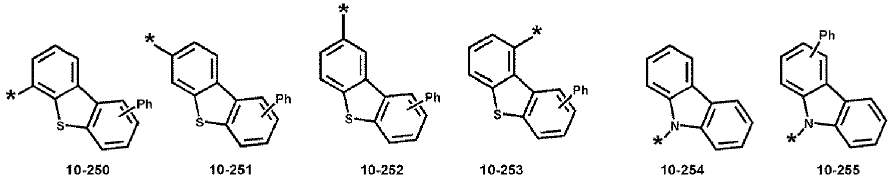 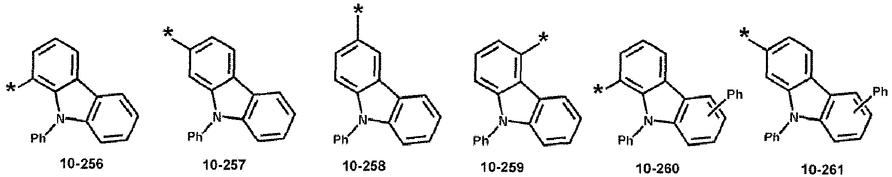 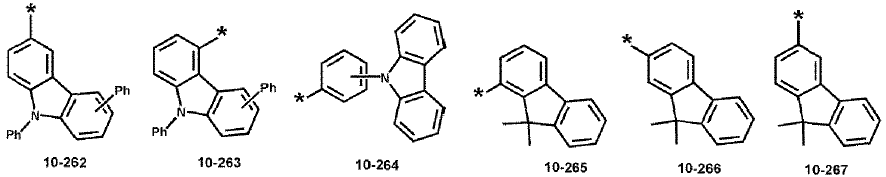 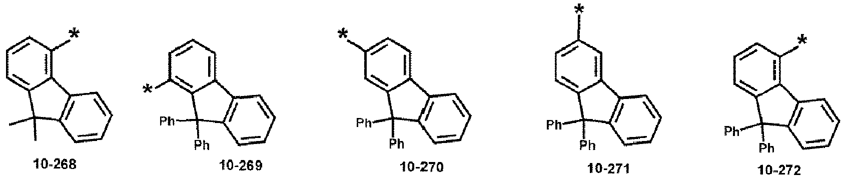 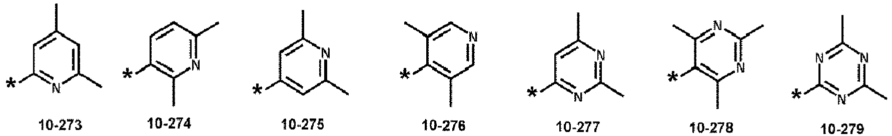 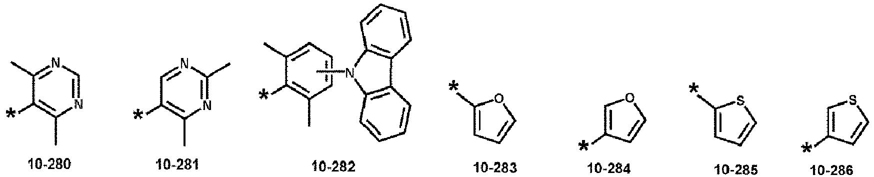 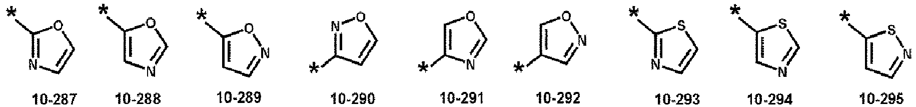 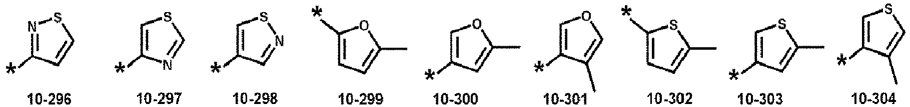 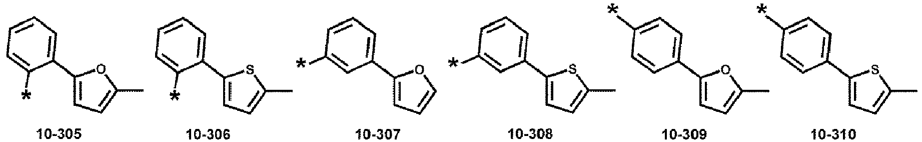 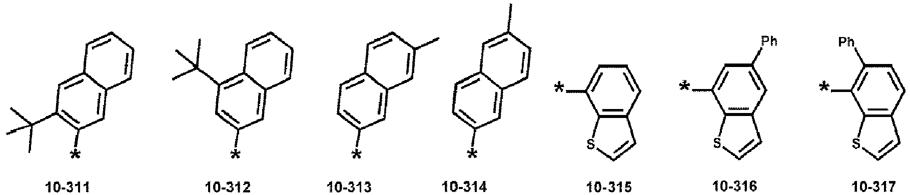 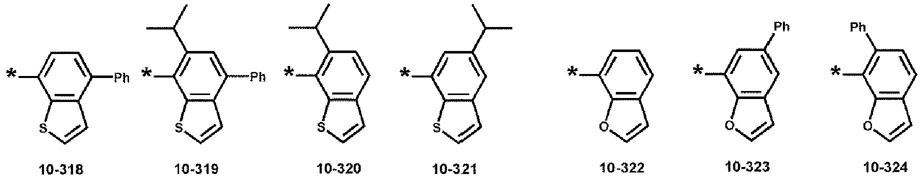 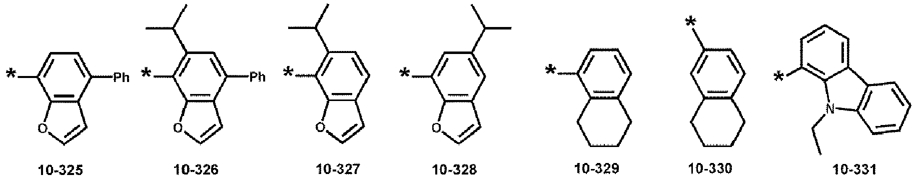 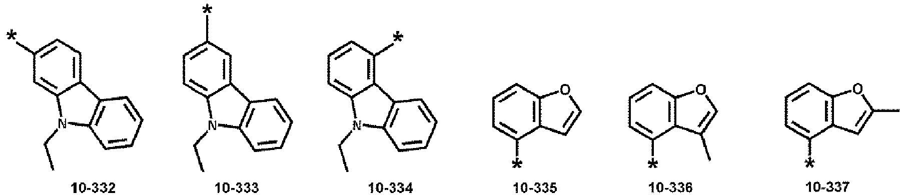 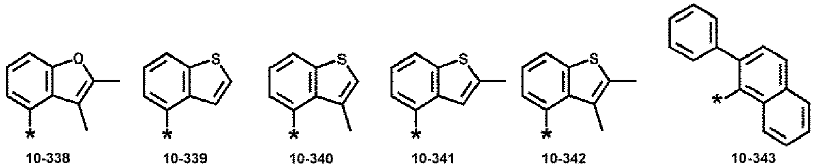 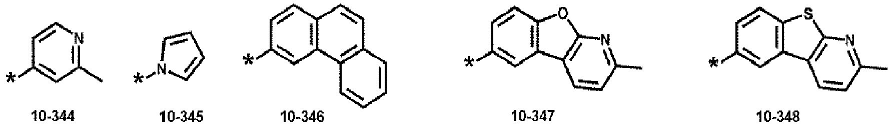 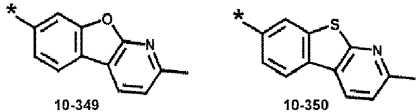 wherein * in Formulae 9-1 to 9-39, 9-201 to 9-227, 10-1 to 10-129, and 10-201 to 10-350 indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may be, for example, a group represented by one of Formulae 9-501 to 9-514 and 9-601 to 9-636:

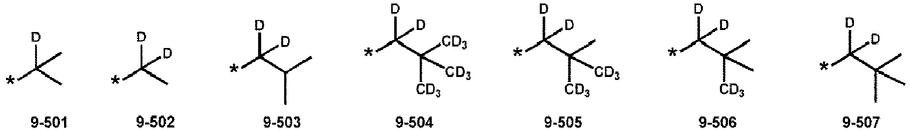

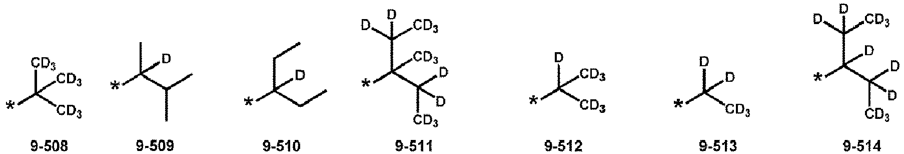

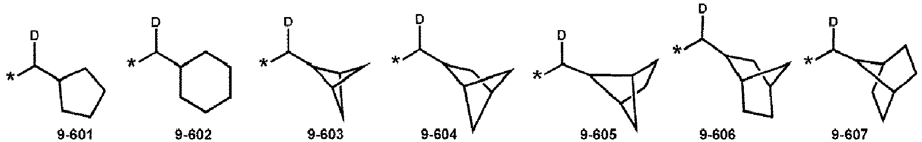

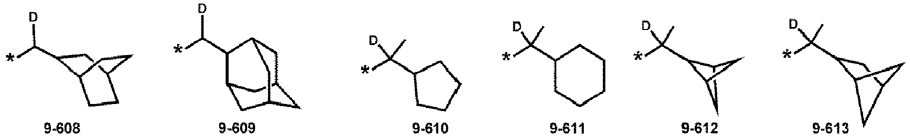

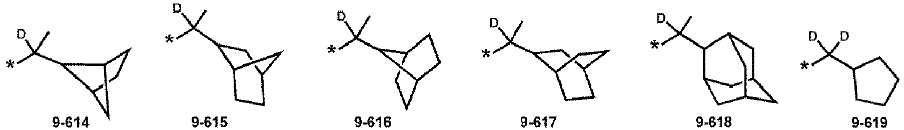

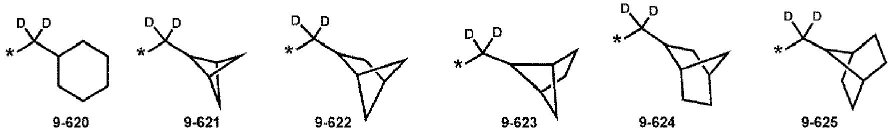

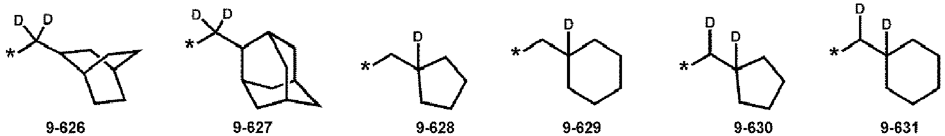

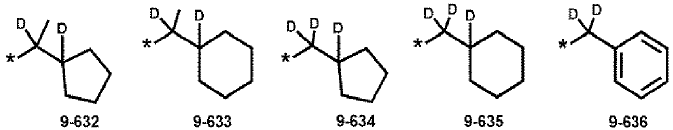

The "group represented by one of Formulae 9-1 to 9-39 in which at least one hydrogen is substituted with -F" and the "group represented by one of Formulae 9-201 to 9-227 in which at least one hydrogen is substituted with -F" may be, for example, a group represented by one of Formulae 9-701 to 9-710:

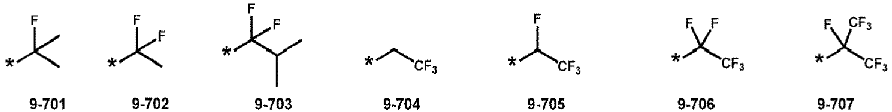

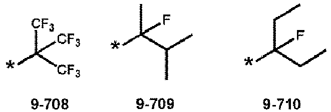

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

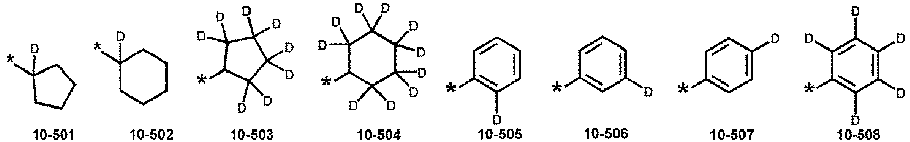

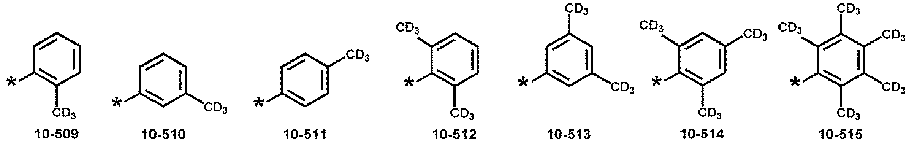

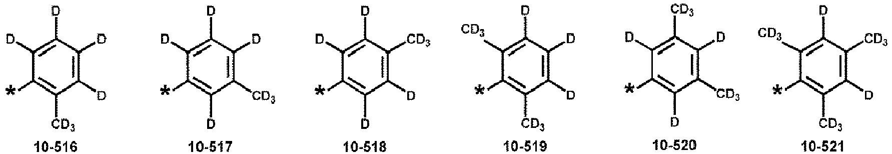

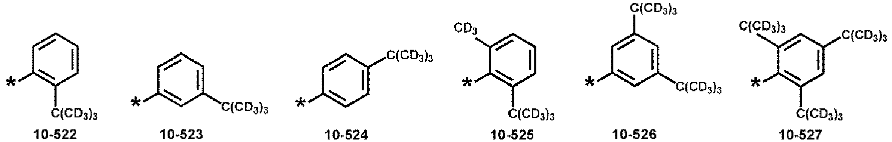

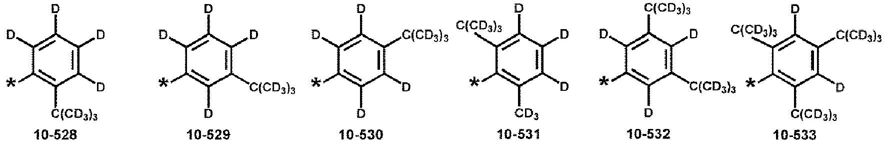

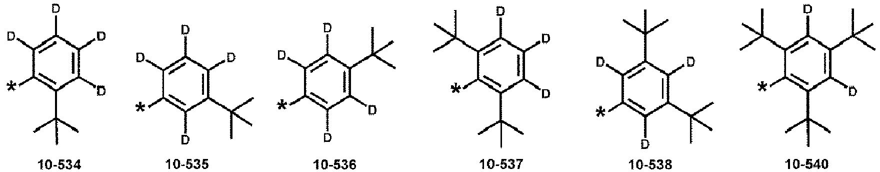

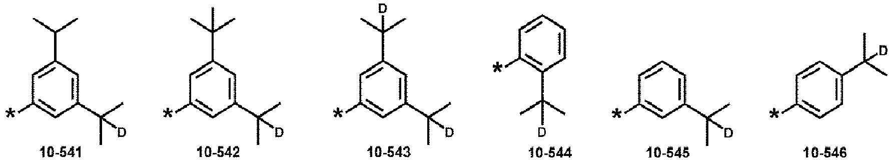

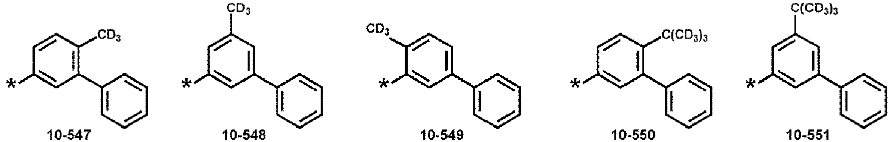

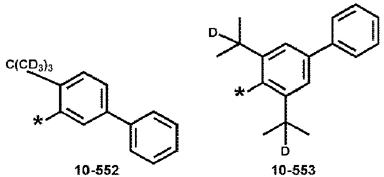

The "group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617: 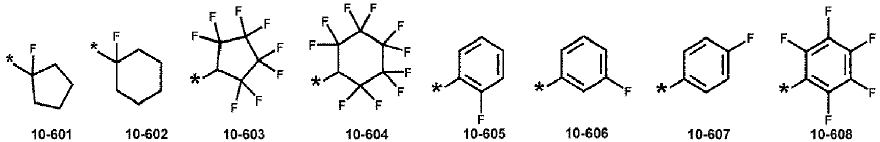 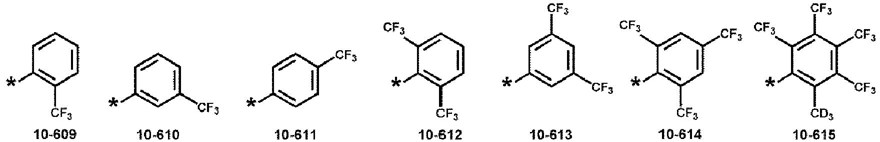 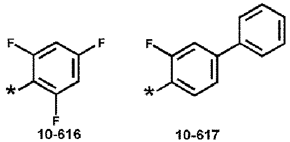 wherein c1 to c4 and a1 to a4 in Formula 1 may indicate numbers of R₁ to R₄, a group represented by *-[(L₁)_{b1}-(R₁)_{c1}], a group represented by *-[(L₂)_{b2}-(R₂)_{c2}], a group represented by *-[(L₃)_{b3}-(R₃)_{c3}], and a group represented by *-[(L₄)_{b4}-(R₄)_{c4}], respectively, and may each independently be an integer from 0 to 20. When c1 is 2 or more, two or more of R₁(s) may be identical to or different from each other, when c2 is 2 or more, two or more of R₂(s) may be identical to or different from each other, when c3 is 2 or more, two or more of R₃(s) may be identical to or different from each other, when c4 is 2 or more, two or more of R₄(s) may be identical to or different from each other, when a1 is 2 or more, two or more of groups represented by *-[(L₁)_{b1}-(R₁)_{c1}] may be identical to or different from each other, when a2 is 2 or more, two or more of groups represented by *-[(L₂)_{b2}-(R₂)_{c2}] may be identical to or different from each other, when a3 is 2 or more, two or more of groups represented by *-[(L₃)_{b3}-(R₃)_{c3}] may be identical to or different from each other, and when a4 is 2 or more, two or more of groups represented by *-[(L₄)_{b4}-(R₄)_{c4}] may be identical to or different from each other. In one or more embodiments, c1 to c4 and a1 to a4 in Formula 1 may each independently be 0, 1, 2, or 3.

c51 in Formula 51 may indicate the number of groups represented by *-C(Q₅₁)(Q₅₂)(Q₅₃) and may be an integer from 1 to 20. When c51 is 2 or more, two or more groups represented by *-C(Q₅₁)(Q₅₂)(Q₅₃) may be identical to or different from each other. In one or more embodiments, c51 may be 1 or 2.

The organometallic compound represented by Formula 1 may satisfy at least one of Condition 1 and Condition 2:
Condition 1
   the sum of d1 to d4 in Formula 1 is 1 or more
Condition 2
   at least one of T₁ to T₄ in Formula 1 is *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-C(R₅ₐ)=*', *=C(R₅ₐ)-*', or *-C(R₅ₐ)=C(R_{5b})-*', and
   at least one of R₅ₐ and R_{5b} is a group represented by Formula 51

In other words, the organometallic compound represented by Formula 1 may include at least one group represented by Formula 51.

In one or more embodiments, the organometallic compound represented by Formula 1 may satisfy at least one of Condition 1A and Condition 2A:
Condition 1A
   in Formula 1,
   i) d1 is 1, and each of d2, d3, and d4 is 0;
   ii) d2 is 1, and each of d1, d3, and d4 is 0;
   iii) d3 is 1, and each of d1, d2, and d4 is 0;
   iv) d4 is 1, and each of d1, d2, and d3 is 0;
   v) each of d1 and d2 is 1, and each of d3 and d4 is 0;
   vi) each of d2 and d3 is 1, and each of d1 and d4 is 0; or
   vii) each of d2 and d4 is 1, and each of d1 and d3 is 0.
Condition 2A
   in Formula 1, n3 is 1, and
   i) T₃ is *-N(R₅ₐ)-*', *-B(R₅ₐ)-*', *-P(R₅ₐ)-*', *-C(R₅ₐ)=*', or *=C(R₅ₐ)-*', and R₅ₐ is a group represented by Formula 51; or
   ii) T₃ is *-C(R₅ₐ)(R_{5b})-*', *-Si(R₅ₐ)(R_{5b})-*', *-Ge(R₅ₐ)(R_{5b})-*', or *-C(R₅ₐ)=C(R_{5b})-*', and at least one of R₅ₐ and R_{5b} is a group represented by Formula 51, wherein * and *' may each indicate a binding site to a neighboring atom.

In Formula 1, i) two or more of a plurality of R₂(s) may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, ii) two or more of a plurality of R₃(s) may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iii) two or more of a plurality of R₄(s) may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and iv) two or more of R₁ to R₄, one or more of R₁ to R₄ and R₅ₐ, one or more of R₁ to R₄ and R_{5b}, or R₅ₐ and R_{5b} may each optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

R₁₀ₐ may be the same as described in connection with R₁.

In one or more embodiments, a group represented by *-C(Q₅₁)(Q₅₂)(Q₅₃) in Formula 51 may be a group represented by one of Formulae 51-1 to 51-25:

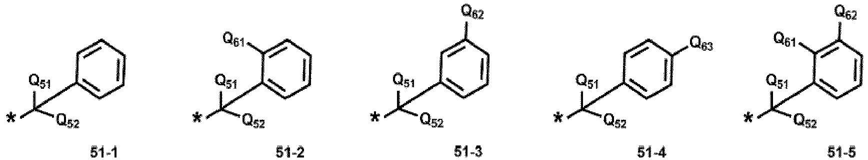

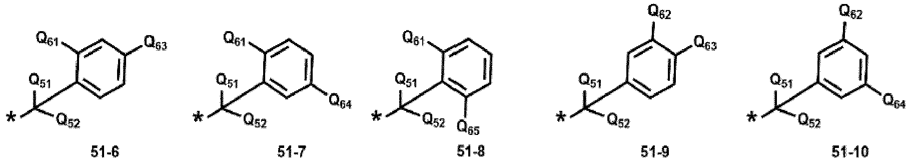

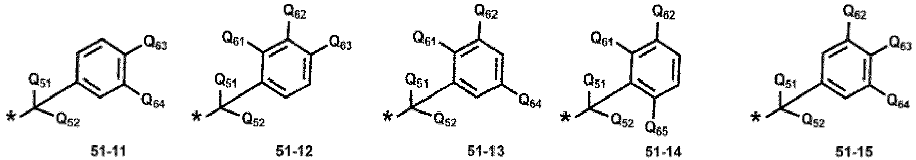

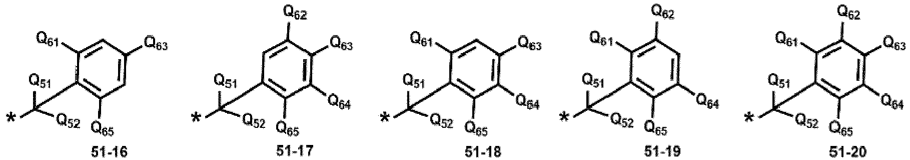

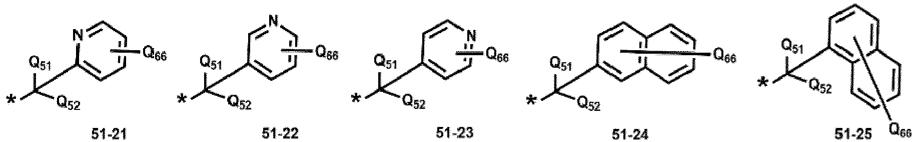

Q₅₁ and Q₅₂ in Formulae 51-1 to 51-25 may each be the same as described in the present specification, and Q₆₁ to Q₆₆ in Formulae 51-1 to 51-25 may each be the same as described in connection with R₁₀ₐ in the present specification, wherein each of Q₆₁ to Q₆₅ in Formulae 51-1 to 51-25 may not be hydrogen, and * in Formulae 51-1 to 51-25 indicates a binding site to L₅₁ in Formula 51.

In one or more embodiments, in Formulae 51-1 to 51-20,
i) Q₅₁ and Q₅₂ may each be hydrogen, and Q₆₁ to Q₆₅ may each independently be deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, or a (C₁-C₂₀ alkyl)phenyl group,
ii) Q₅₁ may be hydrogen, and Q₅₂ and Q₆₁ to Q₆₅ may each independently be deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, or a (C₁-C₂₀ alkyl)phenyl group, or
iii) Q₅₁, Q₅₂, and Q₆₁ to Q₆₅ may each independently be deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, or a (C₁-C₂₀ alkyl)phenyl group.

In one or more embodiments, L₅₁ in Formula 51 may be a single bond.

In one or more embodiments, in a group represented by Formula 51, L₅₁ may be a single bond, and thus, the group represented by Formula 51 may be a group represented by one of Formulae 51-1 to 51-25, for example, one of Formulae 51-1 to 51-20.

In one or more embodiments, a group represented by Formula 51 may be a group represented by one of Formulae 51 (1) to 51 (19):

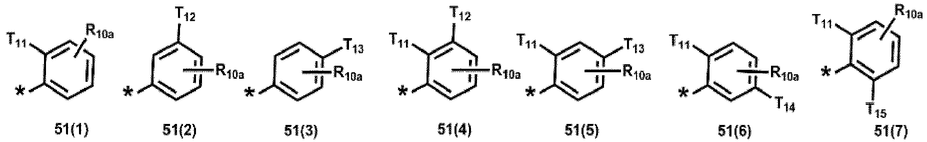

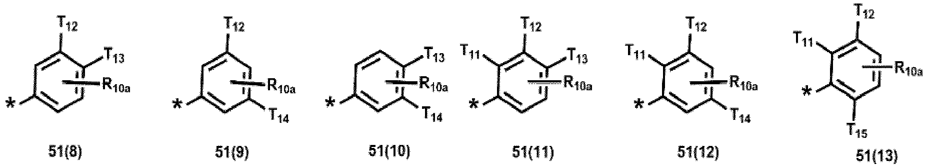

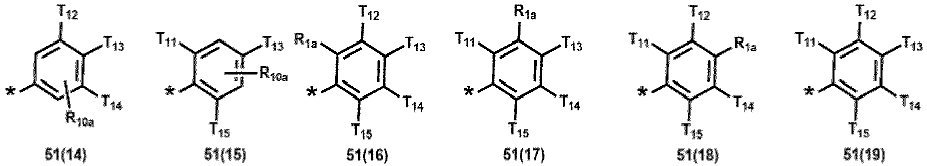

T₁₁ to T₁₅ in Formulae 51(1) to 51(19) may each be a group represented by *-C(Q₅₁)(Q₅₂)(Q₅₃) in Formula 51, T₁₁ to T₁₅ in Formulae 51 (1) to 51(19) may be identical to or different from each other, R₁₀ₐ in Formulae 51 (1) to 51(19) may be the same as described in connection with R₁ in the present specification, and * in Formulae 51(1) to 51(19) indicates a binding site to a neighboring atom.

In one or more embodiments, in Formula 1, n1 may be 1, n4 may be 0, and a group represented by 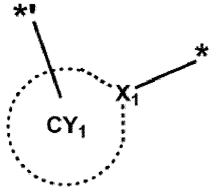 may be a group represented by one of Formulae CY1(1) to CY1(20):

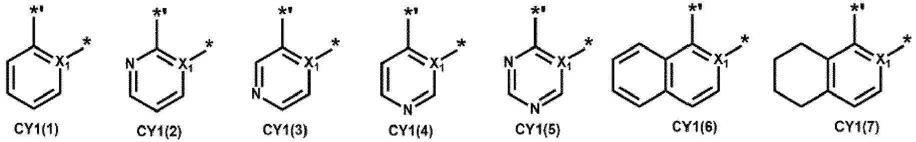

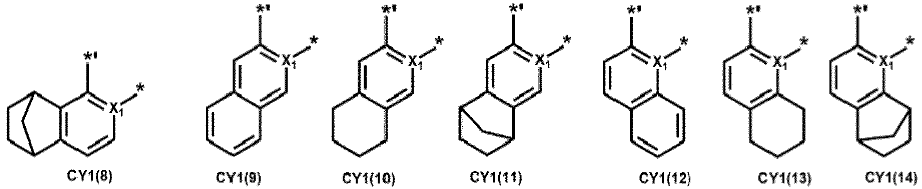

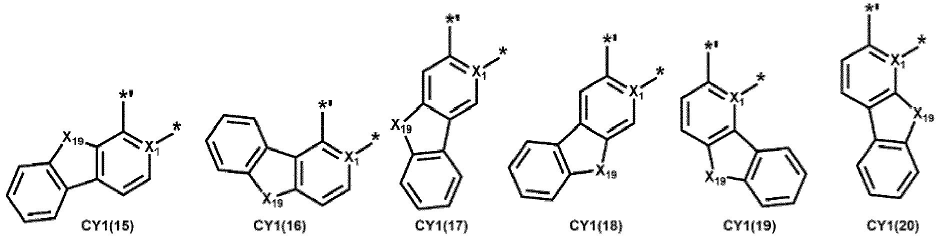

In Formulae CY1(1) to CY1(20),
X₁ may be the same as described in the present specification,
X₁₉ may be O, S, N(R₁₉ₐ), C(R₁₉ₐ)(R_{19b}), or Si(R₁₉ₐ)(R_{19b}),
R₁₉ₐ and R_{19b} may each be the same as described in connection with R₁ in the present specification,
   * indicates a binding site to X₅ in Formula 1, and
   *' indicates a binding site to T₁ in Formula 1.

In one or more embodiments, in Formula 1, n1 may be 1, n4 may be 0, and a group represented by 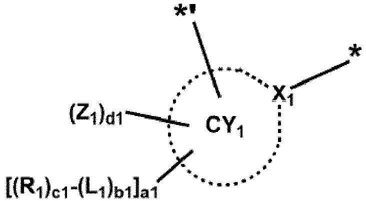 may be a group represented by one of Formulae CY1-1 to CY1-18 and ZCY1-1 to ZCY1-32:

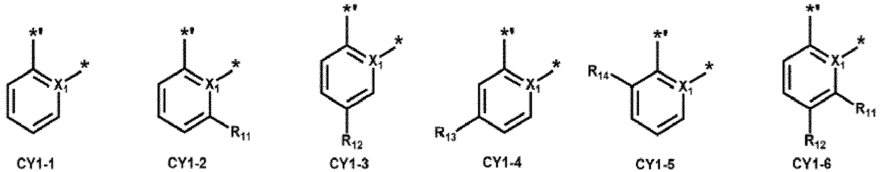

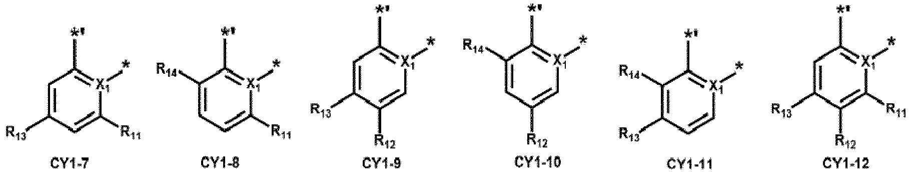

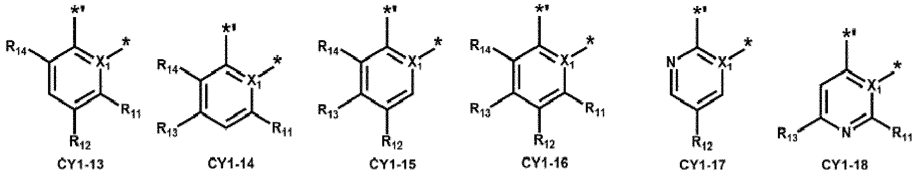

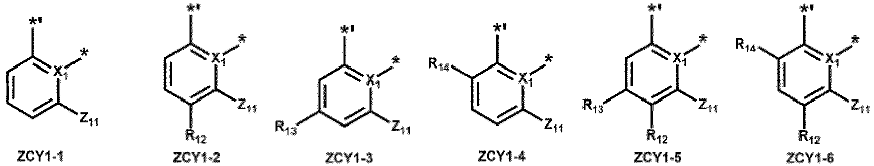

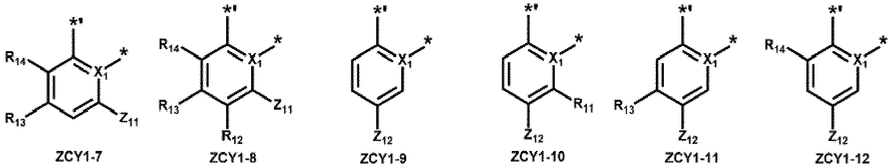

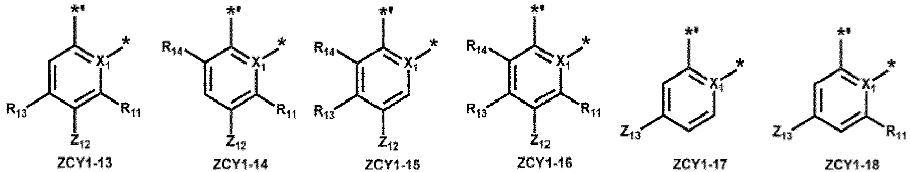

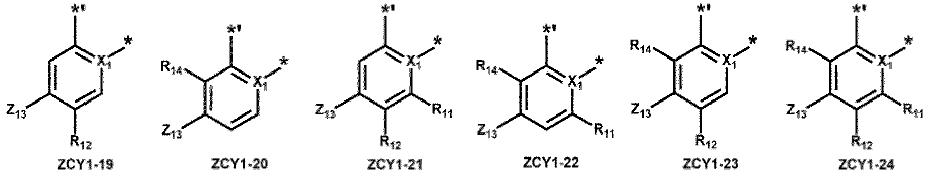

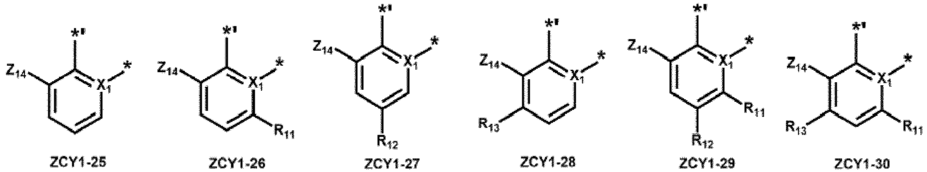

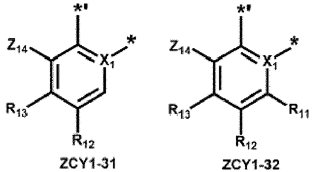

In Formulae CY1-1 to CY1-18 and ZCY1-1 to ZCY1-32,
X₁ may be the same as described in the present specification,
R₁₁ to R₁₄ may each be the same as described in connection with R₁ in the present specification, wherein each of R₁₁ to R₁₄ may not be hydrogen,
Z₁₁ to Z₁₄ may each be the same as described in connection with Z₁ in the present specification,
* indicates a binding site to X₅ in Formula 1, and
*' indicates a binding site to T₁ in Formula 1.

In one or more embodiments, in Formula 1, each of n1 and n2 may be 1, and ring CY₂ may be a group represented by Formula CY2A or CY2B:

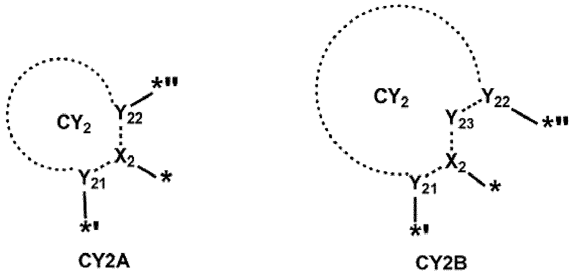

In Formulae CY2A and CY2B,
X₂ and ring CY₂ may each be the same as described in the present specification,
Y₂₁ to Y₂₃ may each independently be O, S, N, C, or Si,
a bond between X₂ and Y₂₁, a bond between X₂ and Y₂₂ , a bond between X₂ and Y₂₃, and a bond between Y₂₂ and Y₂₃ may each be a chemical bond,
   *' indicates a binding site to T₁ in Formula 1,
   * indicates a binding site to M in Formula 1, and
   *" indicates a binding site to T₂ in Formula 1.

In one or more embodiments, in Formula 1, each of n1 and n2 may be 1, and a group represented by 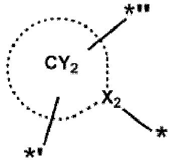 may be a group represented by one of Formulae CY2(1) to CY2(16):

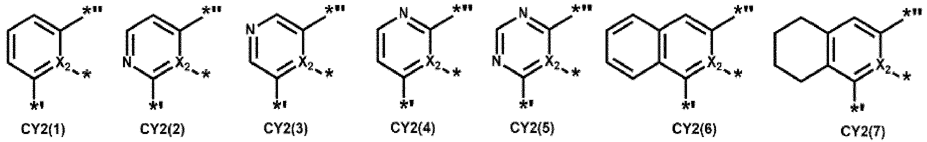

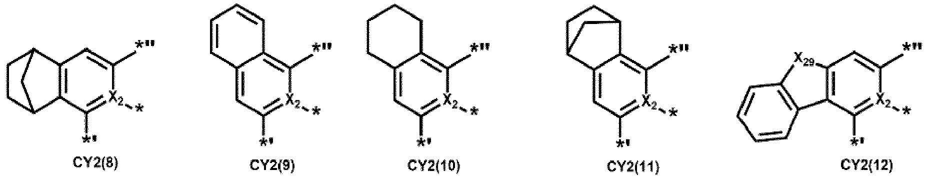

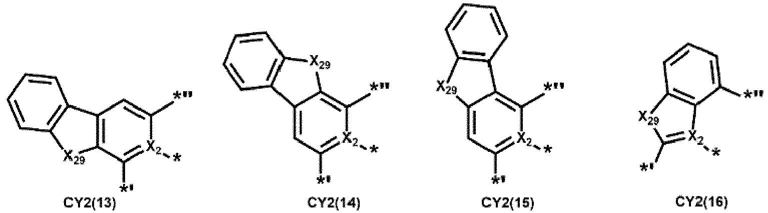

In Formulae CY2(1) to CY2(16),
X₂ may be the same as described in the present specification,
X₂₉ may be O, S, N-[(L₂)_{b2}-(R₂)_{c2}], N(Z₂₄), C(R₂₉ₐ)(R_{29b}), or Si(R₂₉ₐ)(R_{29b}),
L₂, b2, R₂, and c2 may each be the same as described in the present specification,
Z₂₄ may be the same as described in connection with Z₂ in the present specification,
R₂₉ₐ and R_{29b} may each be the same as described in connection with R₂ in the present specification,
*' indicates a binding site to T₁ in Formula 1,
* indicates a binding site to M in Formula 1, and
*" indicates a binding site to T₂ in Formula 1.

In one or more embodiments, in Formula 1, each of n1 and n2 may be 1, and a group represented by 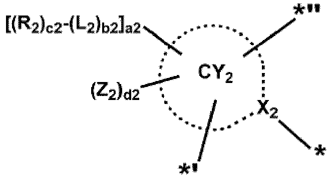 may be a group represented by one of Formulae CY2-1 to CY2-16 and ZCY2-1 to ZCY2-19:

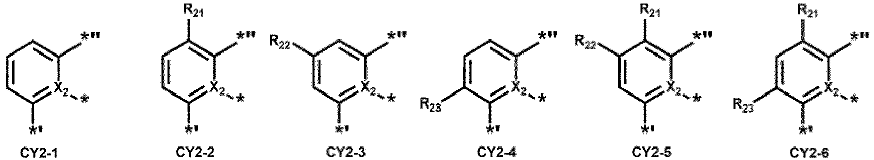

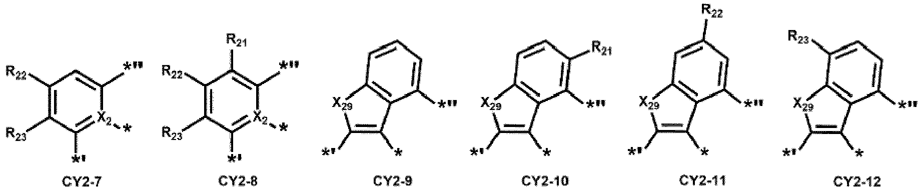

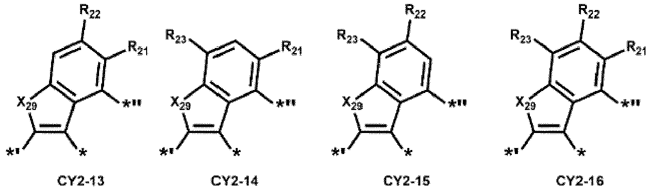

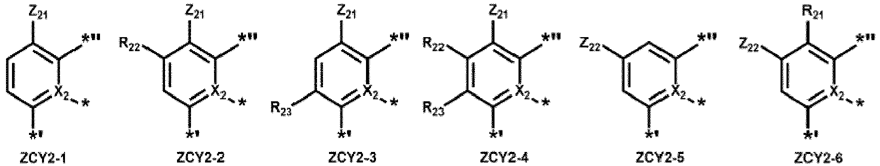

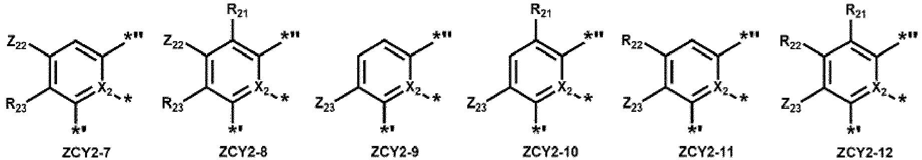

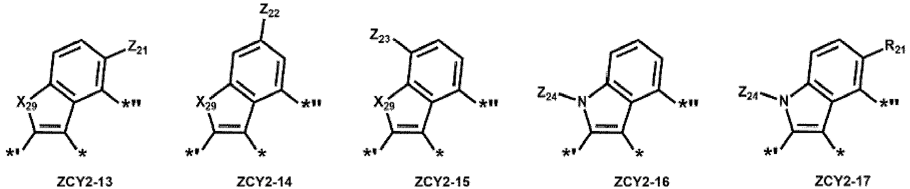

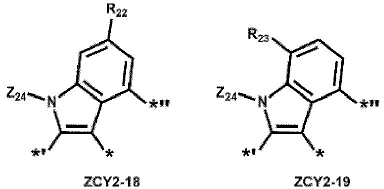

In Formulae CY2-1 to CY2-16 and ZCY2-1 to ZCY2-19,
X₂ may be the same as described in the present specification,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described in the present specification,
Z₂₁ to Z₂₄ may each be the same as described in connection with Z₂ in the present specification,
R₂₁ to R₂₃, R₂₉ₐ, and R_{29b} may each be the same as described in connection with R₂ in the present specification, wherein each of R₂₁ to R₂₃ may not be hydrogen,
   *' indicates a binding site to T₁ in Formula 1,
   * indicates a binding site to M in Formula 1, and
   *" indicates a binding site to T₂ in Formula 1.

In one or more embodiments, in Formula 1, each of n2 and n3 may be 1, and a group represented by 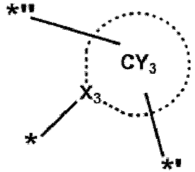 may be a group represented by one of Formulae CY3(1) to CY3(15):

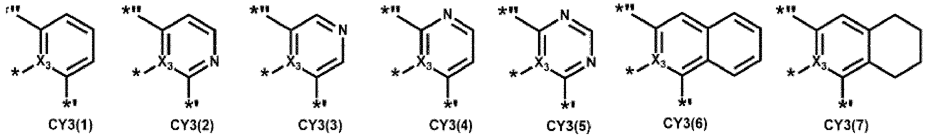

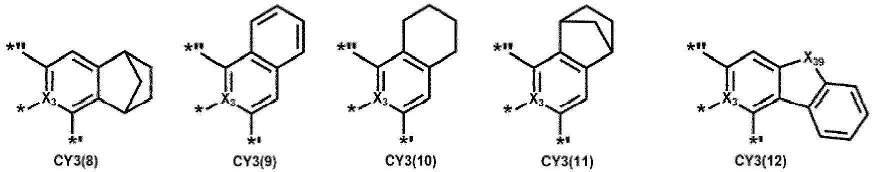

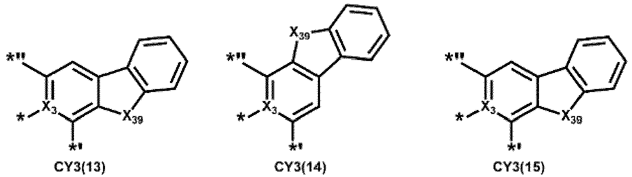

In Formulae CY3(1) to CY3(15),
X₃ may be the same as described in the present specification,
X₃₉ may be O, S, N(Z₃₉ₐ), C(R₃₉ₐ)(R_{39b}), or Si(R₃₉ₐ)(R_{39b}),
R₃₉ₐ and R_{39b} may each be the same as described in connection with R₃ in the present specification,
   *" indicates a binding site to T₂ in Formula 1,
   * indicates a binding site to M in Formula 1, and
   *' indicates a binding site to T₃ in Formula 1.

In one or more embodiments, in Formula 1, each of n2 and n3 may be 1, and a group represented by 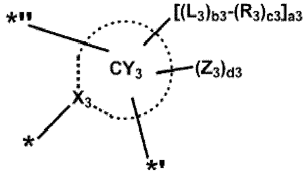 may be a group represented by one of Formulae CY3-1 to CY3-13 and ZCY3-1 to ZCY3-12:

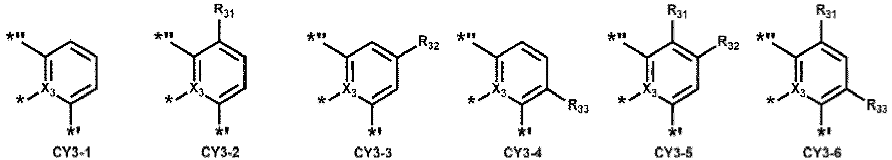

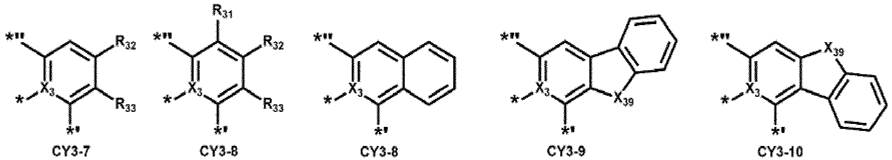

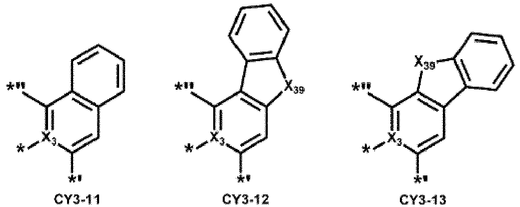

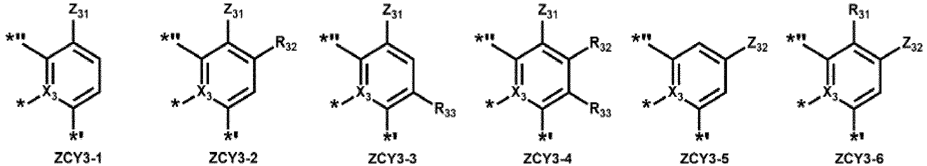

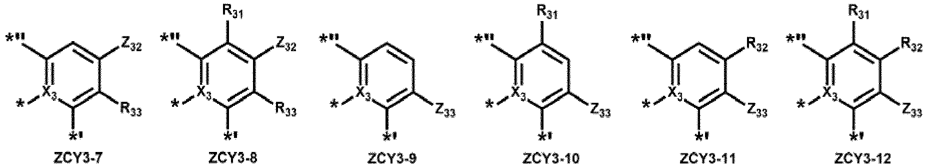

In Formulae CY3-1 to CY3-13 and ZCY3-1 to ZCY3-12,
X₃ may be the same as described in the present specification,
X₃₉ may be O, S, N-[(L₃)_{b3}-(R₃)_{c3}], C(R₃₉ₐ)(R_{39b}), or Si(R₃₉ₐ)(R_{39b}),
L₃, b3, R₃, and c3 may each be the same as described in the present specification,
R₃₁ to R₃₃, R₃₉ₐ, and R_{39b} may each be the same as described in connection with R₃ in the present specification, wherein each of R₃₁ to R₃₃ may not be hydrogen,
Z₃₁ to Z₃₃ may each be the same as described in connection with Z₃ in the present specification,
   *" indicates a binding site to T₂ in Formula 1,
   * indicates a binding site to M in Formula 1, and
   *' indicates a binding site to T₃ in Formula 1.

In one or more embodiments, in Formula 1, n3 may be 1, n4 may be 0, and a group represented by 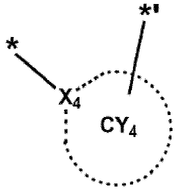 may be a group represented by one of Formulae CY4(1) to CY4(20):

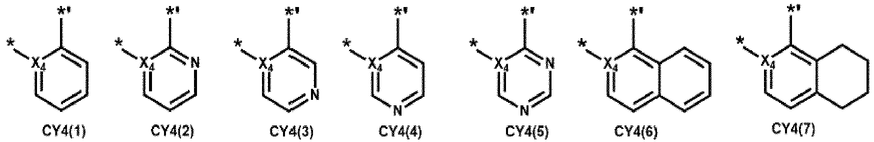

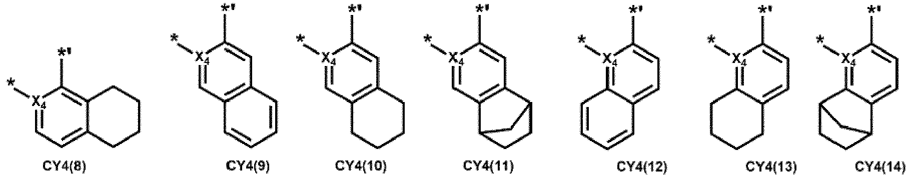

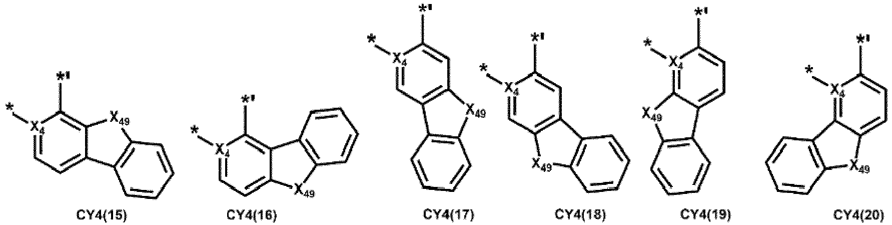

In Formulae CY4(1) to CY4(20),
X₄ may be the same as described in the present specification,
X₄₉ may be O, S, N(R₄₉ₐ), C(R₄₉ₐ)(R_{49b}), or Si(R₄₉ₐ)(R_{49b}),
R₄₉ₐ and R_{49b} may each be the same as described in connection with R₄ in the present specification,
   *' indicates a binding site to T₃ in Formula 1, and
   * indicates a binding site to M in Formula 1.

In one or more embodiments, in Formula 1, n3 may be 1, n4 may be 0, and a group represented by 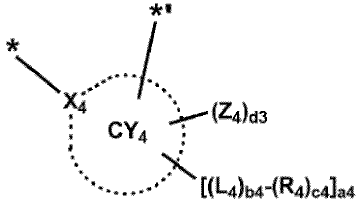 may be a group represented by one of Formulae CY4-1 to CY4-16 and ZCY4-1 to ZCY4-32:

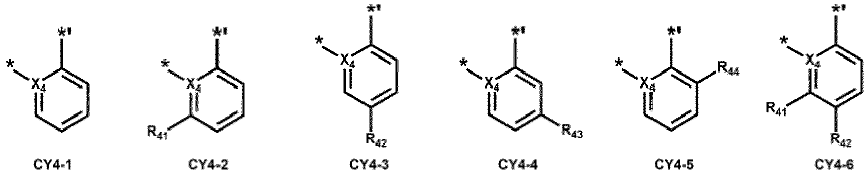

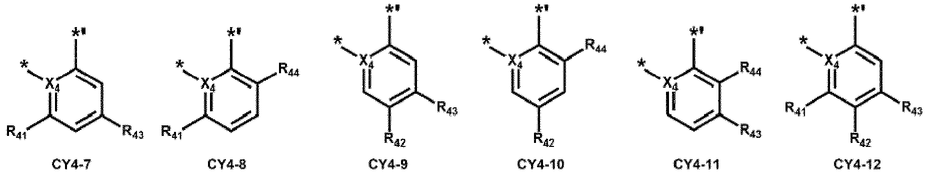

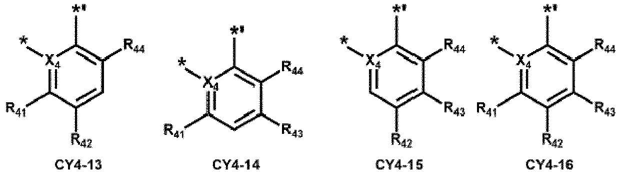

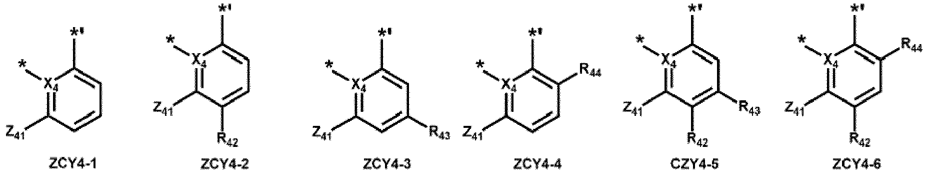

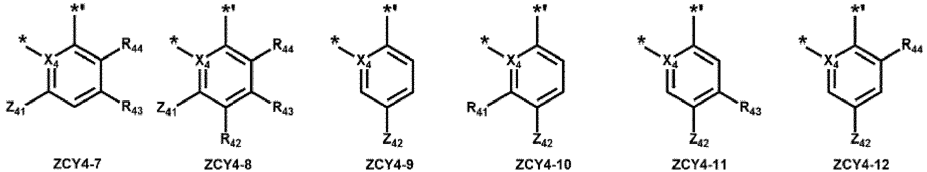

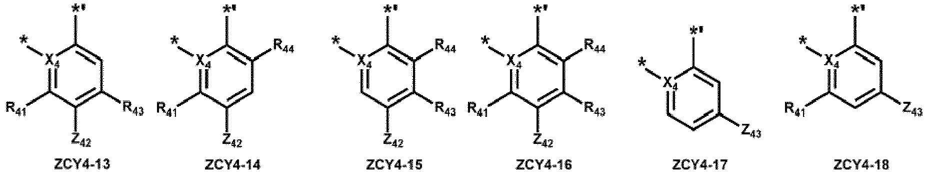

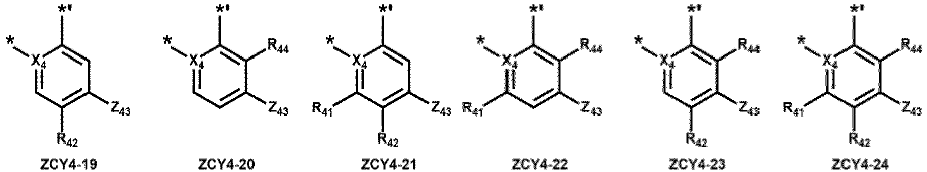

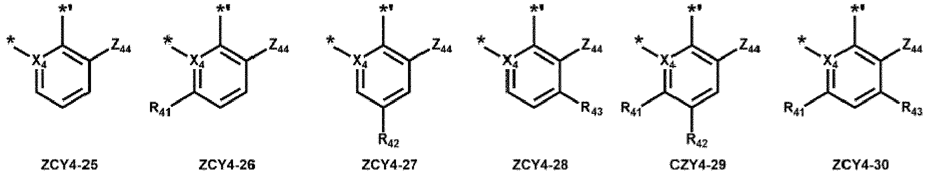

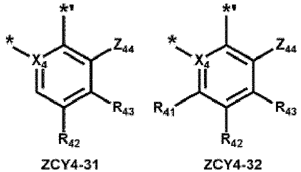

In Formulae CY4-1 to CY4-16 and ZCY4-1 to ZCY4-32,
X₄ may be the same as described in the present specification,
R₄₁ to R₄₄ may each be the same as described in connection with R₄ in the present specification, wherein each of R₄₁ to R₄₄ may not be hydrogen,
Z₄₁ to Z₄₄ may each be the same as described in connection with Z₄ in the present specification,
   *' indicates a binding site to T₃ in Formula 1, and
   * indicates a binding site to M in Formula 1.

In one or more embodiments, the organometallic compound may be represented by one of Formulae 1-1 to 1-4:

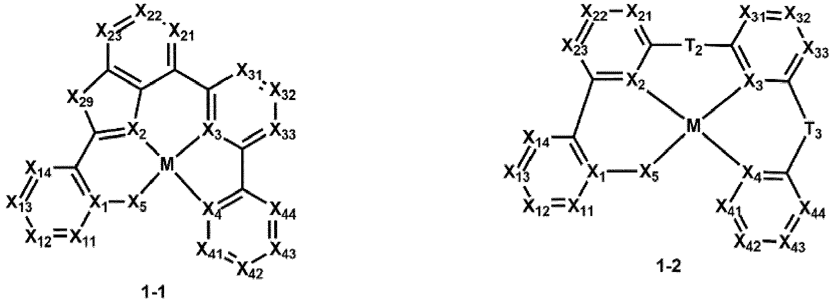

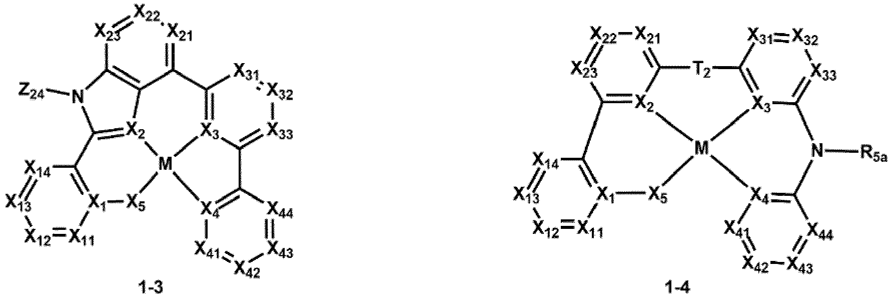

In Formulae 1-1 to 1-4,
M, X₁ to X₅, T₂, and T₃ may each be the same as described in the present specification,
X₁₁ may be N, C(R₁₁), or C(Z₁₁), X₁₂ may be N, C(R₁₂), or C(Z₁₂), X₁₃ may be N, C(R₁₃), or C(Z₁₃), and X₁₄ may be N, C(R₁₄), or C(Z₁₄),
R₁₁ to R₁₄ may each be the same as described in connection with R₁ in the present specification,
Z₁₁ to Z₁₄ may each be the same as described in connection with Z₁ in the present specification,
two or more of R₁₁ to R₁₄ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₂₁ may be N, C(R₂₁), or C(Z₂₁), X₂₂ may be N, C(R₂₂), or C(Z₂₂), and X₂₃ may be N, C(R₂₃), or C(Z₂₃),
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described in the present specification,
R₂₁ to R₂₃, R₂₉ₐ, and R_{29b} may each be the same as described in connection with R₂ in the present specification,
Z₂₁ to Z₂₄ may each be the same as described in connection with Z₂ in the present specification,
two or more of R₂₁ to R₂₃ may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
X₃₁ may be N, C(R₃₁), or C(Z₃₁), X₃₂ may be N, C(R₃₂), or C(Z₃₂), and X₃₃ may be N, C(R₃₃), or C(Z₃₃),
R₃₁ to R₃₃ may each be the same as described in connection with R₃ in the present specification,
Z₃₁ to Z₃₃ may each be the same as described in connection with Z₃ in the present specification,
two or more of R₃₁ to R₃₃ may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
X₄₁ may be N, C(R₄₁), or C(Z₄₁),
X₄₂ may be N, C(R₄₂), or C(Z₄₂),
X₄₃ may be N, C(R₄₃), or C(Z₄₃),
X₄₄ may be N, C(R₄₄), or C(Z₄₄),
R₄₁ to R₄₄ may each be the same as described in connection with R₄ in the present specification,
Z₄₁ to Z₄₄ may each be the same as described in connection with Z₄ in the present specification,
two or more of R₄₁ to R₄₄ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
Formulae 1-1 and 1-2 may each include one of Z₁₁ to Z₁₄, one of Z₂₁ to Z₂₃, one of Z₃₁ to Z₃₃, one of Z₄₁ to Z₄₄, or a combination thereof, and
R₅ₐ in Formula 1-4 may be a group represented by Formula 51. In one or more embodiments,
i) the organometallic compound may be represented by Formula 1-1 or 1-2, and Formulae 1-1 and 1-2 may each satisfy at least one of Condition (1') to Condition (3');
ii) the organometallic compound may be represented by Formula 1-3 or 1-4; or
iii) the organometallic compound may be represented by Formula 1-3 or 1-4, and Formulae 1-3 and 1-4 may each satisfy at least one of Condition (1') to Condition (3'):
   Condition (1')
      X₂₂ is C(Z₂₂)
   Condition (2')
      X₃₂ is C(Z₃₂)
   Condition (3')
      X₄₃ iS C(Z₄₃).

In one or more embodiments, Z₁ to Z₄, Z₁₁ to Z₁₄, Z₂₁ to Z₂₄, Z₃₁ to Z₃₃, and Z₄₁ to Z₄₄ in the present specification may each independently be a group represented by one of Formulae 51-1 to 51-25.

In one or more embodiments, Z₁ to Z₄, Z₁₁ to Z₁₄, Z₂₁ to Z₂₄, Z₃₁ to Z₃₃, and Z₄₁ to Z₄₄ in the present specification may each independently be a group represented by one of Formulae 51(1) to 51(19).

In one or more embodiments, the organometallic compound represented by Formula 1 may satisfy at least one of Condition A to Condition E:
Condition A
   n1 in Formula 1 is 1, n4 in Formula 1 is 0, and a group represented by 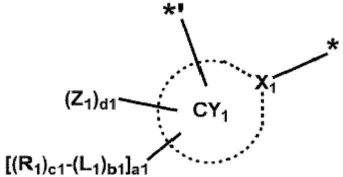 in Formula 1 is a group represented by one of Formulae ZCY1-1 to ZCY1-32
Condition B
   each of n1 and n2 in Formula 1 is 1, and a group represented by 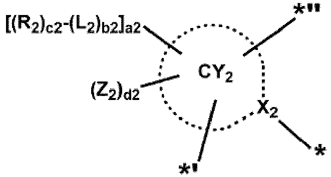 in Formula 1 is a group represented by one of Formulae ZCY2-1 to ZCY2-19.
Condition C
   each of n2 and n3 in Formula 1 is 1, and a group represented by 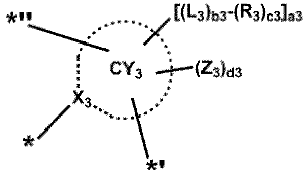 in Formula 1 is a group represented by one of Formulae ZCY3-1 to ZCY3-12
Condition D
   n3 in Formula 1 is 1, n4 in Formula 1 is 0, and a group represented by 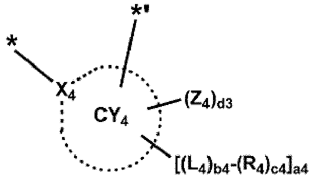 in Formula 1 is a group represented by one of Formulae ZCY4-1 to ZCY4-32
Condition E
   n3 in Formula 1 is 1, T₃ in Formula 1 is *-N(R₅ₐ)-*', and R₅ₐ in Formula 1 is a group represented by Formula 51.

In one or more embodiments, the organometallic compound represented by Formula 1 may emit green light.

In one or more embodiments, the organometallic compound represented by Formula 1 may be one of Compounds 1 to 750:

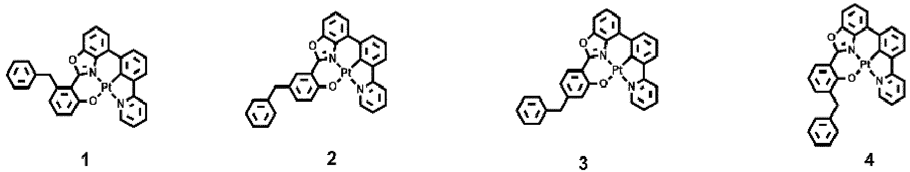

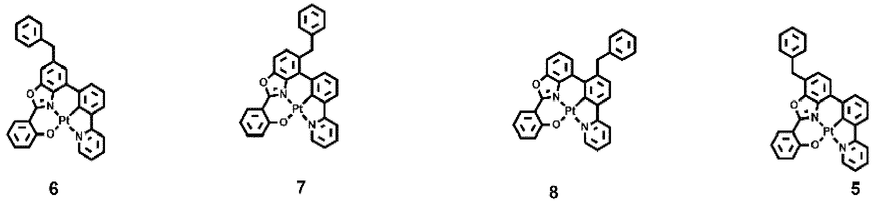

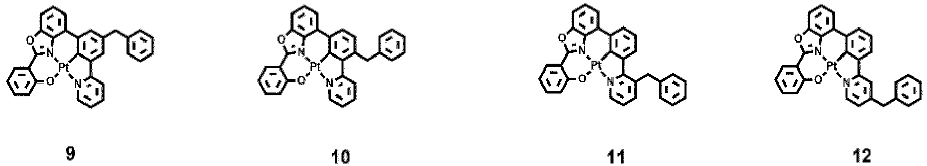

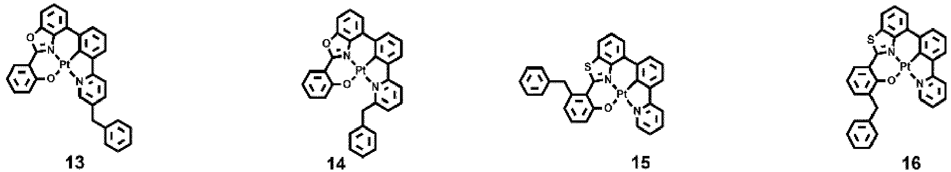

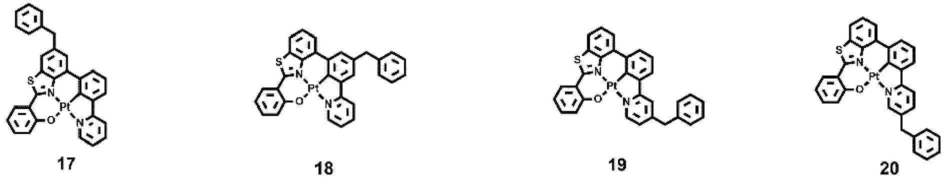

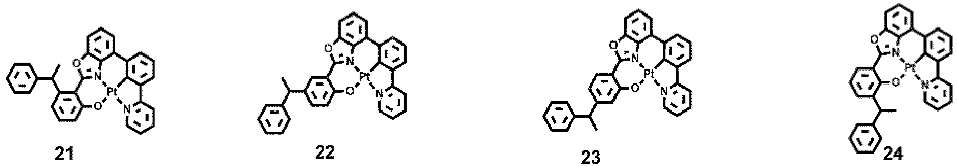

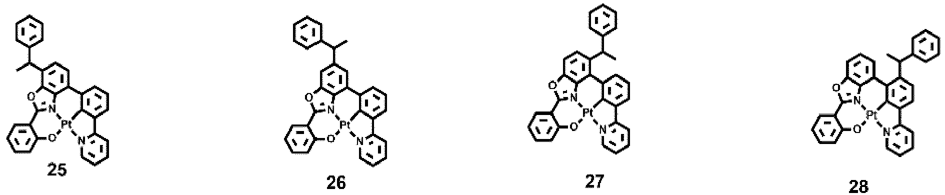

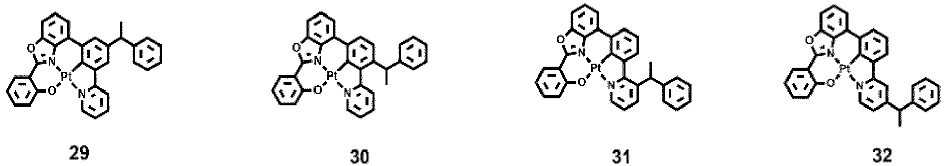

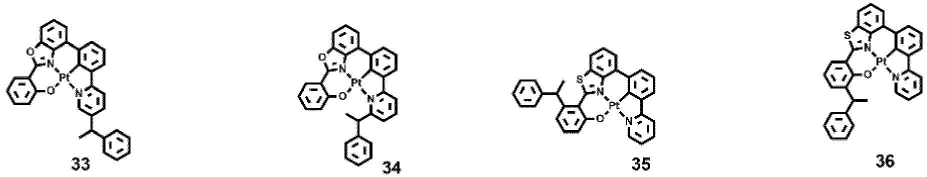

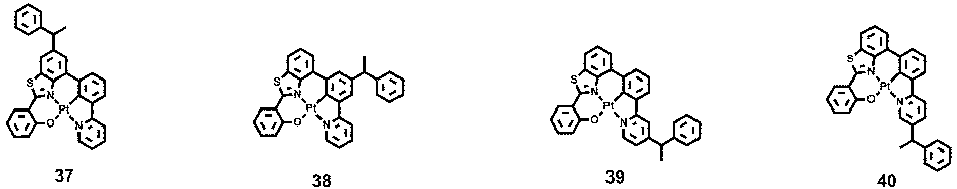

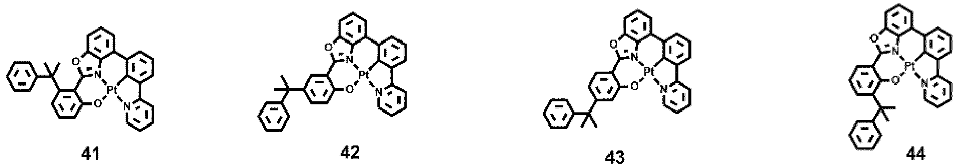

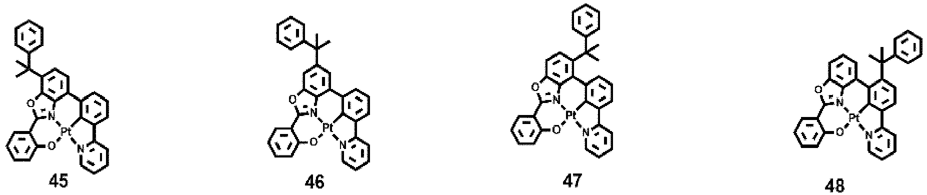

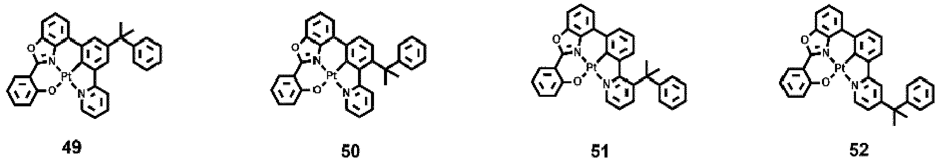

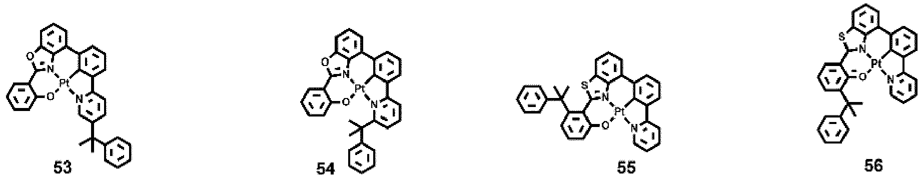

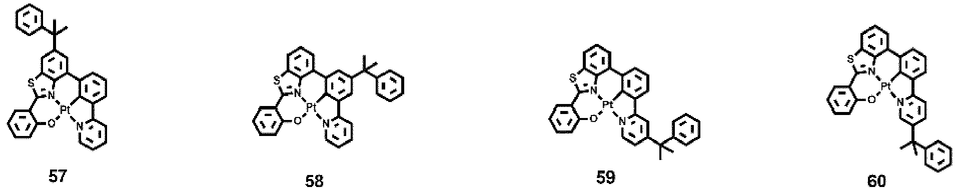

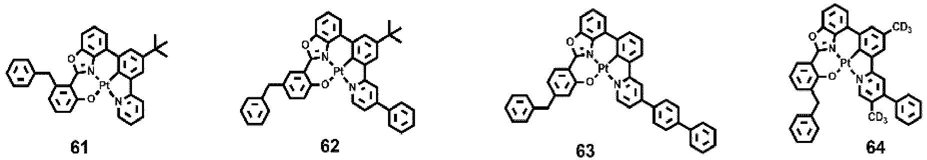

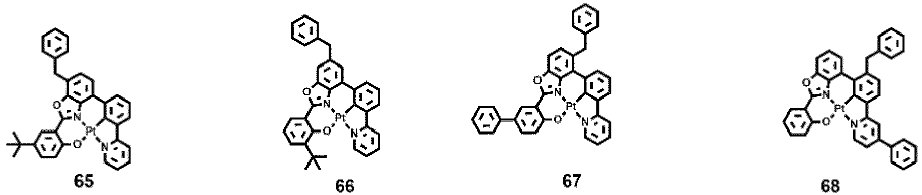

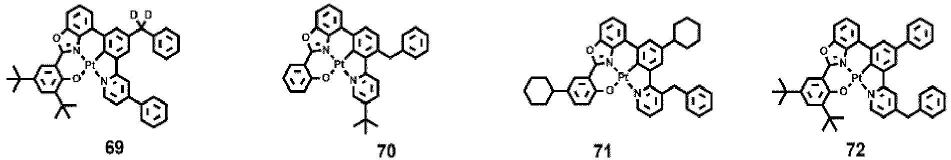

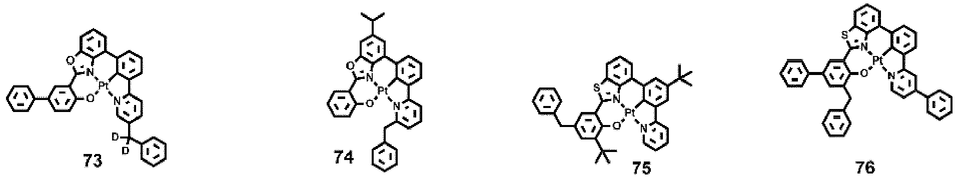

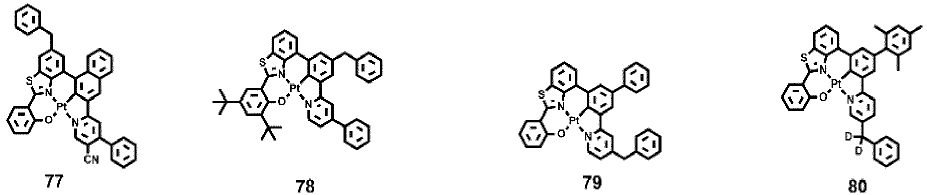

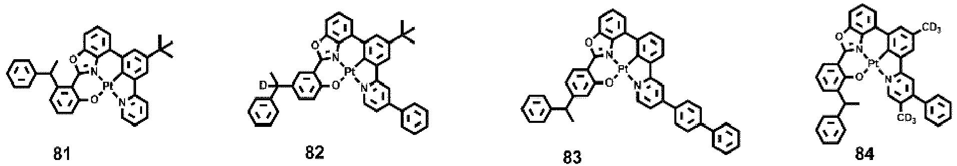

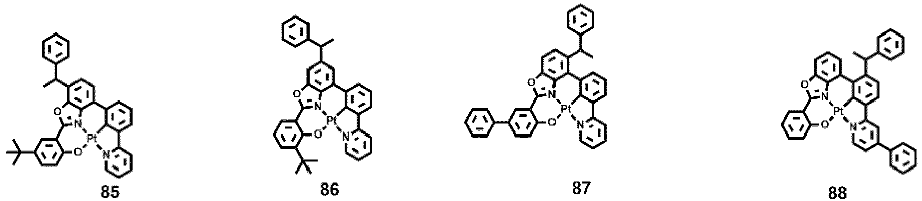

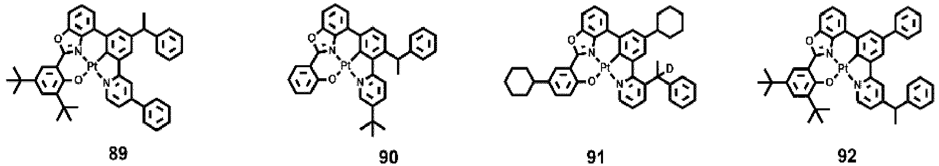

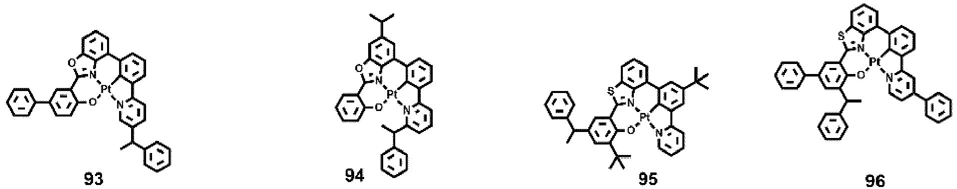

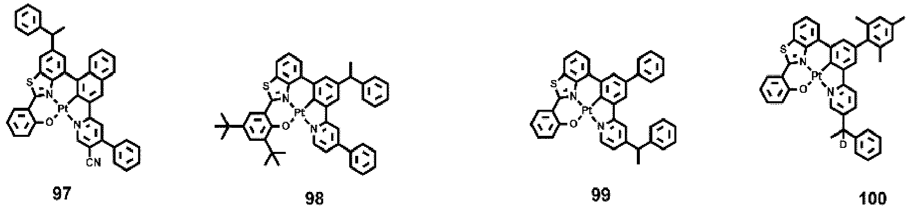

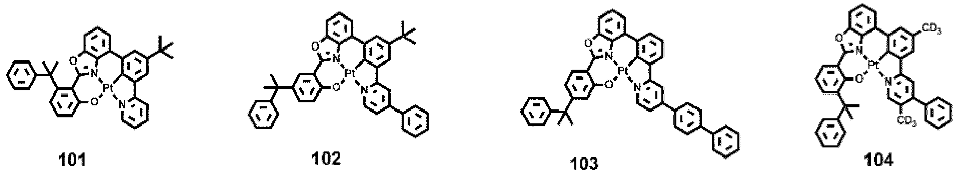

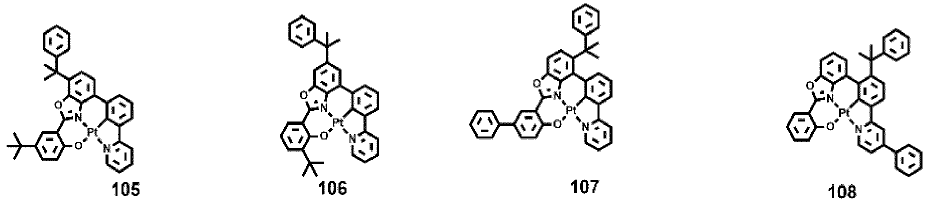

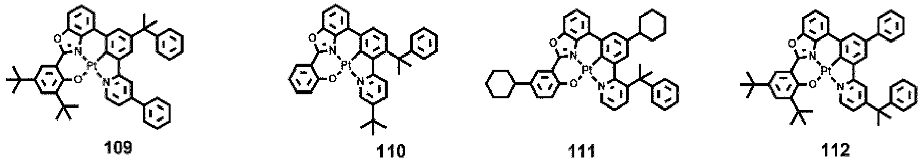

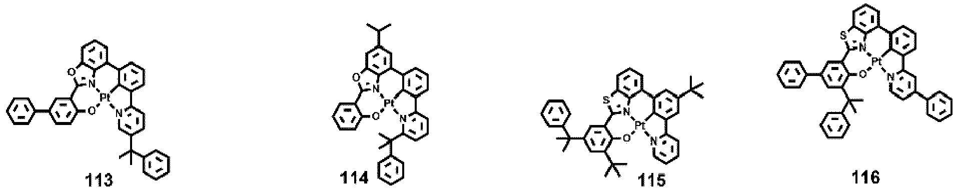

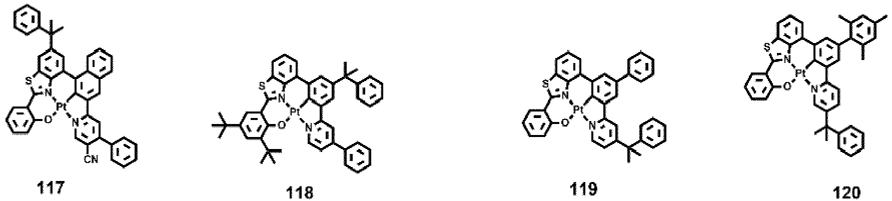

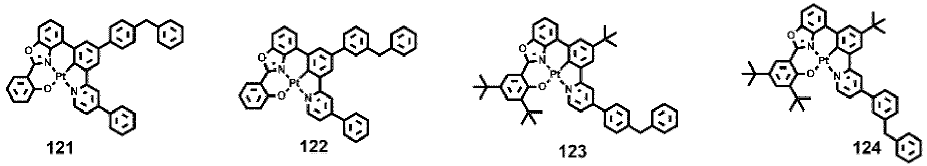

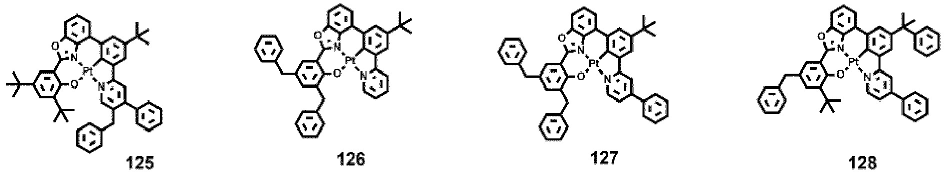

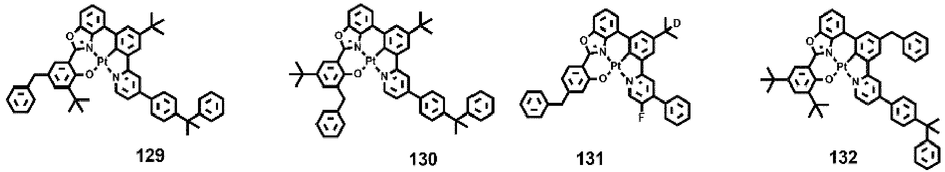

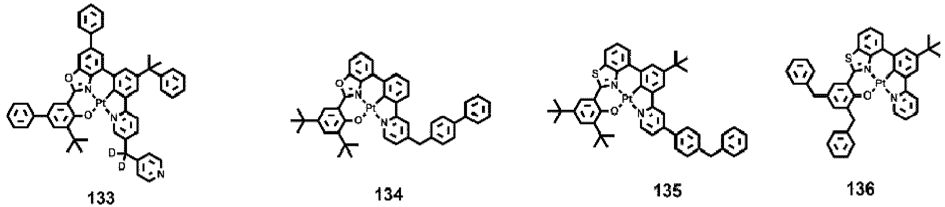

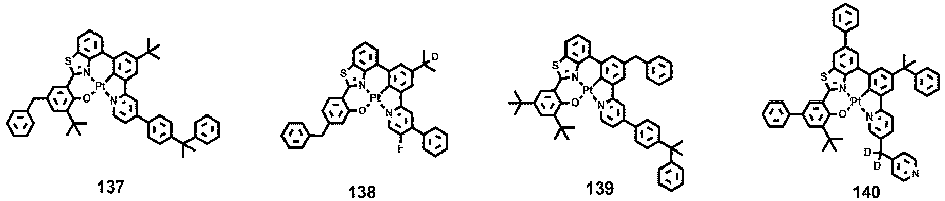

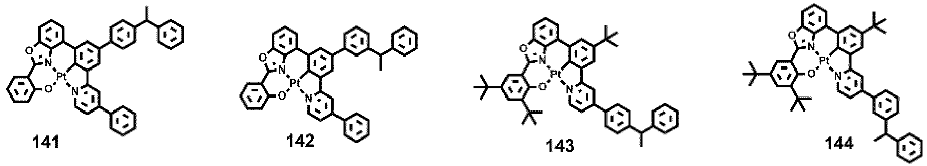

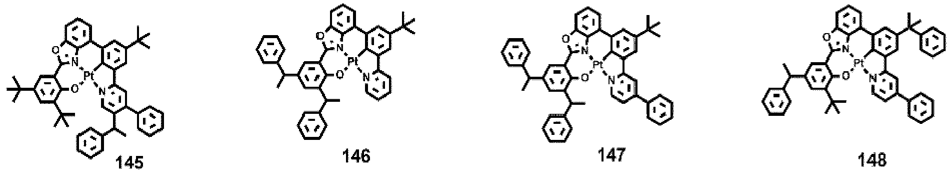

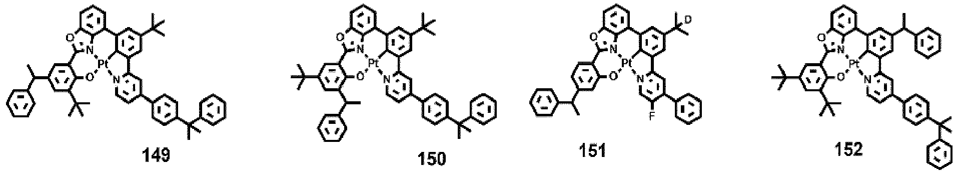

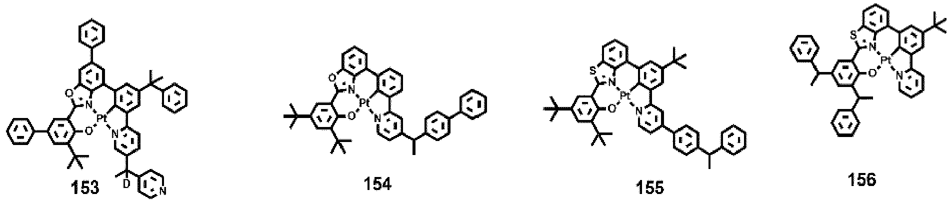

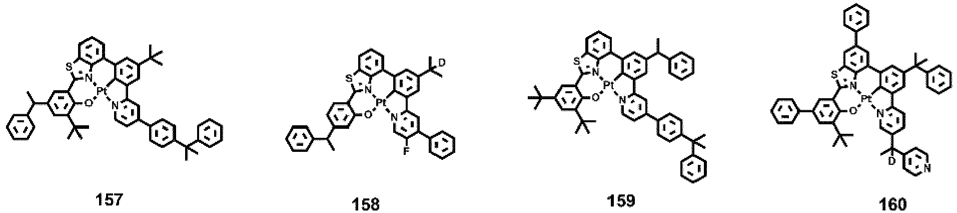

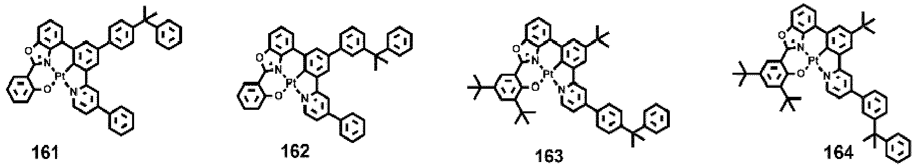

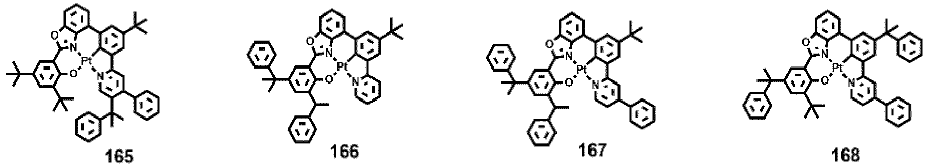

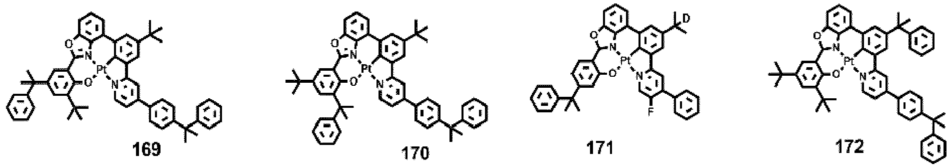

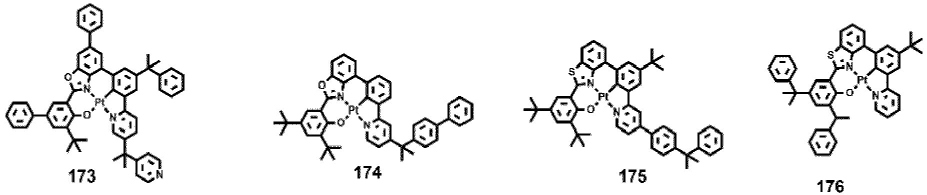

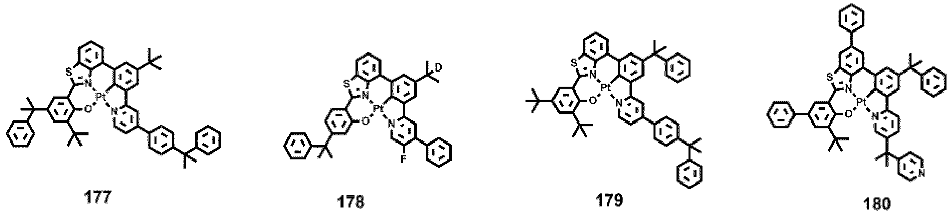

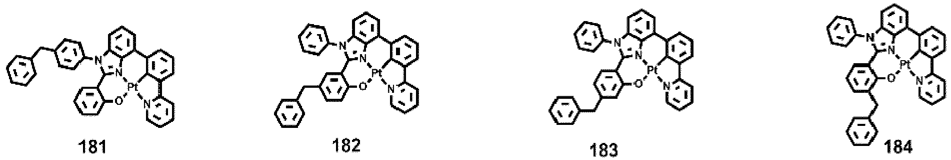

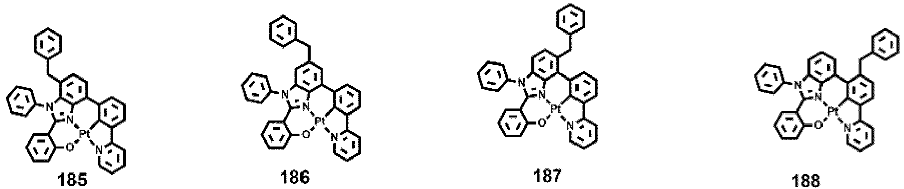

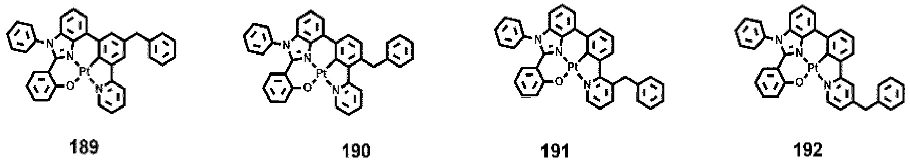

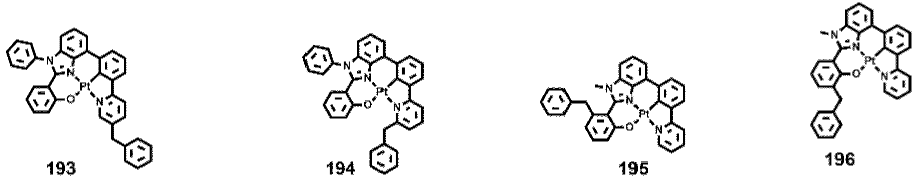

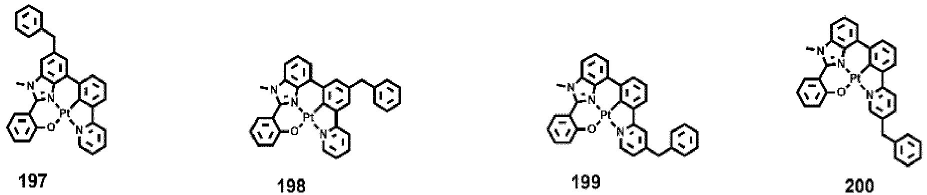

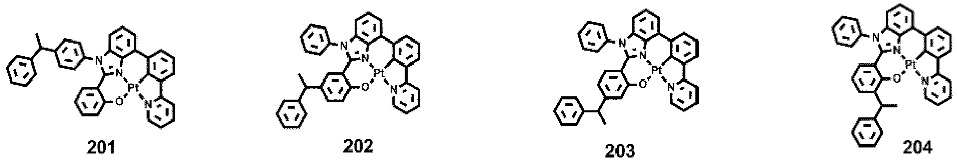

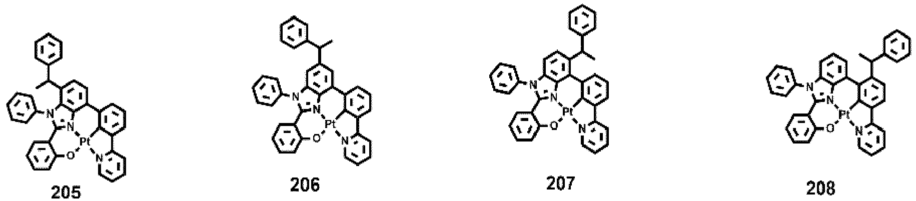

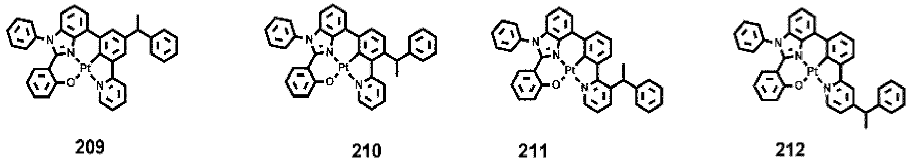

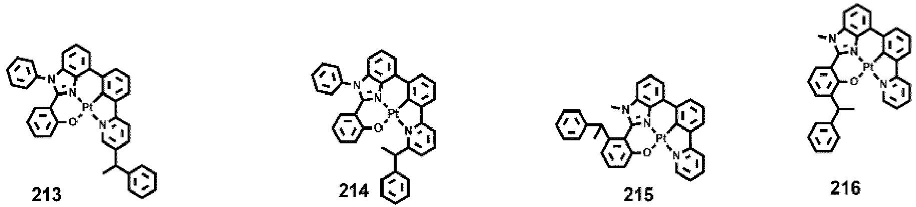

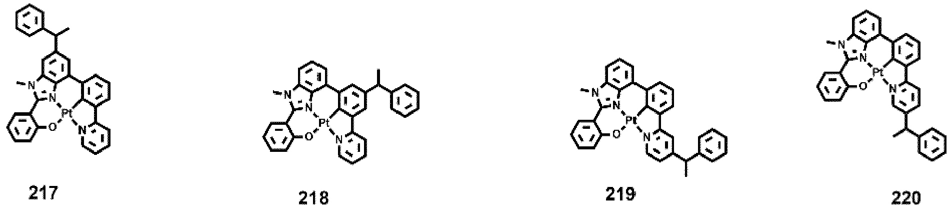

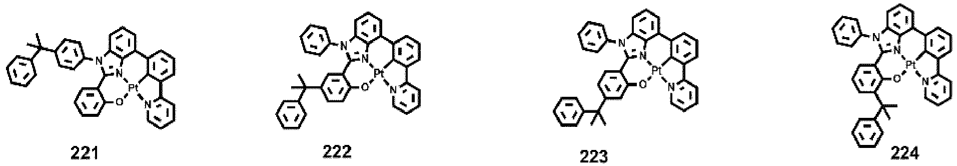

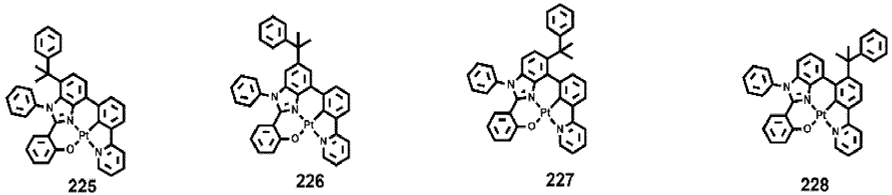

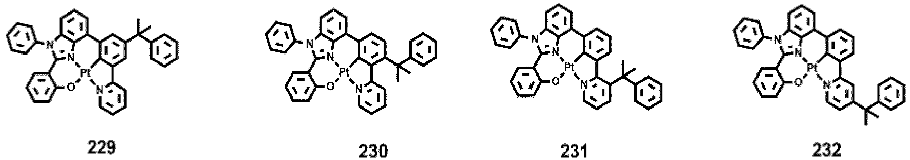

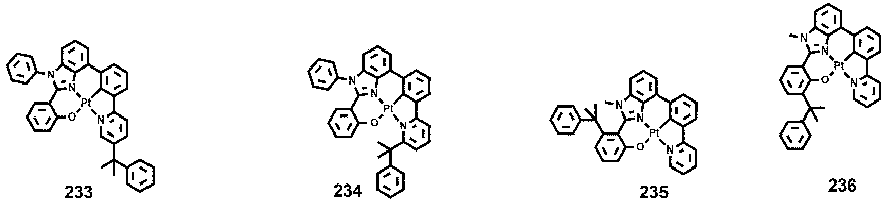

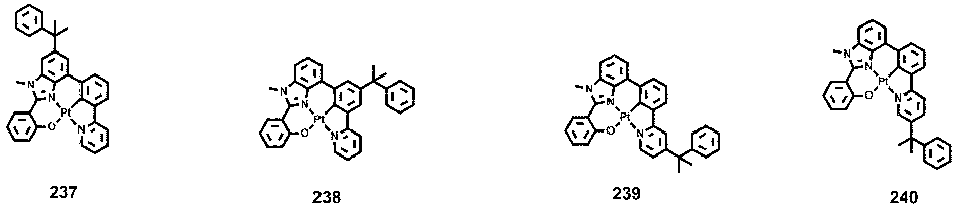

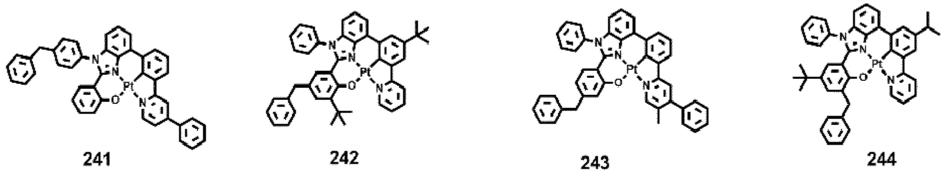

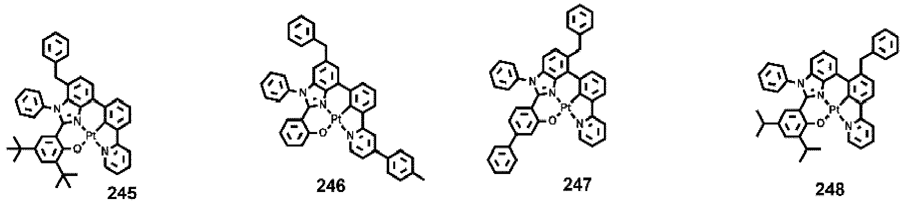

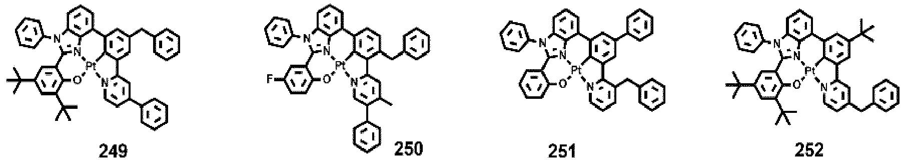

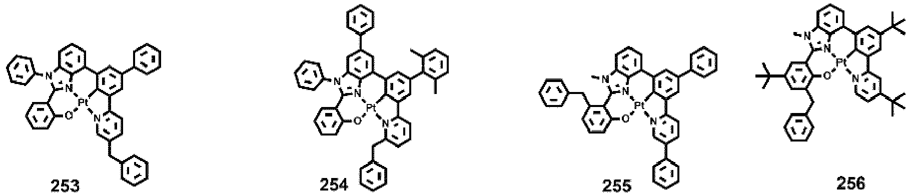

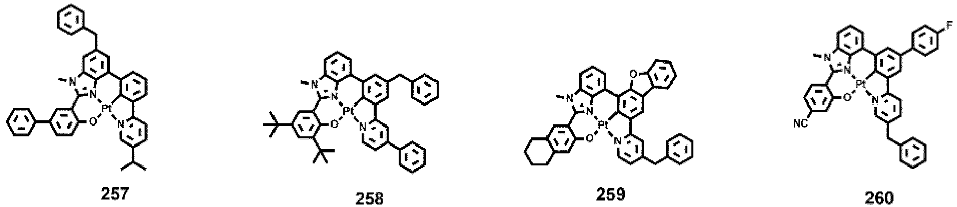

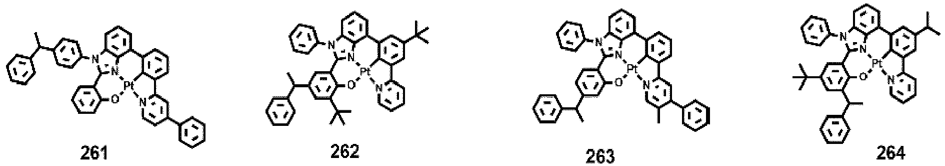

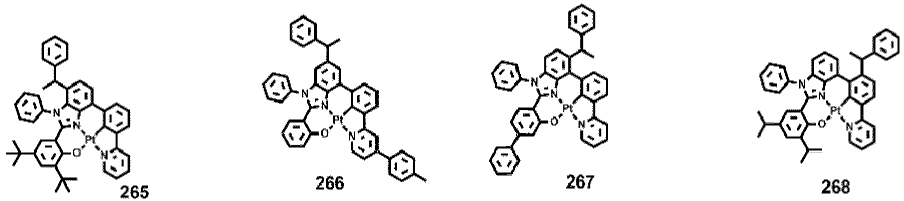

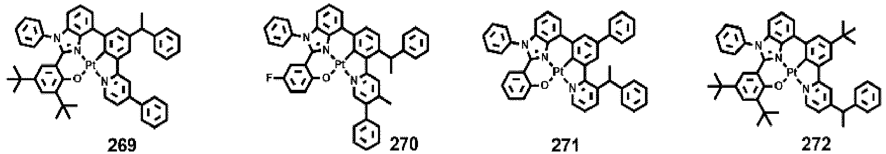

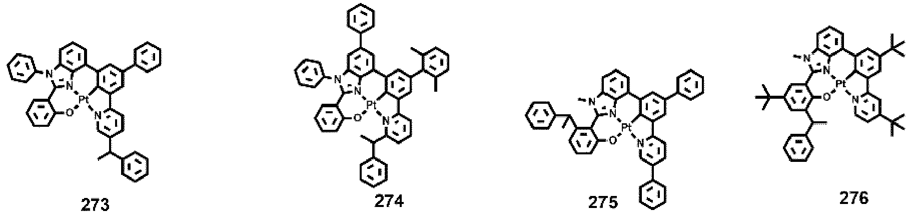

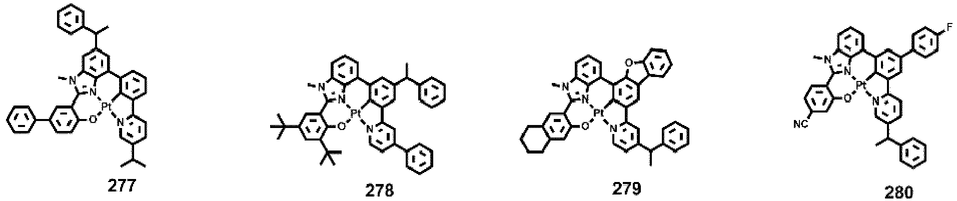

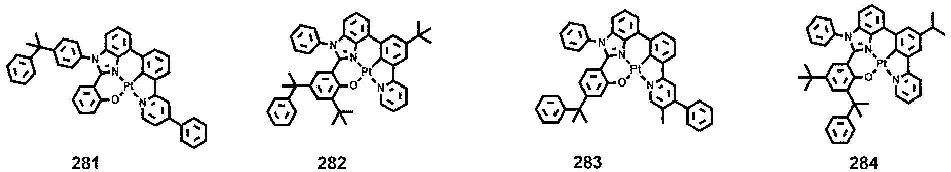

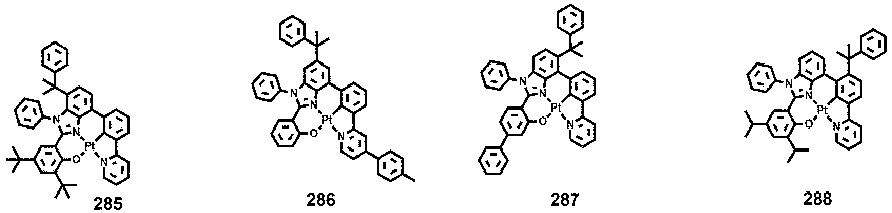

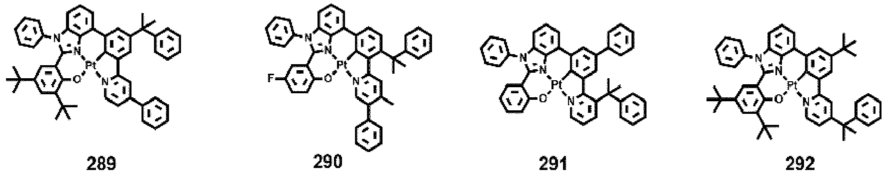

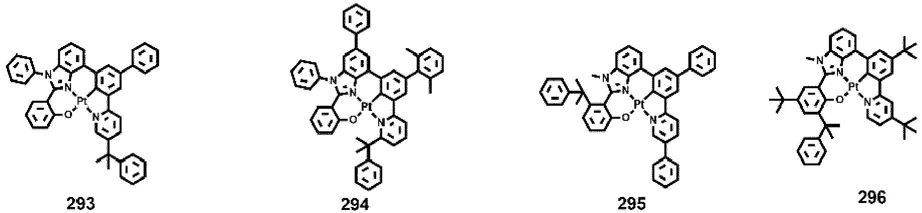

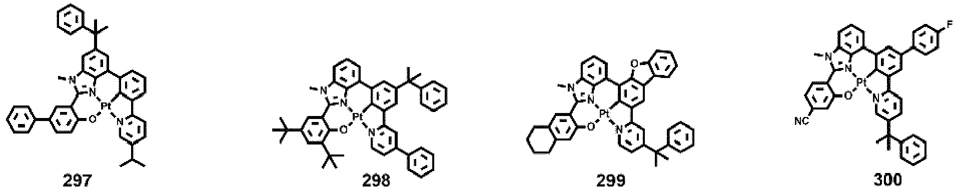

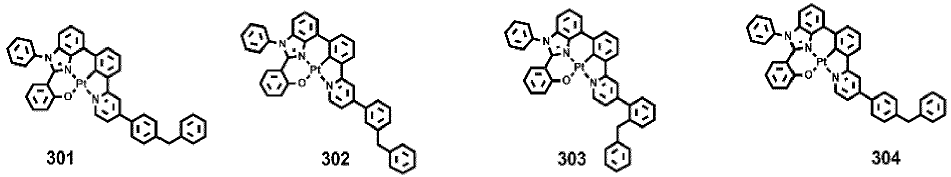

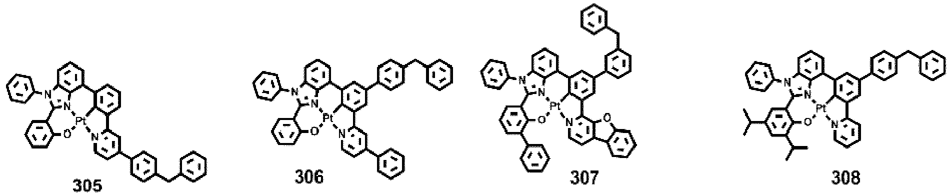

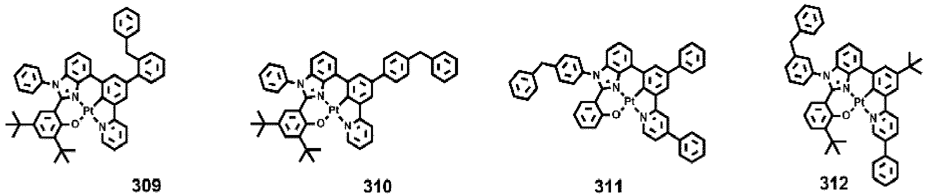

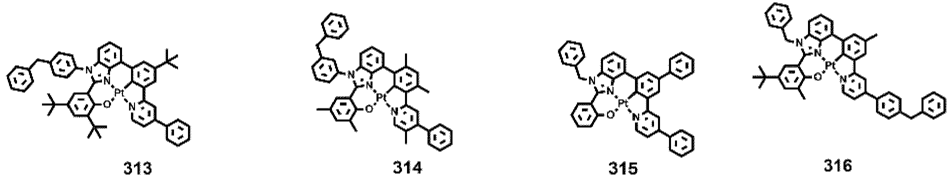

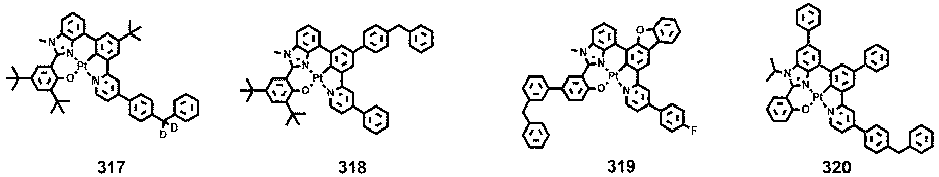

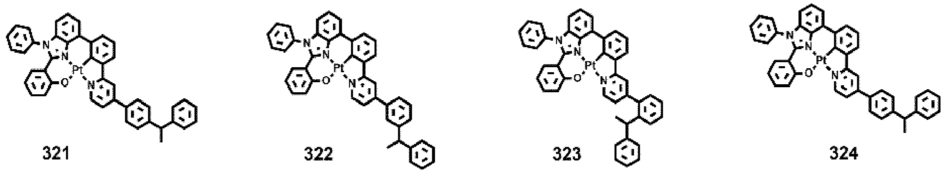

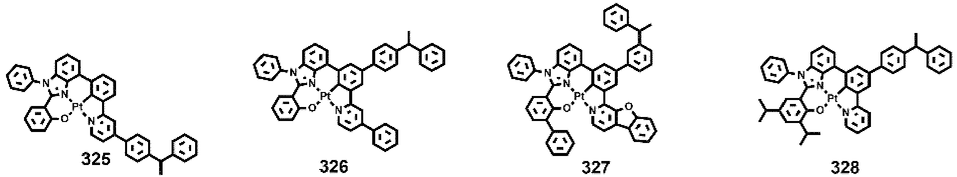

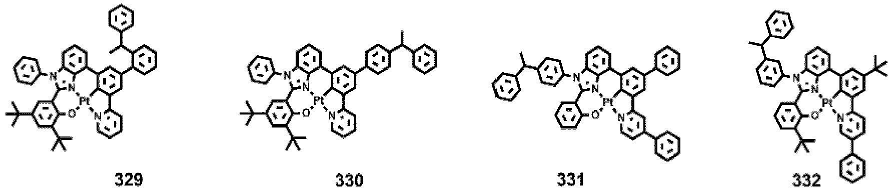

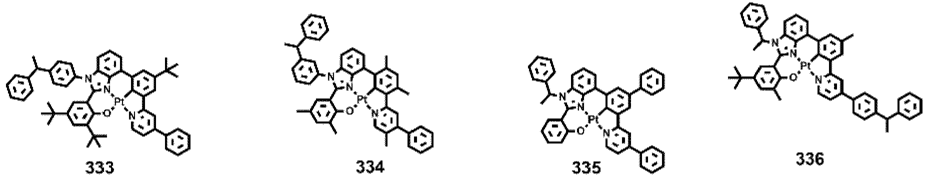

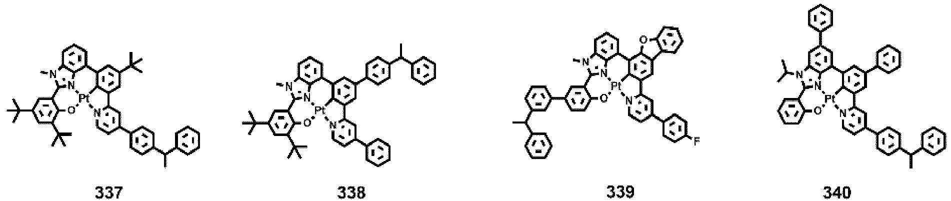

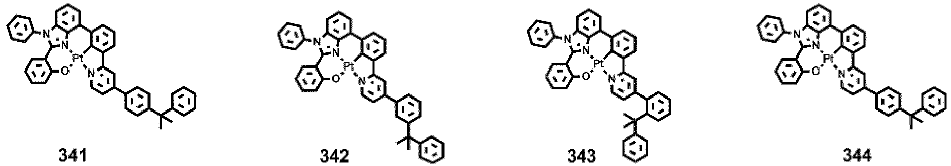

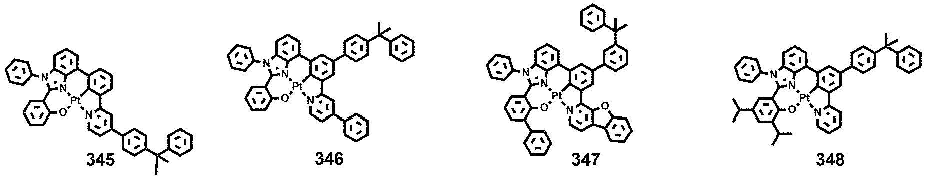

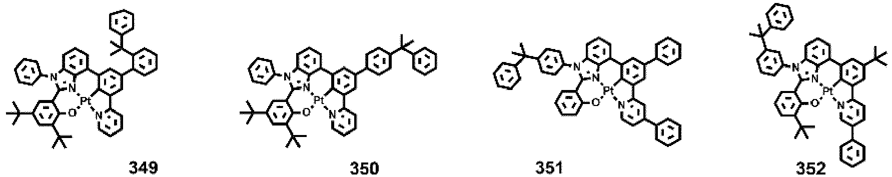

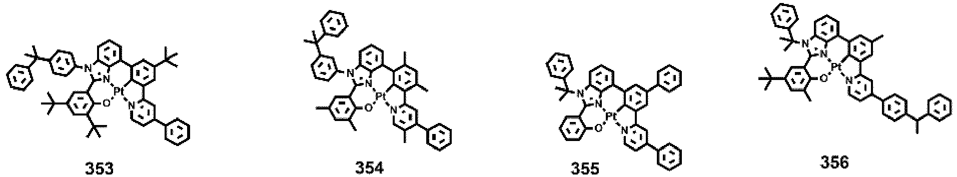

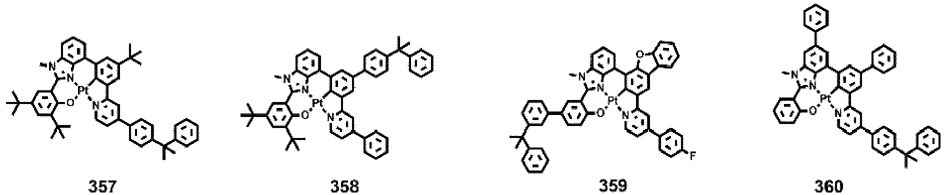

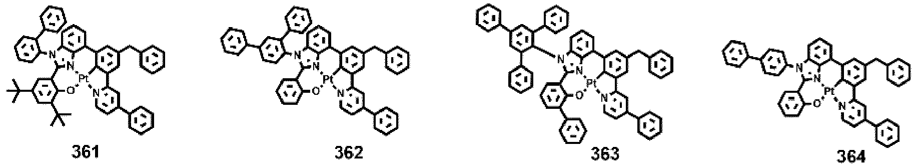

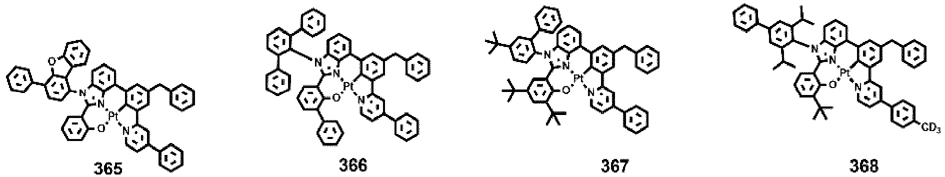

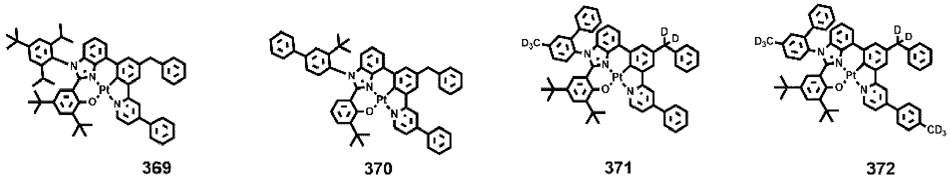

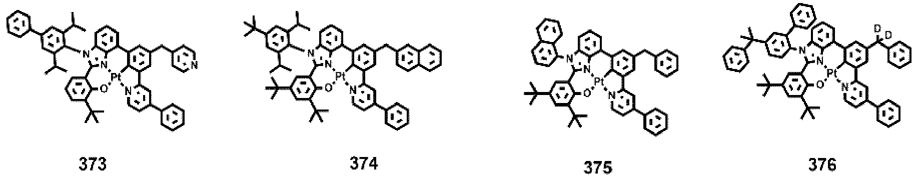

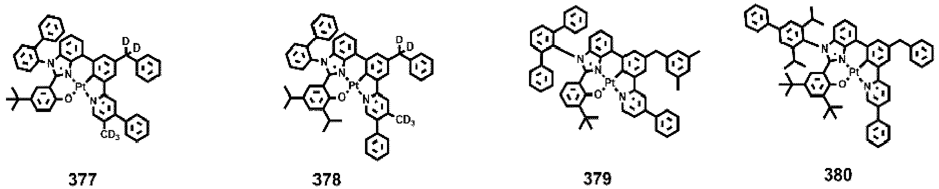

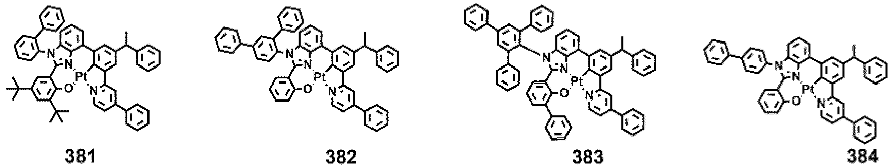

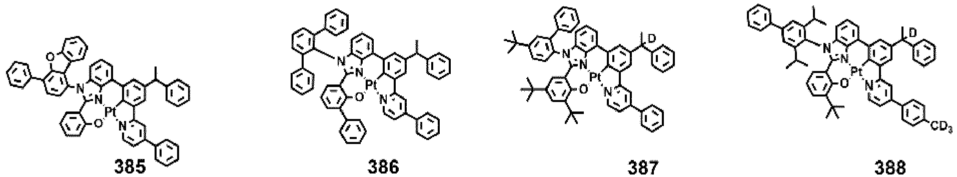

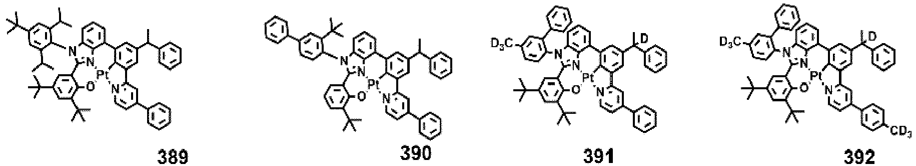

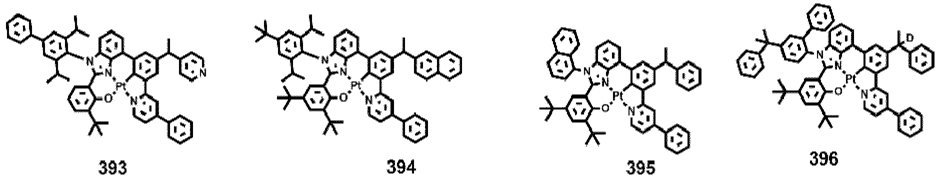

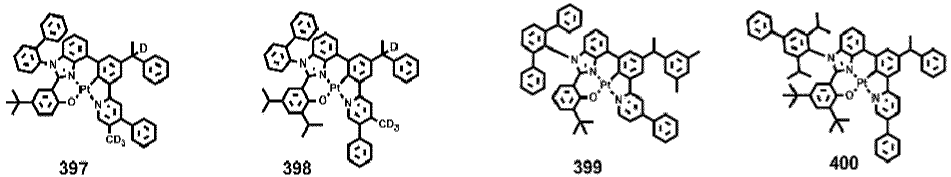

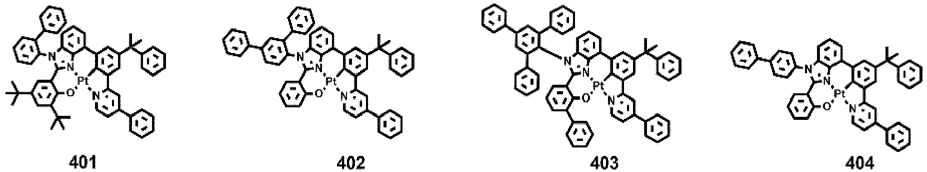

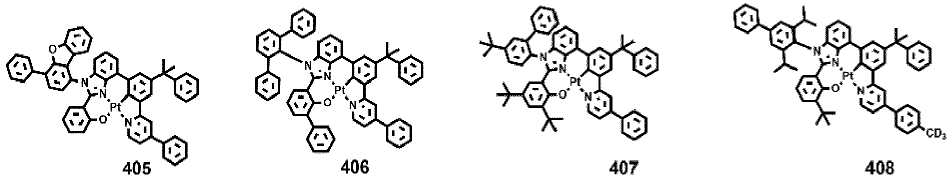

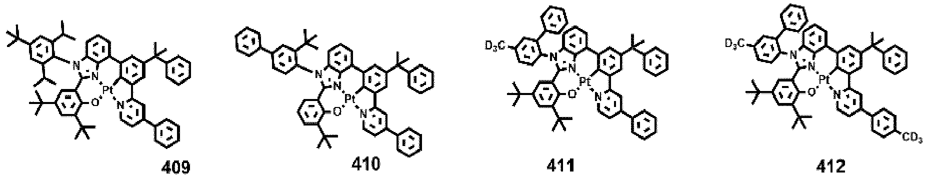

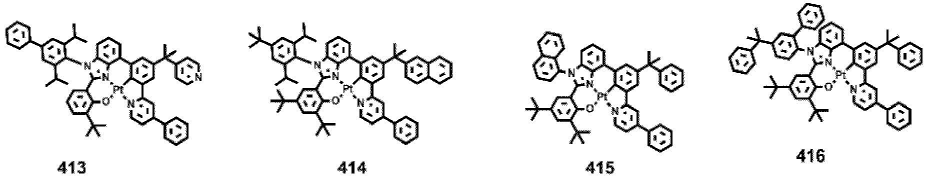

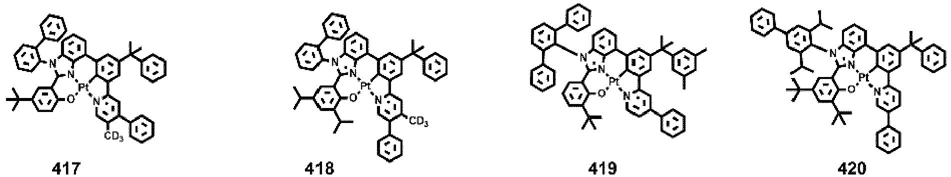

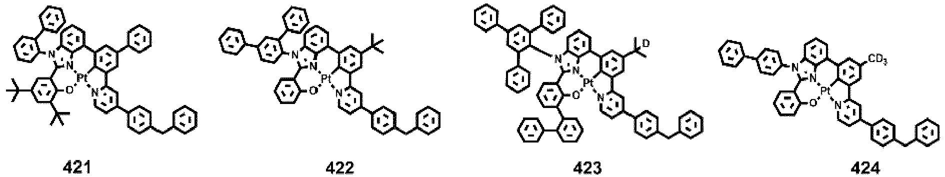

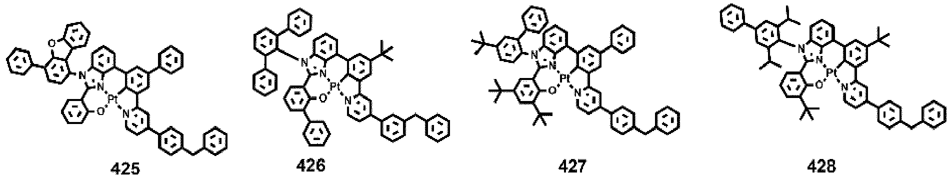

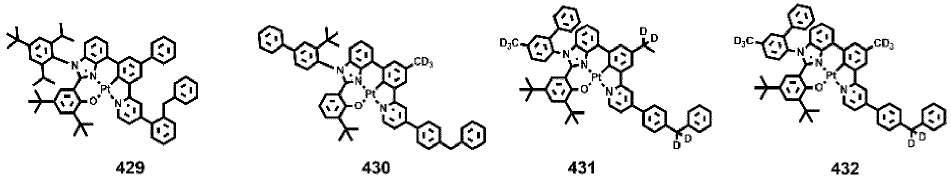

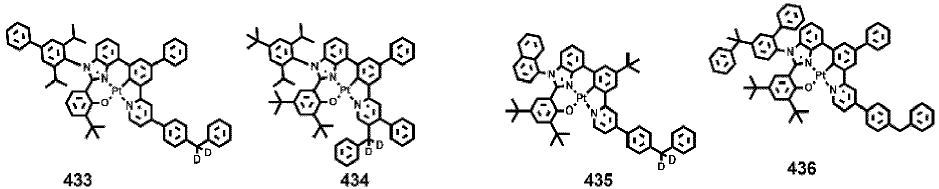

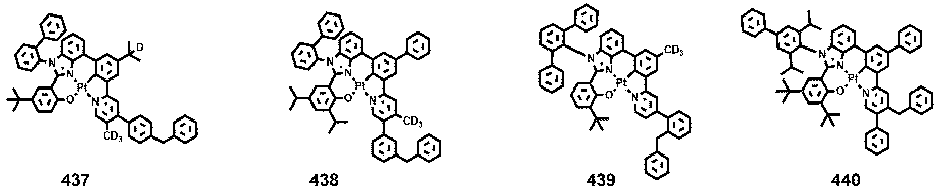

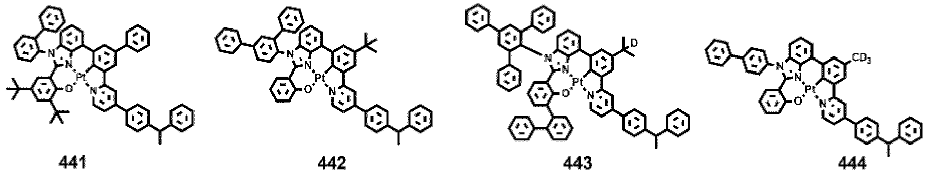

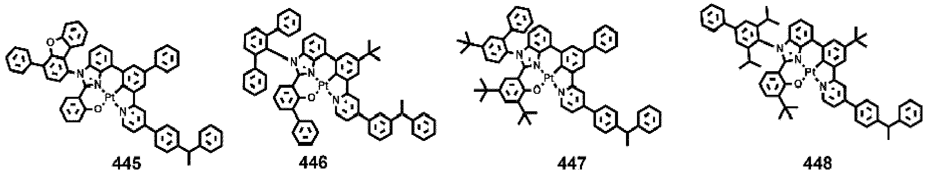

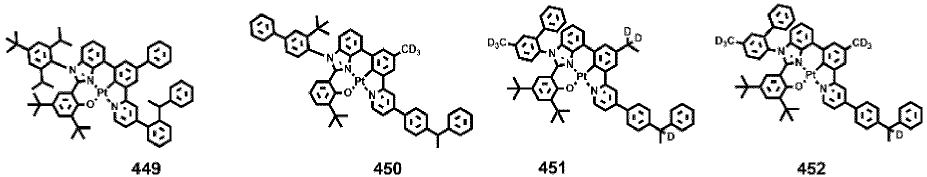

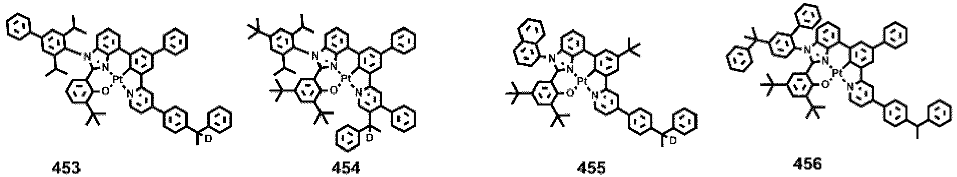

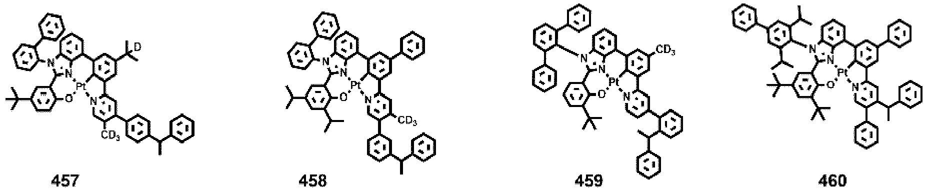

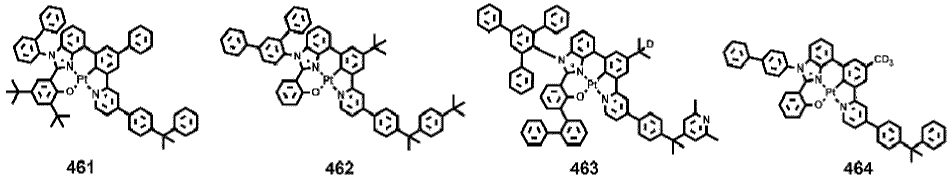

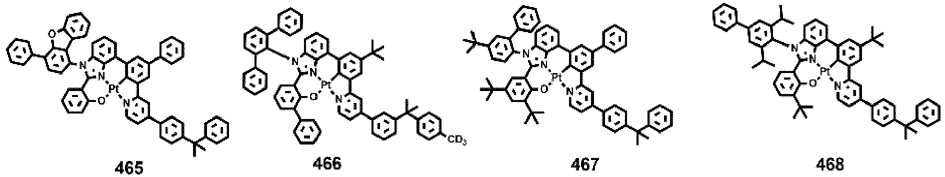

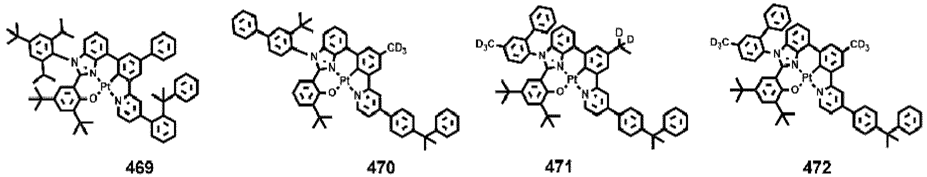

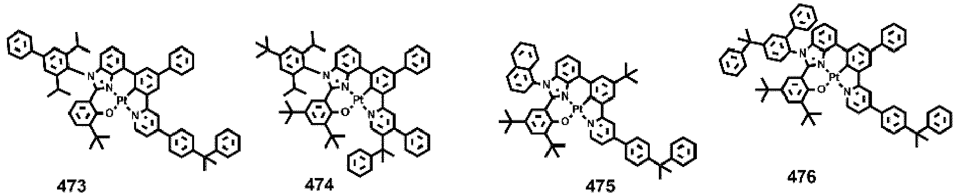

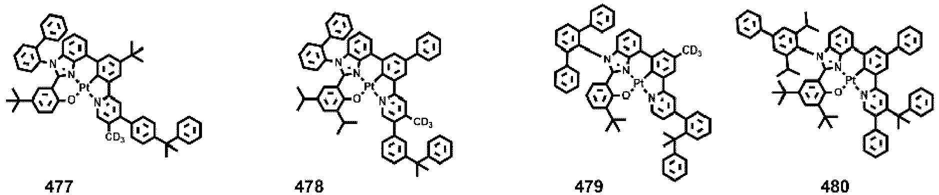

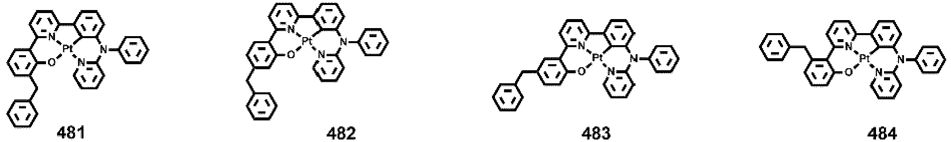

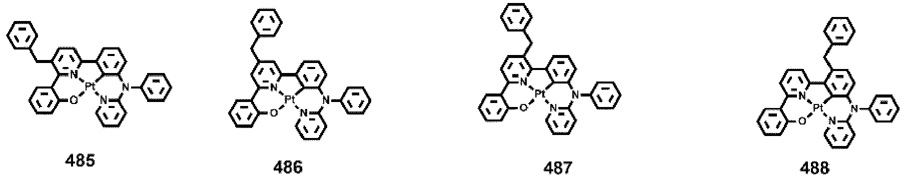

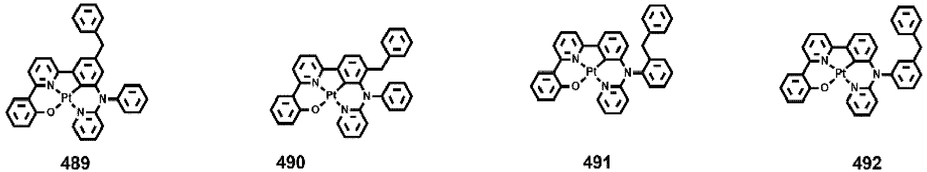

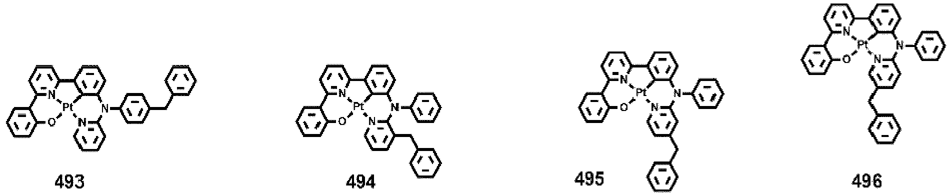

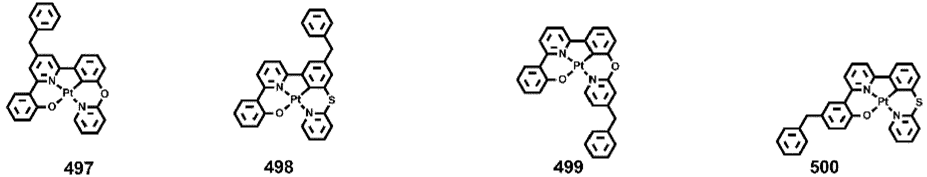

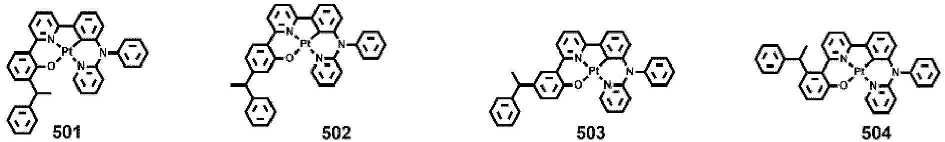

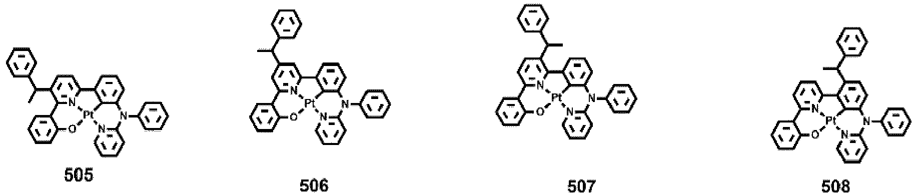

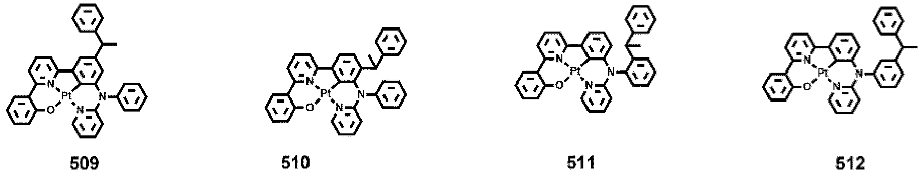

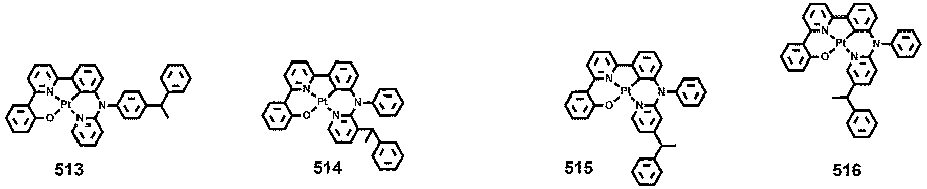

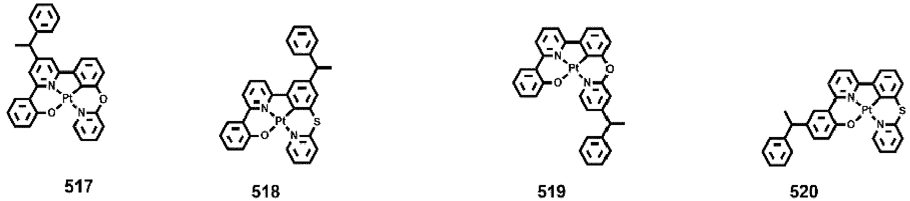

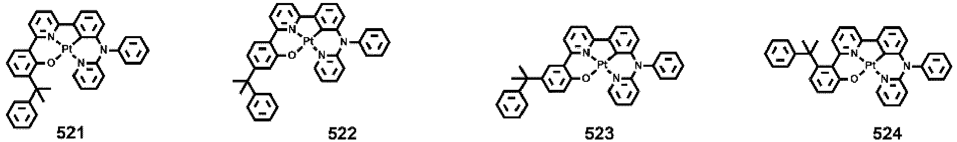

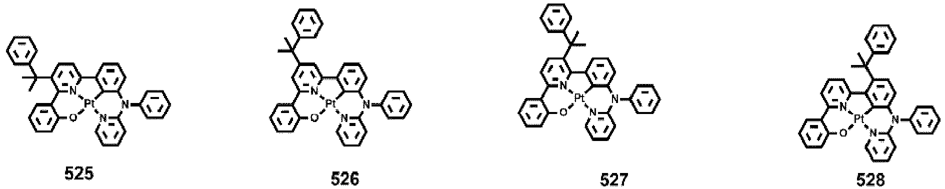

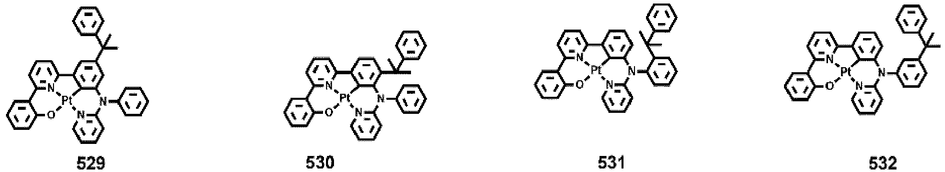

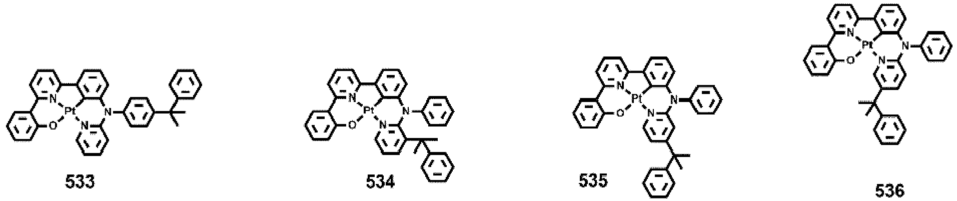

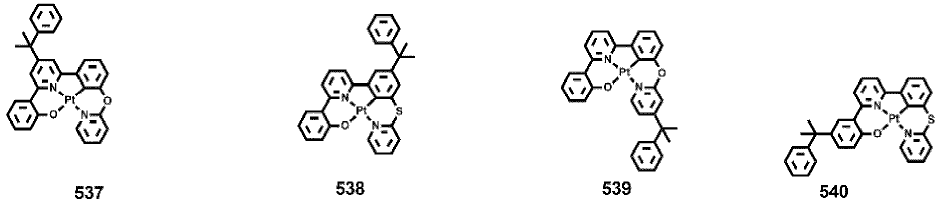

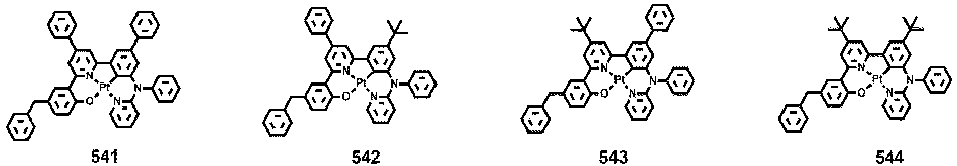

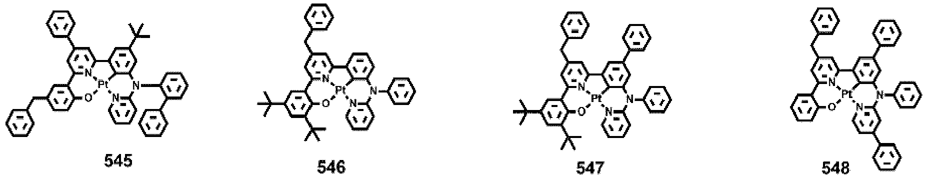

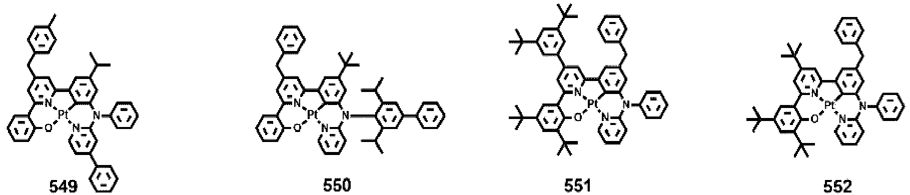

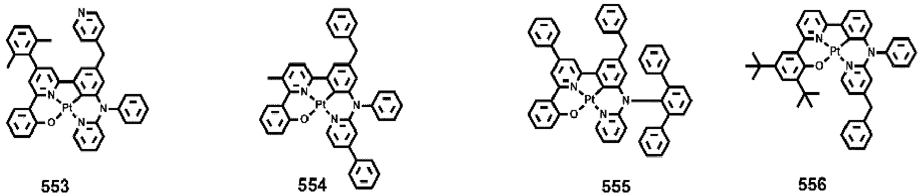

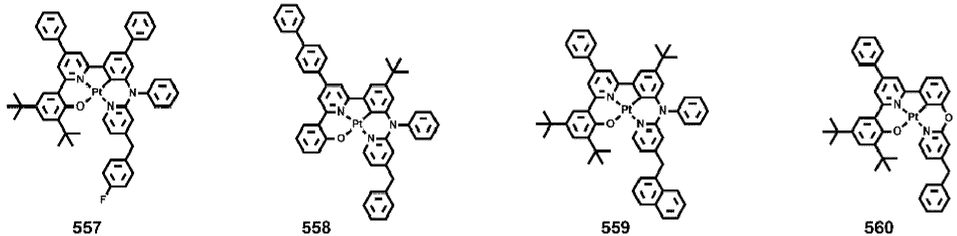

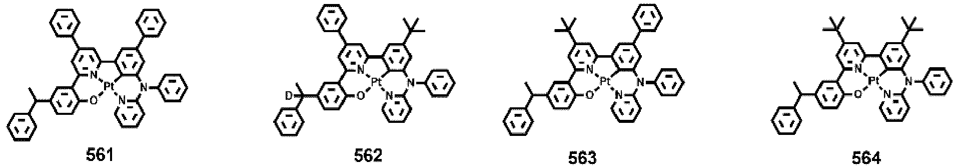

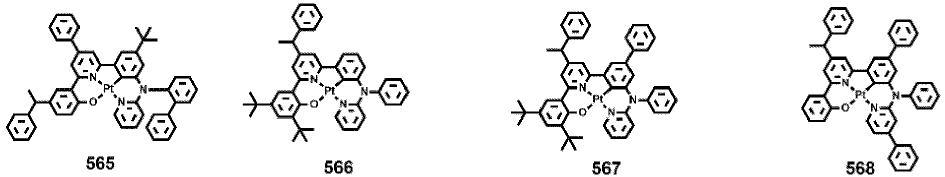

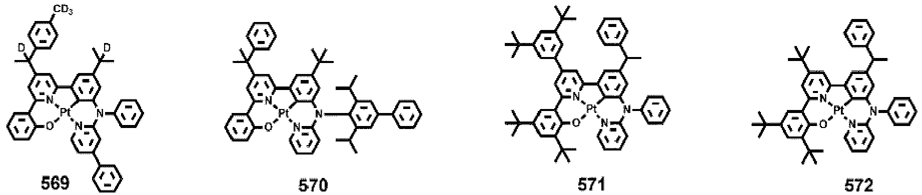

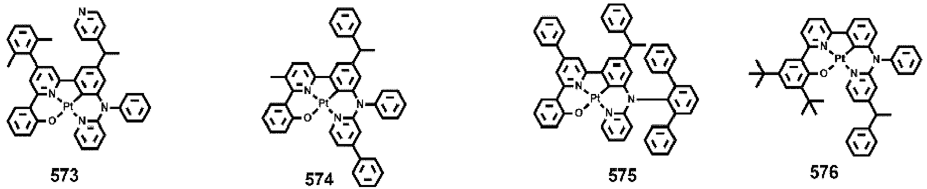

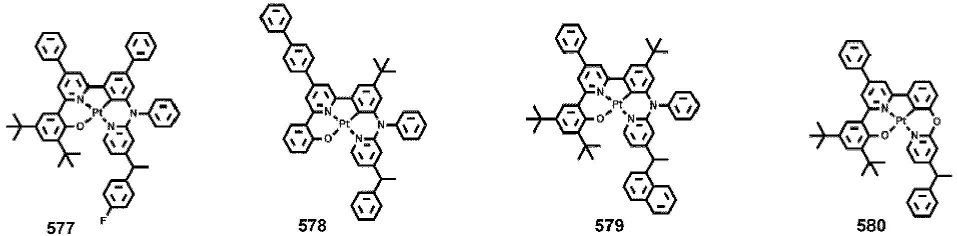

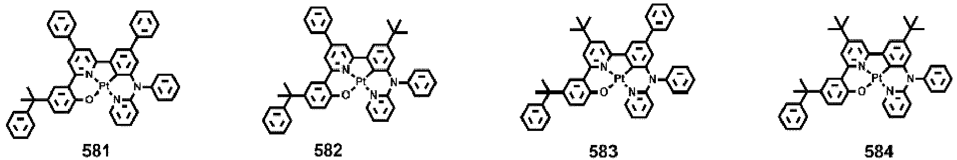

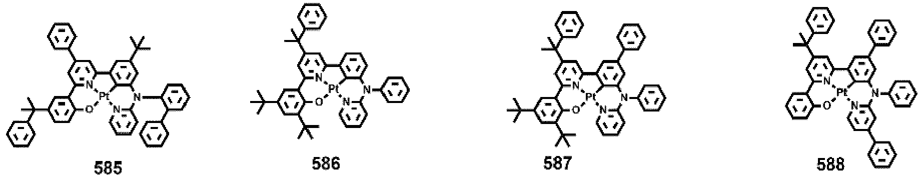

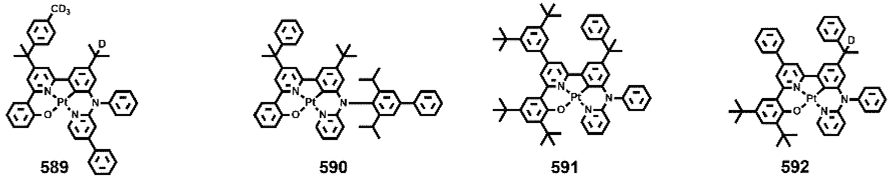

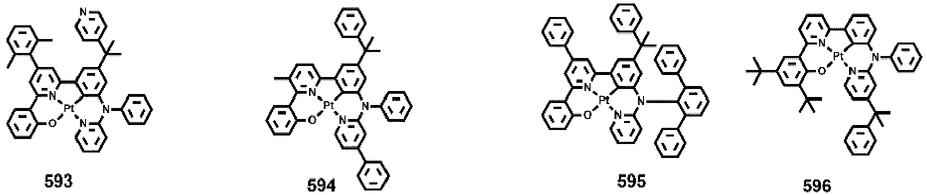

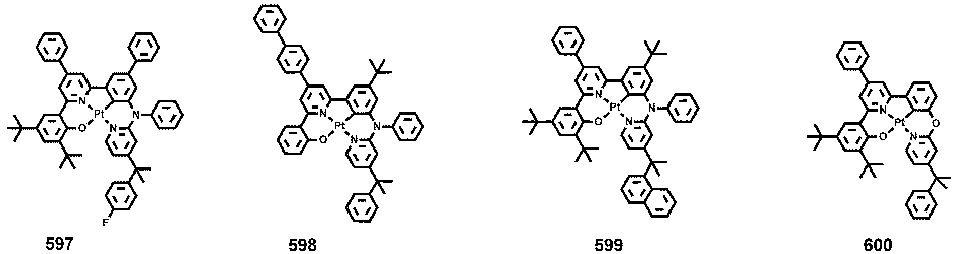

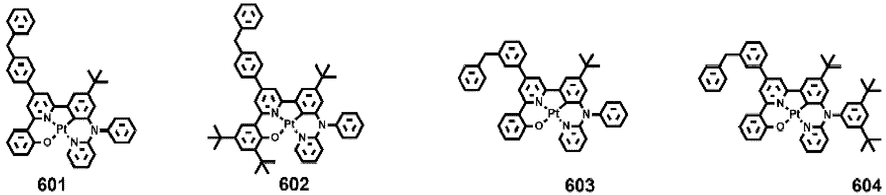

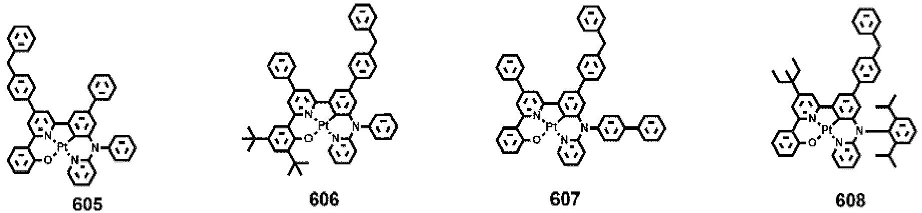

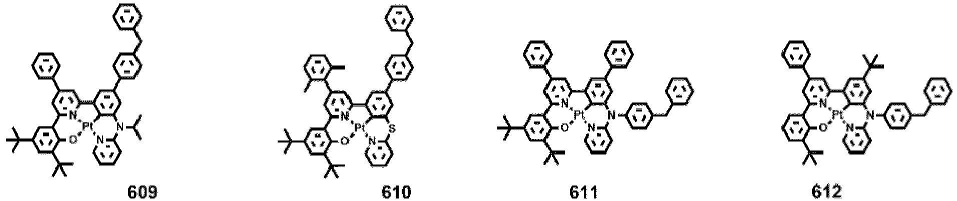

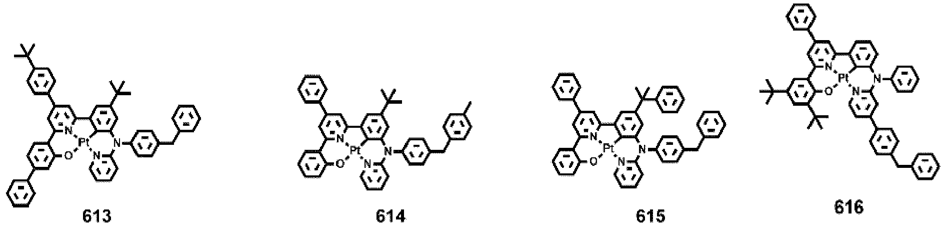

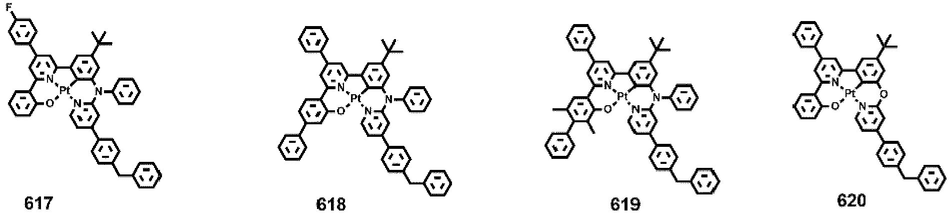

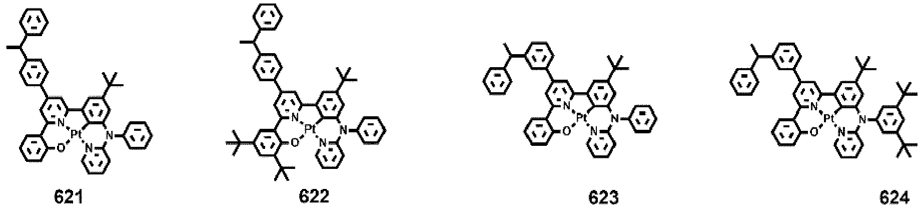

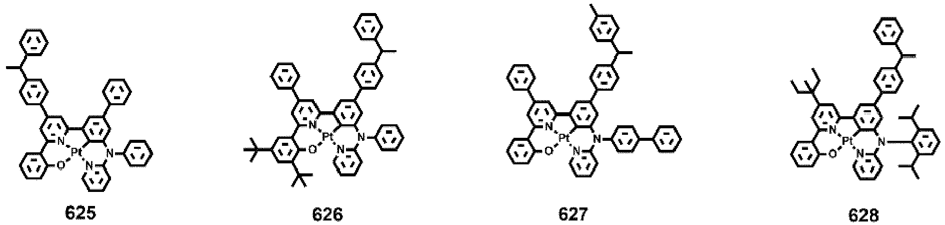

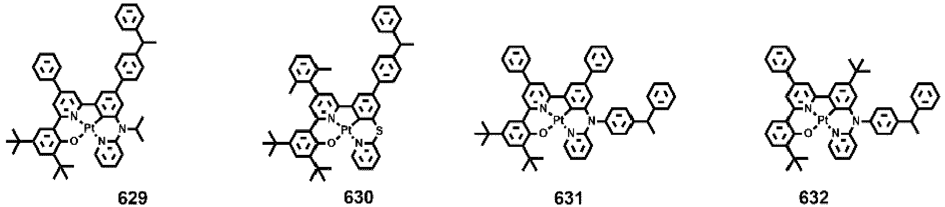

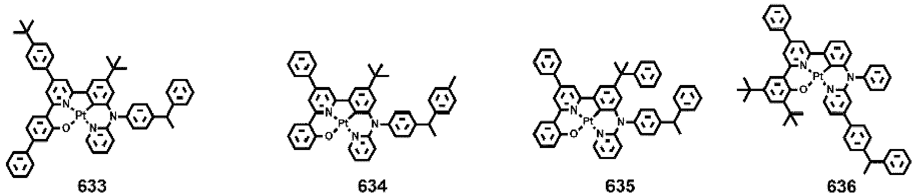

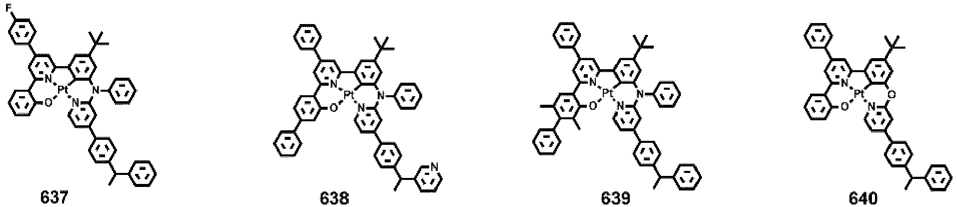

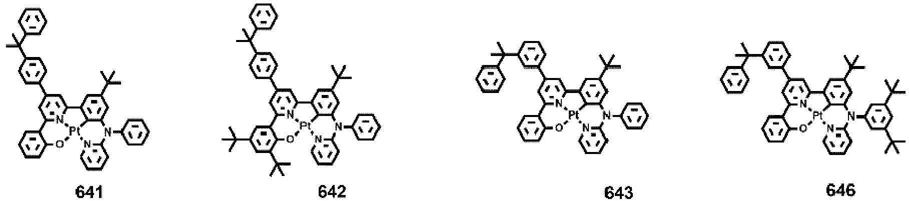

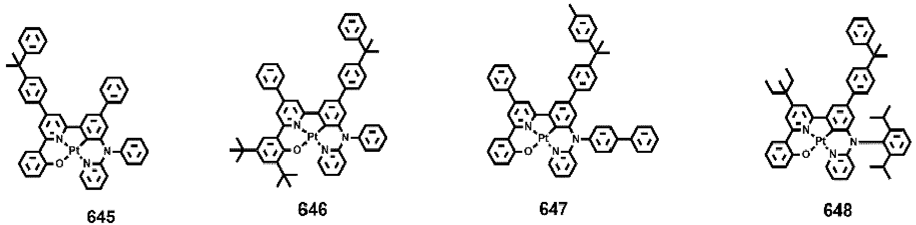

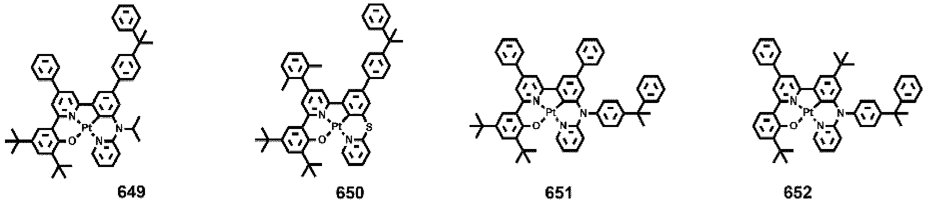

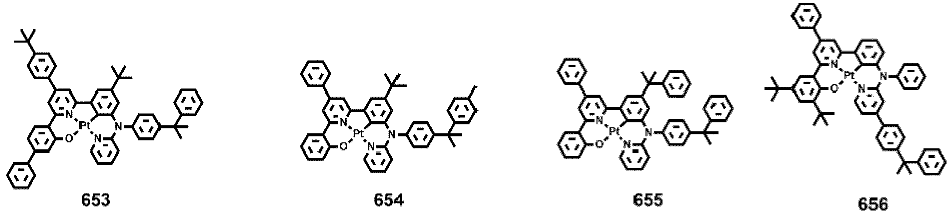

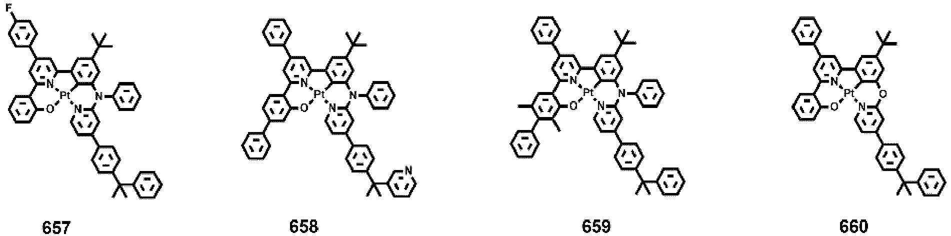

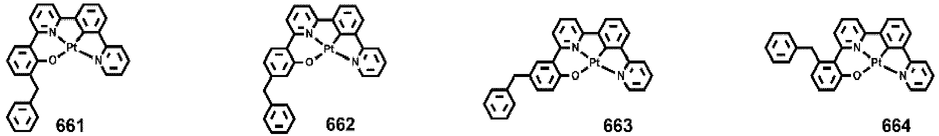

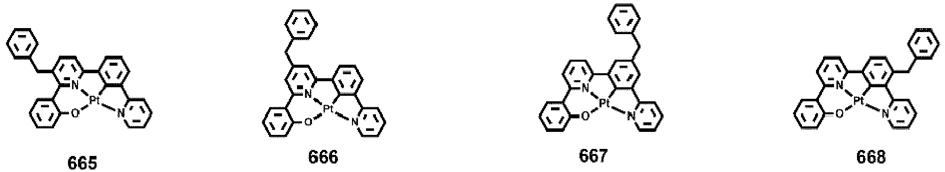

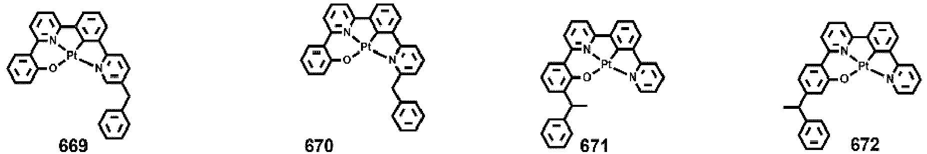

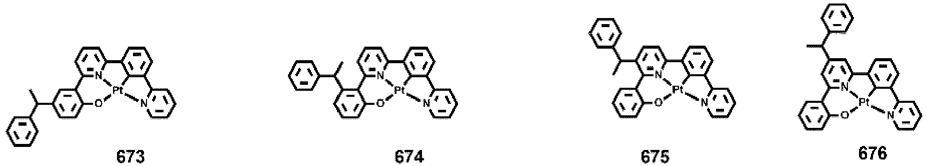

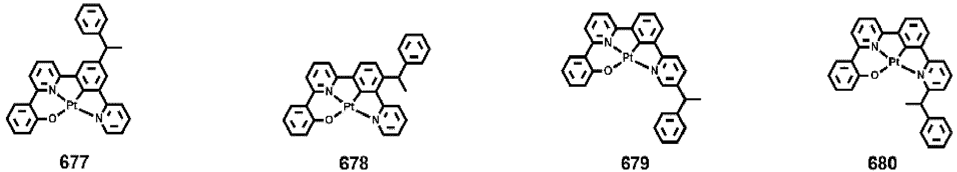

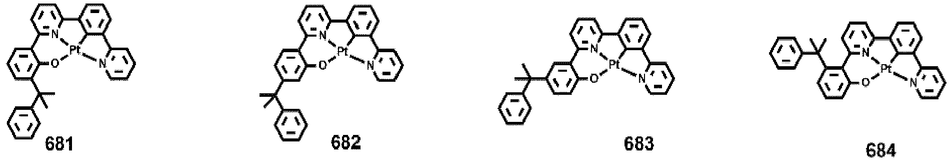

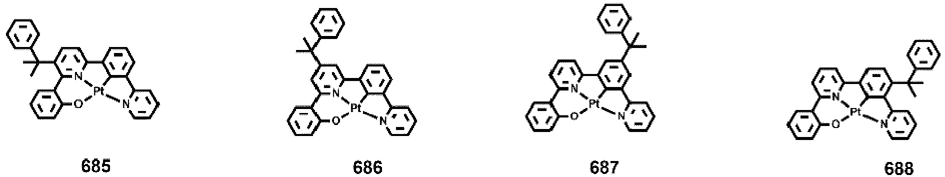

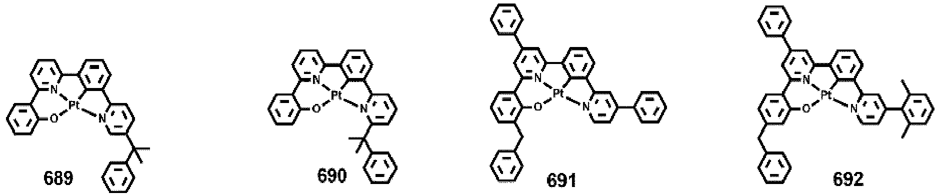

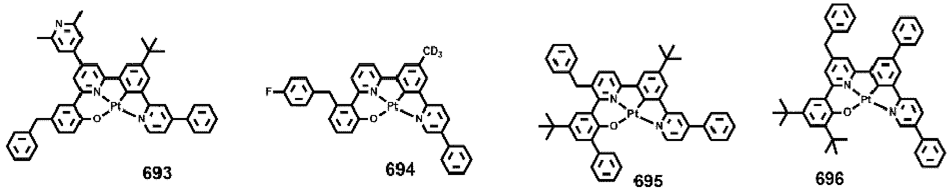

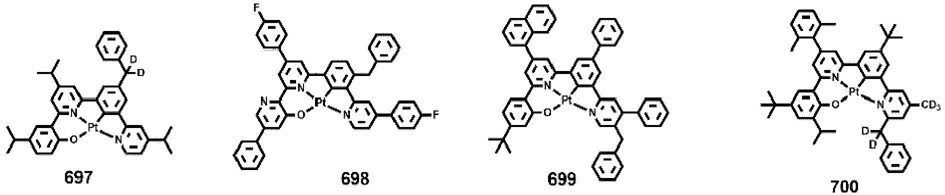

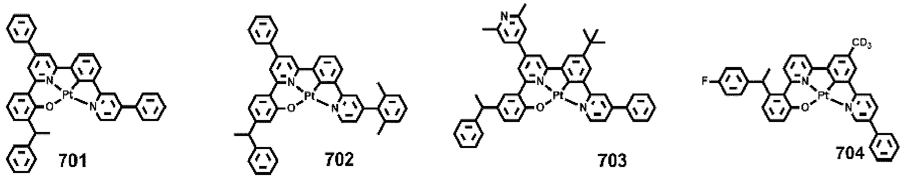

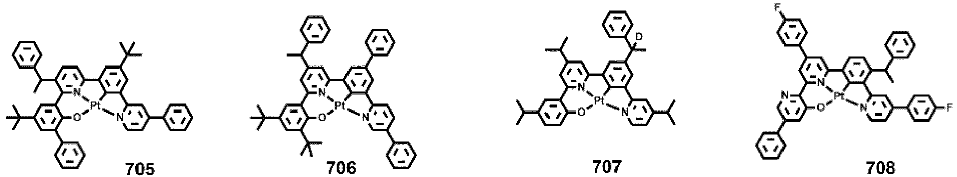

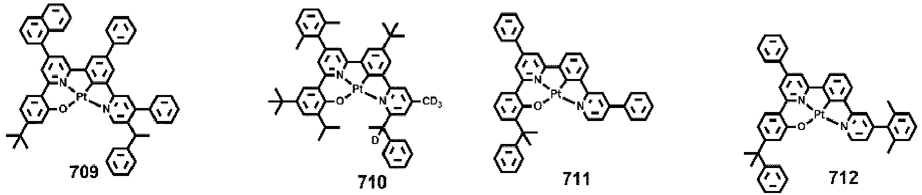

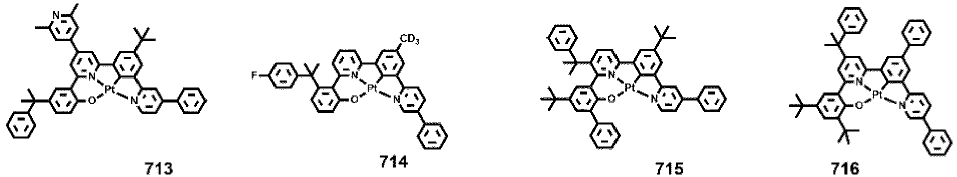

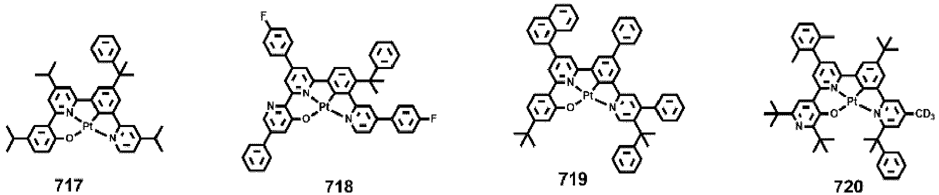

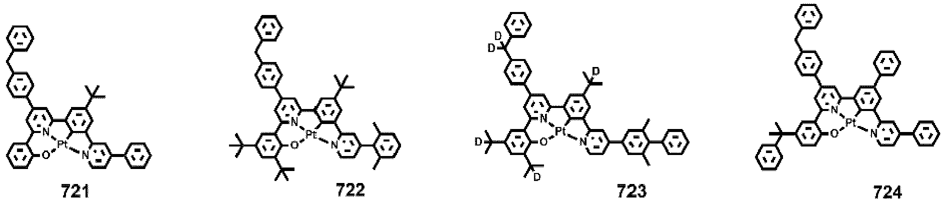

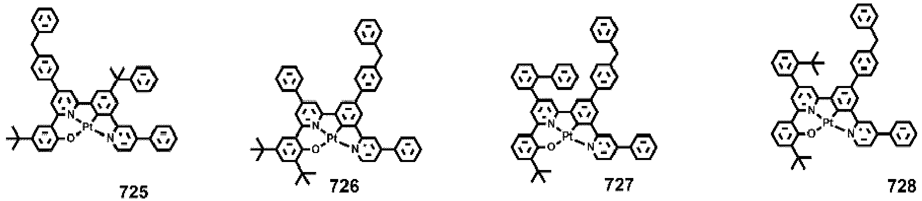

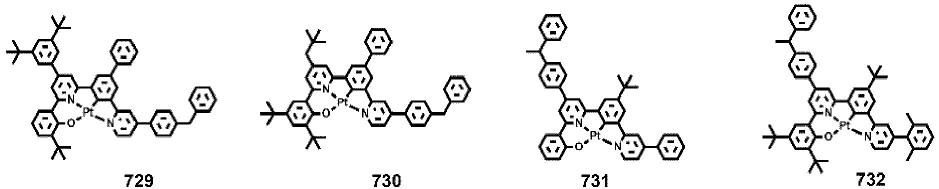

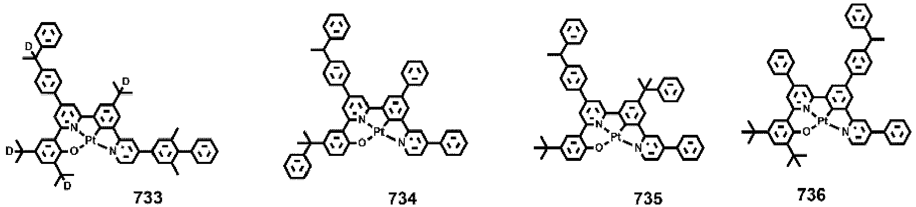

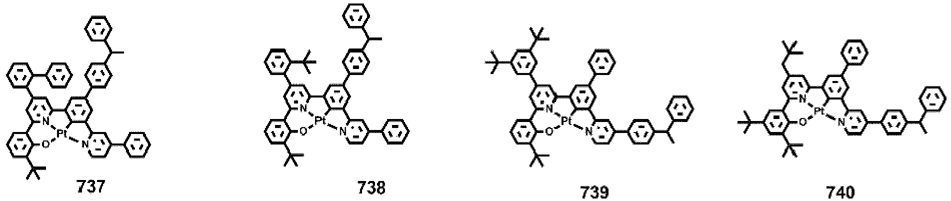

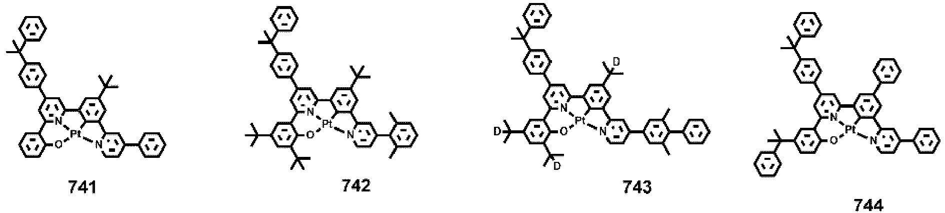

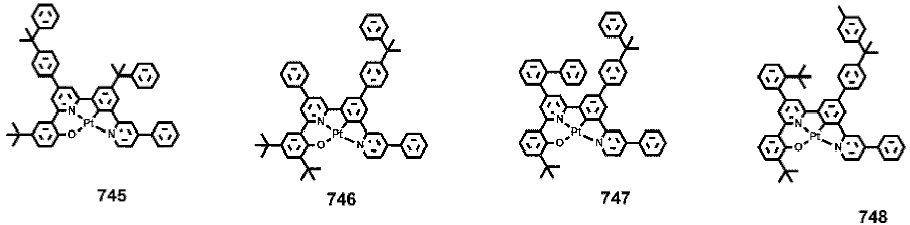

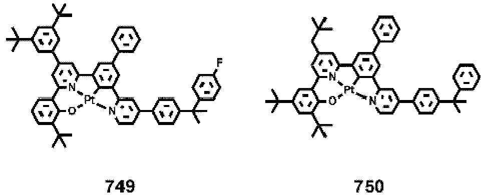

The organometallic compound represented by Formula 1 satisfies at least one of Condition 1 and Condition 2 as described in the present specification. In other words, the organometallic compound represented by Formula 1 includes, as a substituent, at least one group represented by Formula 51. Accordingly, the organometallic compound represented by Formula 1 may have improved planarity and orientation characteristics, and thus, an electronic device, for example, an organic light-emitting device, using the organometallic compound represented by Formula 1 may have improved characteristics in terms of luminescence efficiency and/or lifespan.

A highest occupied molecular orbital (HOMO) energy level, lowest unoccupied molecular orbital (LUMO) energy level, and T₁ energy level of the exemplary organometallic compound represented by Formula 1 were evaluated using the Gaussian 09 program with the molecular structure optimization obtained by B3LYP-based density functional theory (DFT), and results thereof are shown in Table 1. The energy levels in Table 1 are in electron volts (eV).

**Table 1**

| Compound No. | HOMO (eV) | LUMO (eV) | T₁(eV) |
|---|---|---|---|
| 317 | -4.710 | -1.707 | 2.388 |
| 351 | -4.790 | -1.735 | 2.369 |
| 592 | -4.535 | -1.612 | 2.138 |
| 741 | -4.689 | -1.877 | 2.120 |

From Table 1, it is confirmed that the organometallic compound represented by Formula 1 has such electric characteristics that are suitable for use as a dopant for an electric device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of an organic light-emitting device, for example, a dopant in an emission layer of the organic layer. Thus, according to another aspect, provided is an organic light-emitting device including: a first electrode; a second electrode; and an organic layer located between the first electrode and the second electrode and including an emission layer, and the organic layer includes at least one organometallic compound represented by Formula 1.

Because the organic light-emitting device includes an organic layer including the organometallic compound represented by Formula 1, the organic light-emitting device may have higher external quantum efficiency and long lifespan.

The organometallic compound represented by Formula 1 may be utilized between a pair of electrodes of an organic light-emitting device. In one or more embodiments, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). The emission layer may emit, for example, green light or blue light.

The expression "(an organic layer) includes at least one organometallic compounds represented by Formula 1" used herein may include a case in which "(an organic layer) includes identical organometallic compounds represented by Formula 1" and a case in which "(an organic layer) includes two or more different organometallic compounds represented by Formula 1".

In one or more embodiments, the organic layer may include, as the organometallic compound, a single Compound 1. In this embodiment, the single Compound 1 may be included in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region located between the first electrode and the emission layer and an electron transport region located between the emission layer and the second electrode, the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

FIGURE is a schematic cross-sectional view of an organic light-emitting device 10 according to one or more embodiments. Hereinafter, a structure of an organic light-emitting device according to one or more embodiments of the present disclosure and a method of manufacturing an organic light-emitting device according to one or more embodiments of the present disclosure will be described in connection with FIGURE. The organic light-emitting device 10 includes a first electrode 11, an organic layer 15, and a second electrode 19, which are sequentially stacked.

A substrate may be additionally located under (e.g., below) the first electrode 11 or above (e.g., on top of) the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. In one or more embodiments, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80°C to about 200°C.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

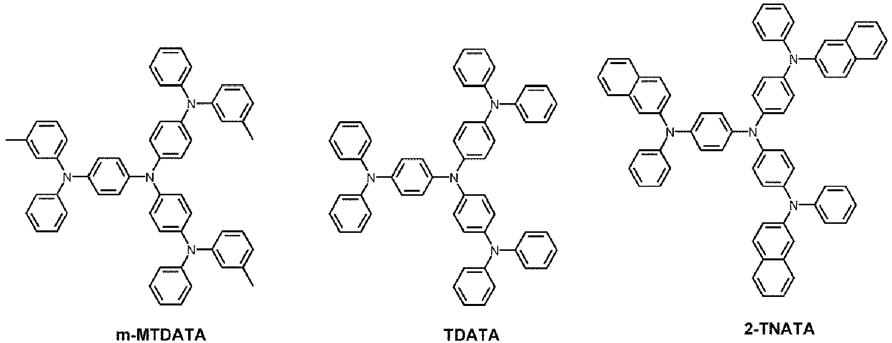

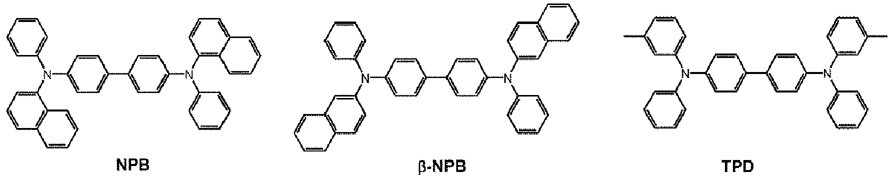

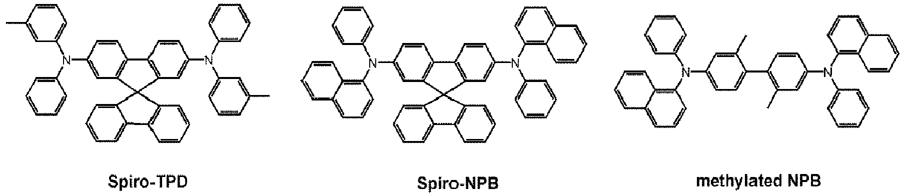

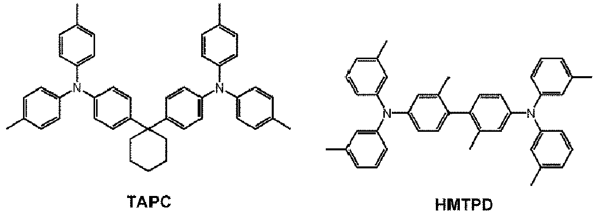

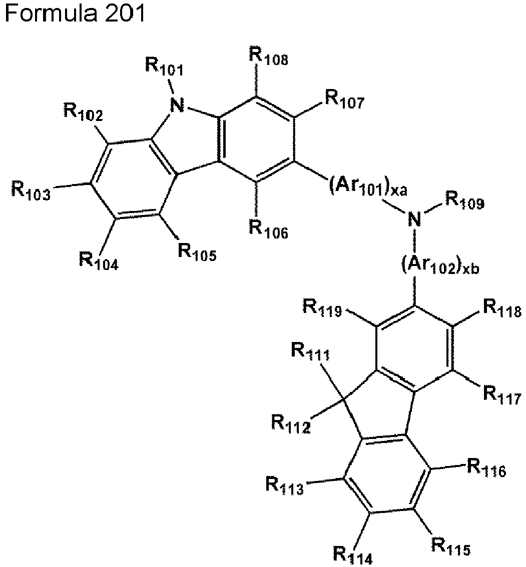

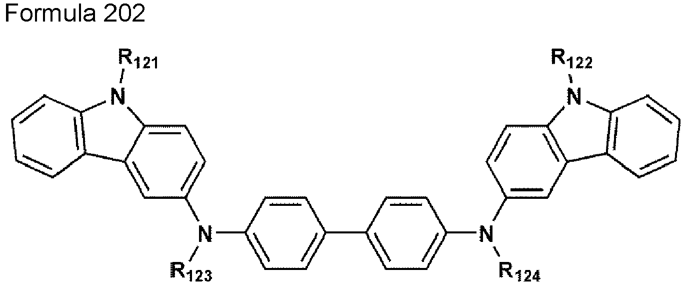

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. In one or more embodiments, xa may be 1, and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), or a C₁-C₁₀ alkoxy group (for example, a methoxy group, an ethoxy group, a propoxy group, a butoxy group, a pentoxy group, or the like);
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with deuterium, - F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, C₁-C₁₀ alkyl group, a C₁-C₁₀ alkoxy group, or a combination thereof.

R₁₀₉ in Formula 201 may be a phenyl group, a naphthyl group, an anthracenyl group, or a pyridinyl group, each unsubstituted or substituted with deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or a combination thereof.

In one or more embodiments, the compound represented by Formula 201 may be represented by Formula 201A:

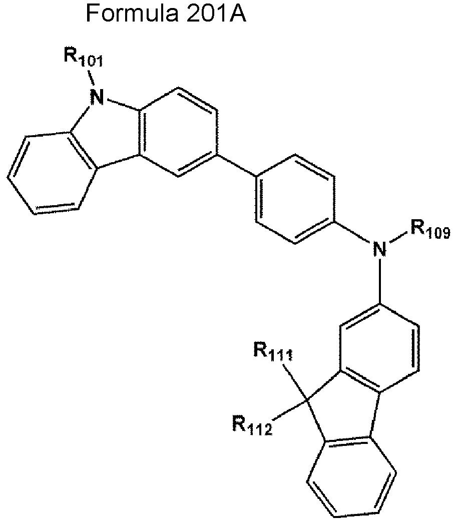

R₁₀₁, R₁₁₁, R₁₁₂, and R₁₀₉ in Formula 201A may each be the same as described above.

In one or more embodiments, the hole transport region may include one of Compounds HT1 to HT20 or a combination thereof:

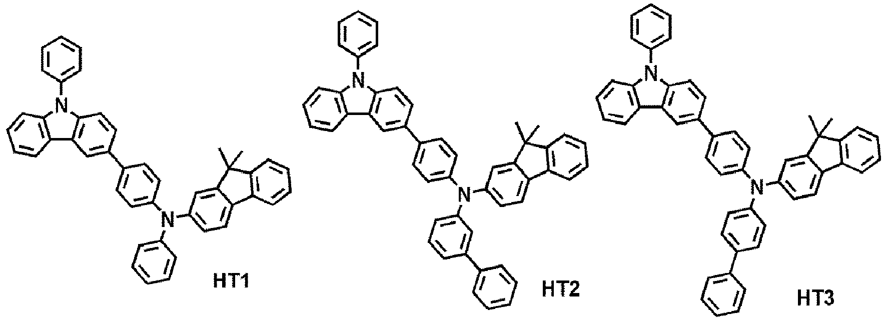

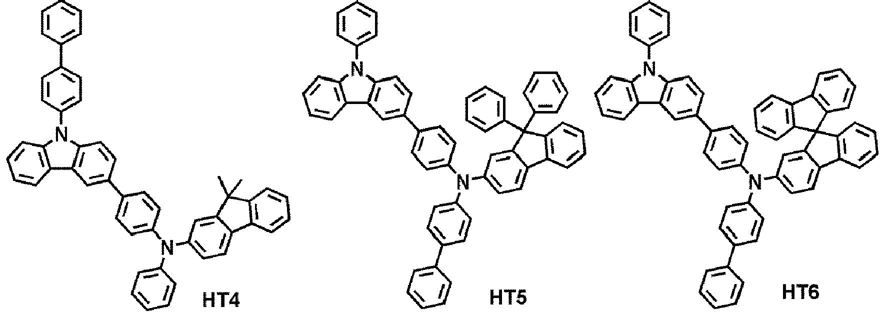

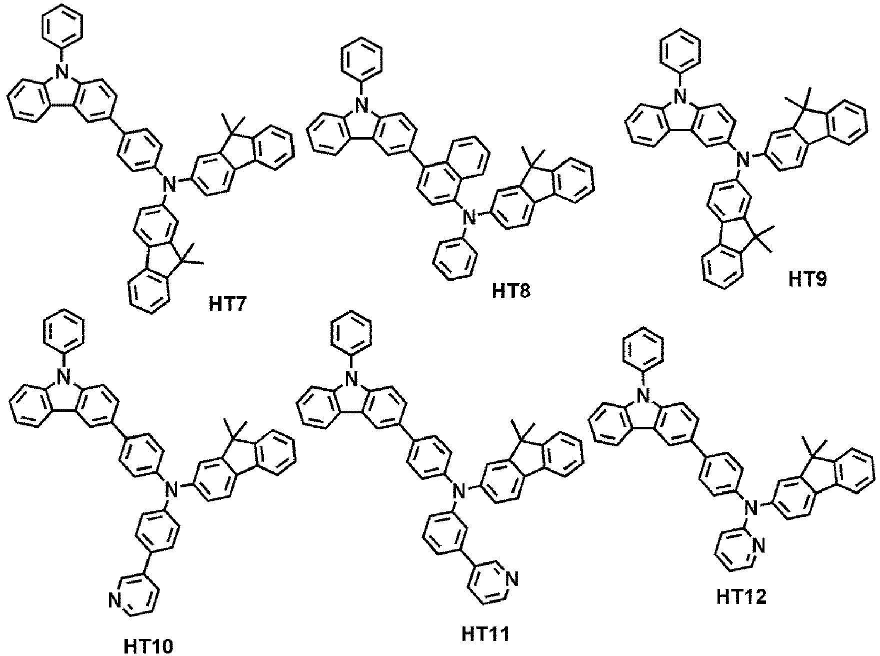

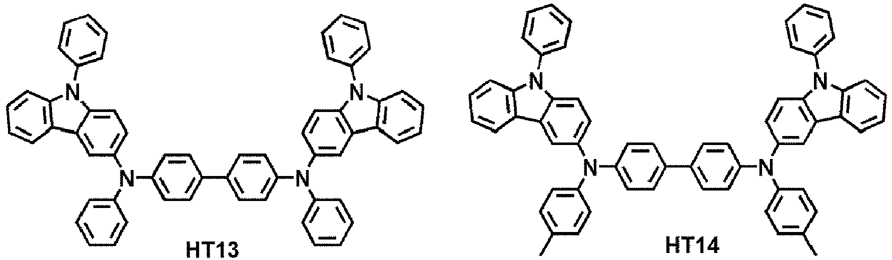

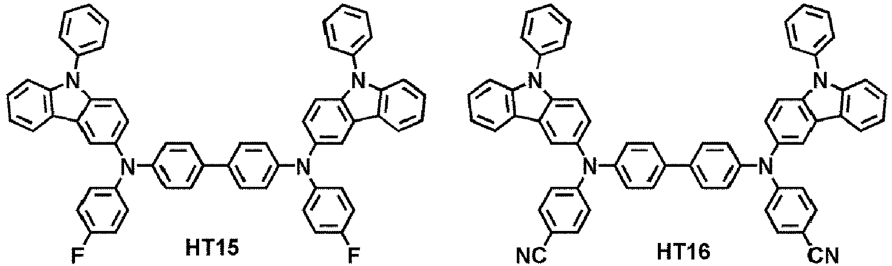

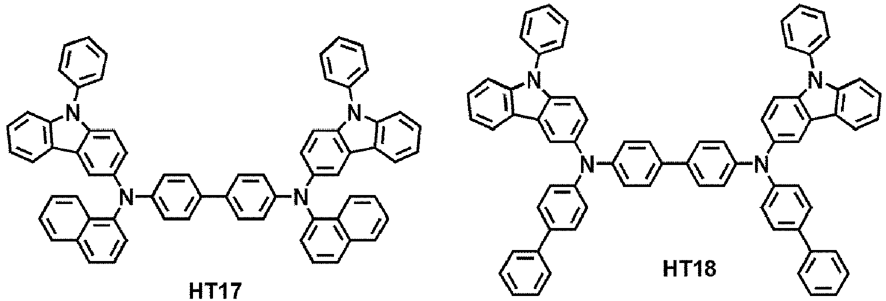

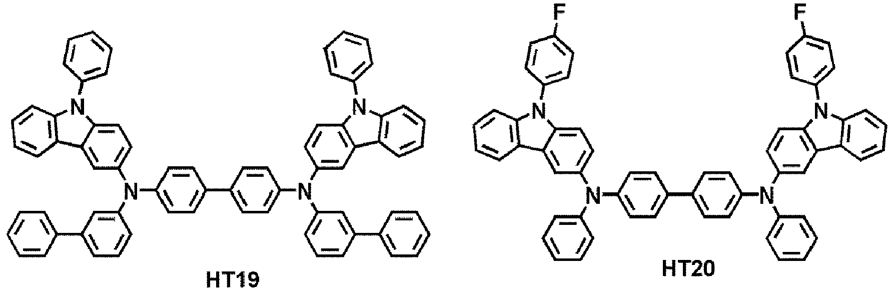

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generating material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. In one or more embodiments, the p-dopant may be: a quinone derivative such as tetracyanoquinodimethane (TCNQ), 2,3,5,6-tetrafluoro-tetracyano-1,4-benzoquinodimethane (F4-TCNQ), or F6-TCNNQ; metal oxide, such as tungsten oxide and molybdenum oxide; a cyano group-containing compound, such as Compound HT-D1; or a combination thereof.

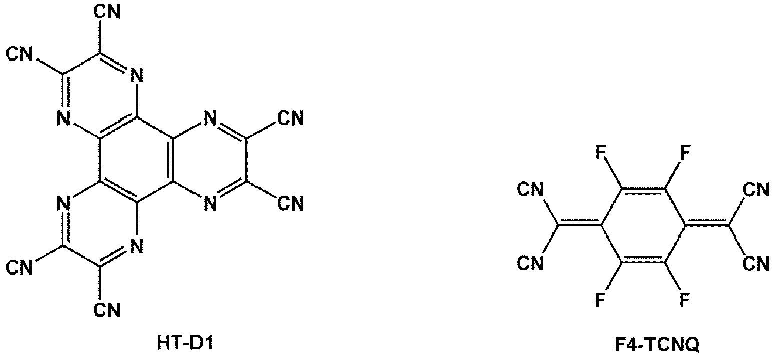

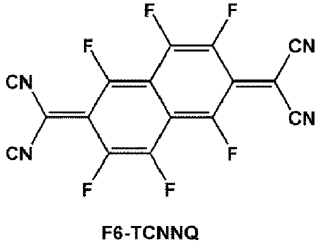

The hole transport region may further include a buffer layer.

The buffer layer may compensate for an optical resonance distance according to a wavelength of light emitted from the emission layer, and thus, efficiency of a formed organic light-emitting device may be improved.

In one or more embodiments, when the hole transport region includes an electron blocking layer, a material for forming the electron blocking layer may include a material that is used in the hole transport region as described above, a host material described below, or a combination thereof. In one or more embodiments, when the hole transport region includes an electron blocking layer, mCP described below, Compound H-H1 described below, or a combination thereof may be used as the material for forming the electron blocking layer.

An emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary depending on a compound that is used to form the emission layer.

The emission layer may include a host and a dopant, and the dopant may include the organometallic compound represented by Formula 1 as described herein.

The host may include TPBi, TBADN, ADN (also referred to as "DNA"), CBP, CDBP, TCP, mCP, Compound H50, Compound H51, Compound H52, Compound H-H1, Compound H-H2, or a combination thereof:

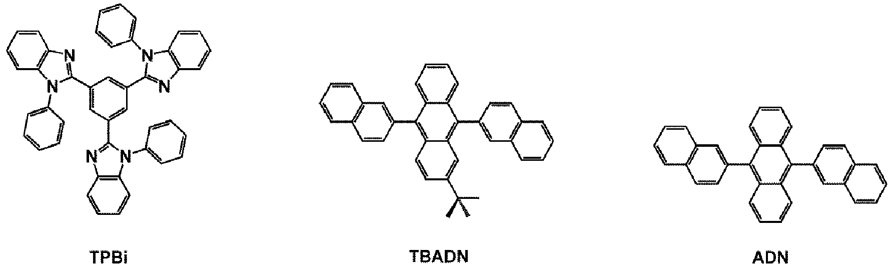

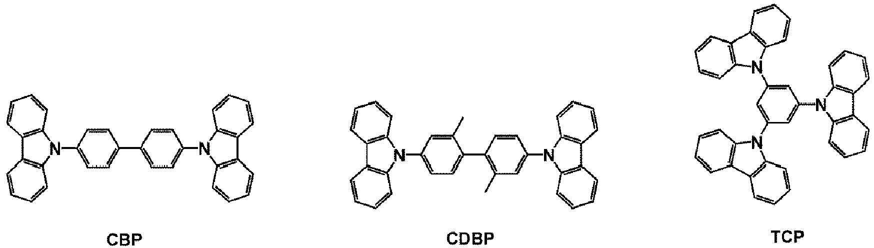

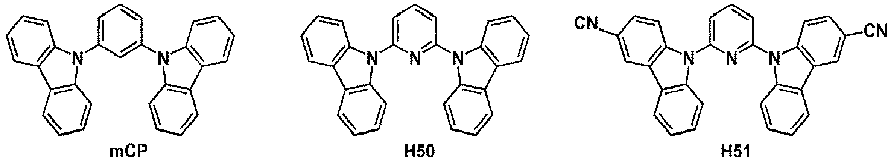

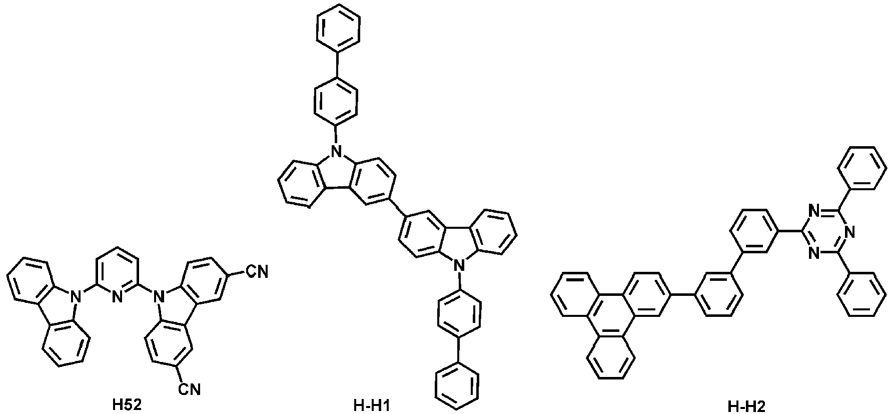

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 20 parts by weight based on 100 parts by weight of the host.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be located on the emission layer.

The electron transport region may include a hole blocking layer, an electron transport layer, an electron injection layer, or a combination thereof.

In one or more embodiments, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAlq, or a combination thereof.

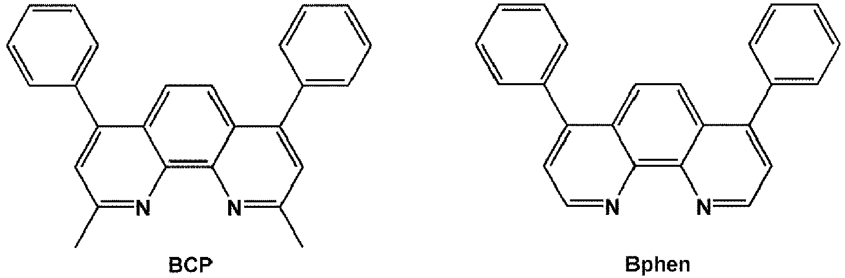

A thickness of the hole blocking layer may be in a range of about 20 Å to about 1,000 Å, for example, about 30 Å to about 600 Å. When the thickness of the hole blocking layer is within these ranges, the hole blocking layer may have excellent hole blocking characteristics without a substantial increase in driving voltage.

The electron transport layer may include BCP, Bphen, TPBi, Alq₃, BAlq, TAZ, NTAZ, or a combination thereof:

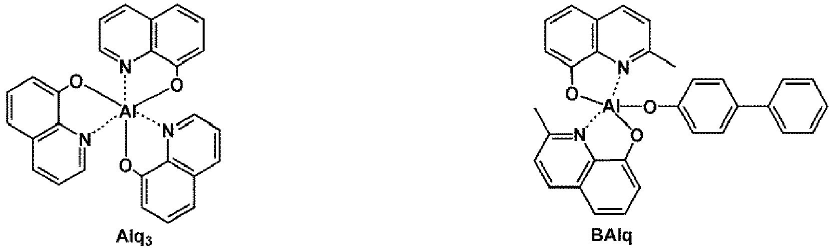

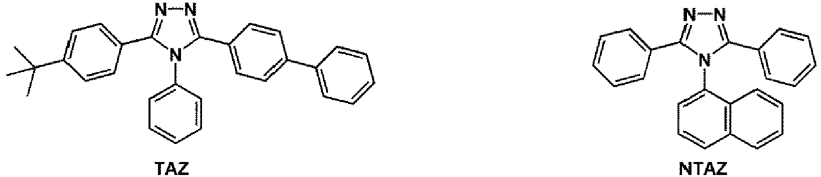

In one or more embodiments, the electron transport layer may include one of Compounds ET1 to ET25 or a combination thereof:

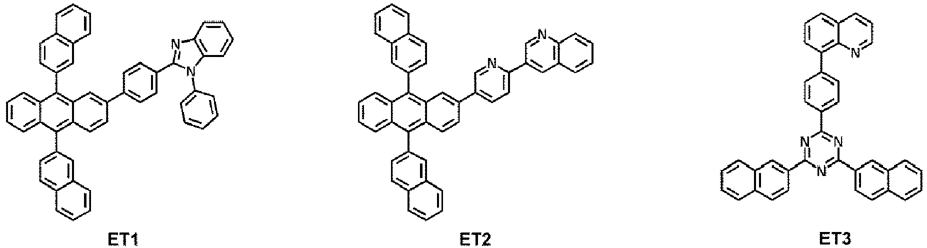

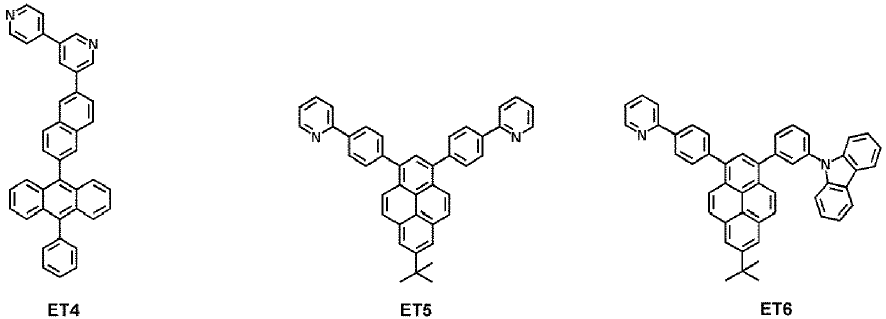

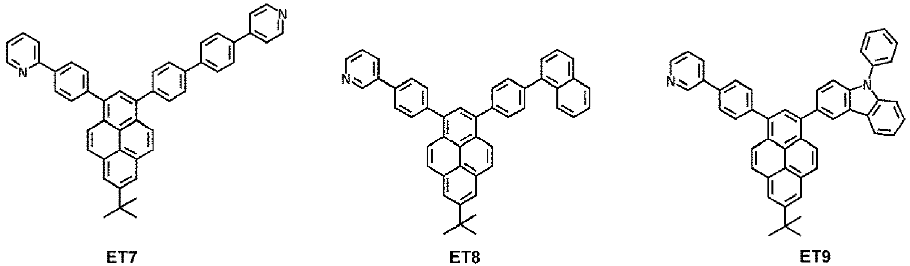

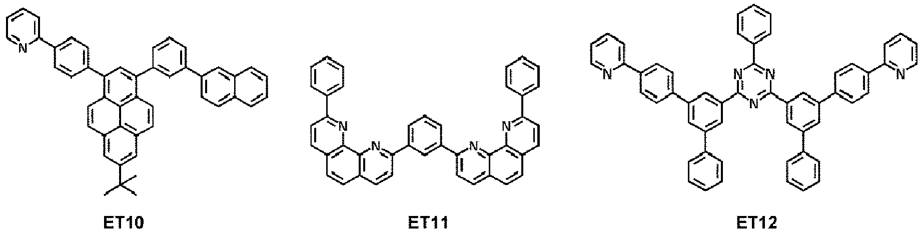

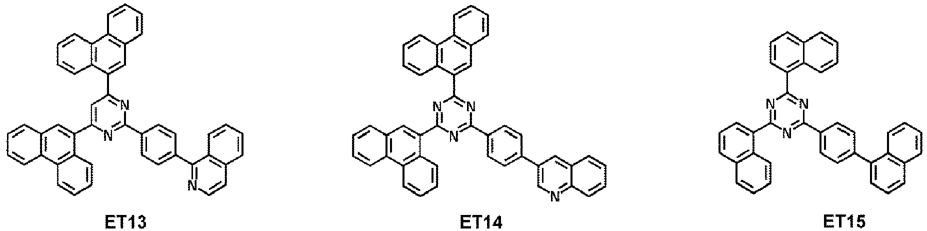

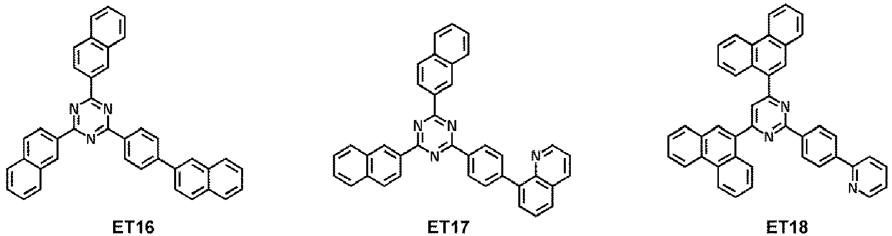

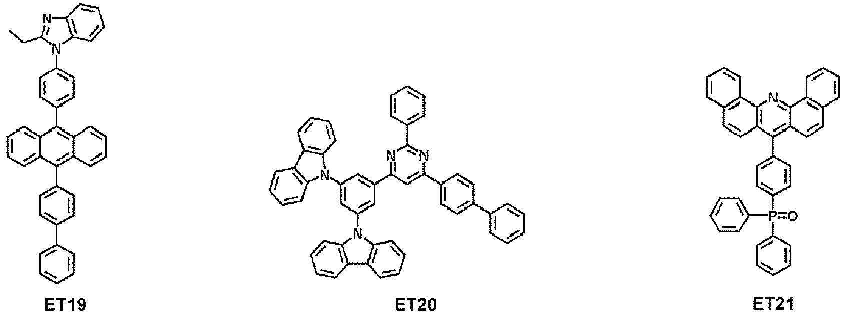

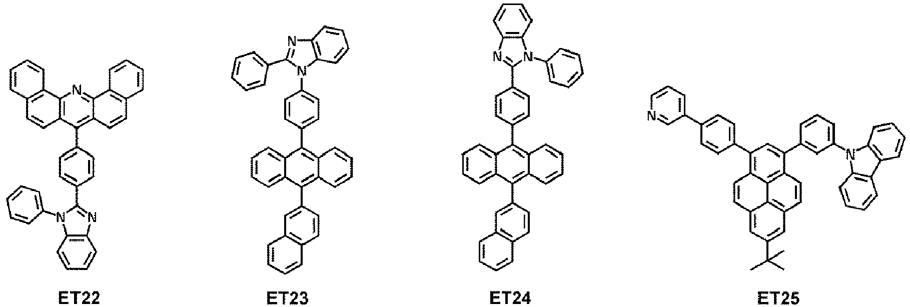

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 or ET-D2:

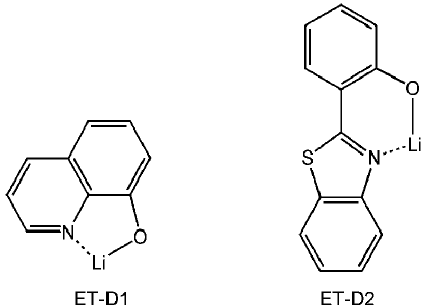

Also, the electron transport region may include an electron injection layer that promotes the flow of electrons from the second electrode 19 thereinto.

The electron injection layer may include LiF, NaCl, CsF, Li₂O, BaO, Compound ET-D1, Compound ET-D2, or a combination thereof.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIGURE, but embodiments of the present disclosure are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, and the like.

According to another aspect, provided is a diagnostic composition including at least one organometallic compound represented by Formula 1.

The organometallic compound represented by Formula 1 may provide high luminescence efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and examples thereof may include a methoxy group, an ethoxy group, a propoxy group, a butoxy group, or a pentoxy group.

The term "C₁-C₆₀ alklythio group" used herein refers to a monovalent group represented by -SA₁₀₁ (wherein A₁₀₁ is the C₁-C₆₀ alkyl group).

The term "C₂-C₆₀ alkenyl group" as used herein has a structure including at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group may include a cyclopropyl group, a cyclobutyl group, a cyclopentyl, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monocyclic group that includes at least one heteroatom selected from N, O, P, Si, S, Se, Ge, and B as a ring-forming atom instead of a carbon atom, and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a valent monocyclic group that has 3 to 10 carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, S, Se, Ge, and B as a ring-forming atom instead of a carbon atom, 1 to 10 carbon atoms, and at least one carbon-carbon double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having at least one heteroatom selected from N, O, P, Si, S, Se, Ge, and B as a ring-forming atom instead of a carbon atom, and a cyclic aromatic system having 1 to 60 carbon atoms, and the term "C₁-C₆₀ heteroarylene group" as used herein refers to a divalent group having at least one heteroatom selected from N, O, P, Si, S, Se, Ge, and B as a ring-forming atom instead of a carbon atom, and a cyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The C₂-C₆₀ heteroaryl alkyl group used herein refers to a C₁-C₆₀ alkyl group substituted with at least one C₁-C₆₀ heteroaryl group.

The term "C₆-C₆₀ aryloxy group" as used herein indicates a group of formula - OA₁₀₂ (wherein A₁₀₂ indicates the C₆-C₆₀ aryl group), the C₆-C₆₀ arylthio group indicates a group of formula -SA₁₀₃ (wherein A₁₀₃ indicates the C₆-C₆₀ aryl group), and the C₁-C₆₀ alkylthio group indicates a group of formula -SA₁₀₄ (wherein A₁₀₄ indicates the C₁-C₆₀ alkyl group).

The term "C₁-C₆₀ heteroaryloxy group" as used herein indicates a group of formula -OA₁₀₂ₐ (wherein A₁₀₂ₐ indicates the C₁-C₆₀ heteroaryl group), and the C₁-C₆₀ heteroarylthio group indicates a group of formula -SA₁₀₃ₐ (wherein A₁₀₃ₐ indicates the C1-C60 heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and non-aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and non-aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of a substituted or unsubstituted C₅-C₃₀ carbocyclic group may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each unsubstituted or substituted with at least one R₁₀ₐ.

The term "C₁-C₃₀ heterocyclic group" as used herein refers to a saturated or unsaturated cyclic group having, as a ring-forming atom, at least one heteroatom selected from N, O, P, Si, S, Se, Ge, and B instead of a carbon ring atom, other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may include, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (, each unsubstituted or substituted with at least one R₁₀ₐ).

In one or more embodiments, examples of the terms "C₅-C₃₀ carbocyclic group" and "C₁-C₃₀ heterocyclic group" as used herein may include i) a first ring, ii) a second ring, iii) a condensed cyclic group in which two or more first rings are condensed with each other, iv) a condensed cyclic group in which two or more second rings are condensed with each other, or v) a condensed cyclic group in which one or more first rings and one or more second rings are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the "fluorinated C₁ alkyl group (that is, the fluorinated methyl group)" may include -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group," as used herein each refer to the respective group wherein at least one ring-forming carbon atom is substituted with nitrogen.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅),-B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅),-B(Q26)(Q27), -P(=O)(Q₂₈)(Q₂₉), -P(Q28)(Q29), or a combination thereof;
-N(Q31)(Q32), -Si(Q₃₃)(Q₃₄)(Q₃₅), -B(Q36)(Q37), -P(=O)(Q₃₈)(Q₃₉), or-P(Q38)(Q39); or
a combination thereof.

Q₁ to Q₉, Q₁₁ to Q₁₉, Q₂₁ to Q₂₉, and Q₃₁ to Q₃₉ described herein may each independently be: hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₁-C₆₀ heteroaryl group; a C₂-C₆₀ heteroaryl alkyl group; a C₁-C₆₀ heteroaryloxy group; a C₁-C₆₀ heteroarylthio group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example 1 (Compound 317)

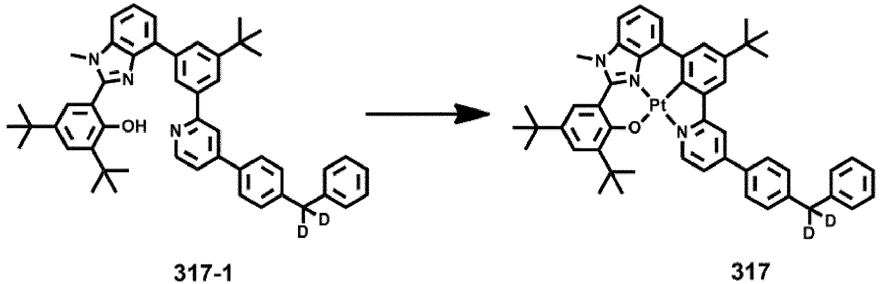

Compound 317-1 (7.9 grams (g), 11.0 millimoles (mmol)) and K₂PtCl₄ (5.5 g, 13.2 mmol) were mixed with 100 milliliters (mL) of acetic acid, the mixture was stirred while refluxing for 18 hours to proceed with the reaction, and then temperature was lowered to room temperature. A solid generated therefrom was filtered, and a column chromatography was performed using methylene chloride (MC) and hexane, to thereby obtain 4.2 g (yield: 42%) of Compound 317.

High resolution mass spectrometry-matrix assisted laser desorption ionization (HRMS (MALDI)) calcd for C₅₀H₄₉D₂N₃OPt: m/z 906.3805 Found: 906.3811

### Synthesis Example 2 (Compound 351)

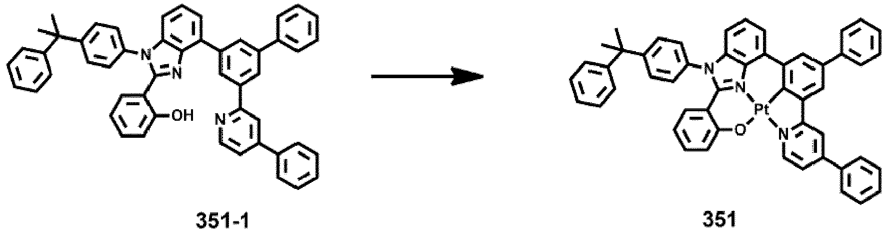

Compound 351-1 (7.9 g, 11.1 mmol) and K₂PtCl₄ (5.5 g, 13.3 mmol) were mixed with 100 mL of acetic acid, the mixture was stirred while refluxing for 18 hours to proceed with the reaction, and then temperature was lowered to room temperature. A solid generated therefrom was filtered, and a column chromatography was performed using MC and hexane, to thereby obtain 3.8 g (yield: 38%) of Compound 351.

HRMS(MALDI) calcd for C₅₁H₃₇N₃OPt: m/z 902.2584 Found: 902.2589

### Synthesis Example 3 (Compound 592)

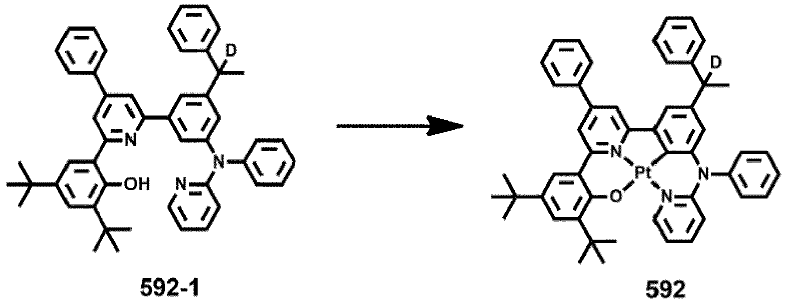

Compound 592-1 (7.9 g, 11.1 mmol) and K₂PtCl₄ (5.5 g, 13.3 mmol) were mixed with 100 mL of acetic acid, the mixture was stirred while refluxing for 18 hours to proceed with the reaction, and then temperature was lowered to room temperature. A solid generated therefrom was filtered, and a column chromatography was performed using MC and hexane, to thereby obtain 3.1 g (yield: 31%) of Compound 592.

HRMS(MALDI) calcd for C₅₀H₄₆DN₃OPt: m/z 901.3430 Found: 901.3420

### Synthesis Example 4 (Compound 741)

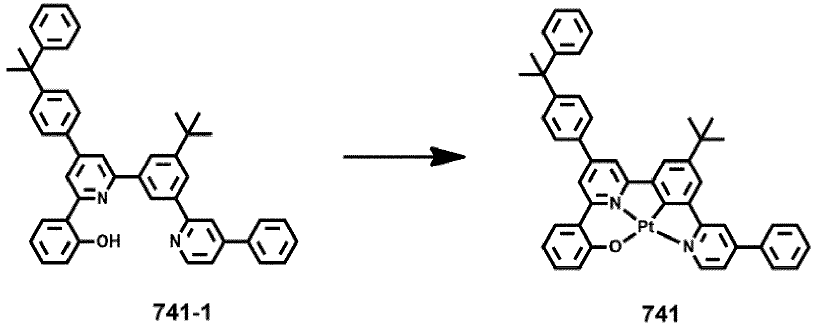

Compound 741-1 (3.9 g, 5.9 mmol) and K₂PtCl₄ (3.0 g, 7.1 mmol) were mixed with 50 mL of acetic acid, the mixture was stirred while refluxing for 18 hours to proceed with the reaction, and then temperature was lowered to room temperature. A solid generated therefrom was filtered, and a column chromatography was performed using MC and hexane, to thereby obtain 2.1 g (yield: 42%) of Compound 741.

HRMS(MALDI) calcd for C₄₇H₄₀N₂OPt: m/z 843.2788 Found: 843.2795

### Synthesis Example A (Compound A)

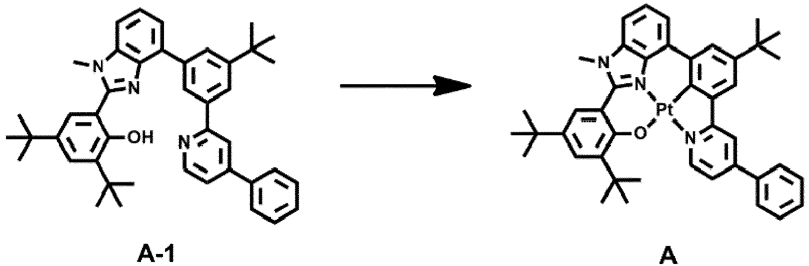

0.5 g (yield: 40%) of Compound A was obtained in the same manner as in Synthesis Example 1, except that Compound A-1 was used instead of Compound 317-1.

HRMS(MALDI) calcd for C₄₃H₄₅N₃OPt: m/z 814.3210 Found: 814.3205

### Synthesis Example B (Compound B)

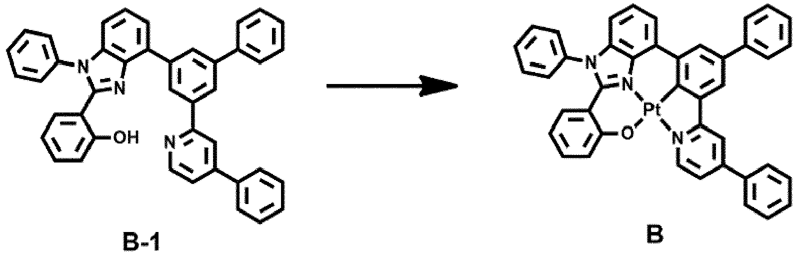

0.4 g (yield: 36%) of Compound B was obtained in the same manner as in Synthesis Example 2, except that Compound B-1 was used instead of Compound 351-1.

HRMS(MALDI) calcd for C₄₂H₂₇N₃OPt: m/z 784.1802 Found: 784.1796

### Synthesis Example C (Compound C)

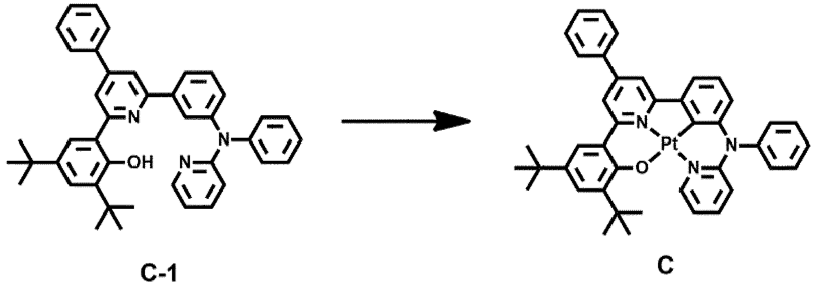

0.6 g (yield: 45%) of Compound C was obtained in the same manner as in Synthesis Example 3, except that Compound C-1 was used instead of Compound 592-1.

HRMS(MALDI) calcd for C₄₂H₃₉N₃OPt: m/z 796.2741 Found: 796.2744

### Synthesis Example D (Compound D)

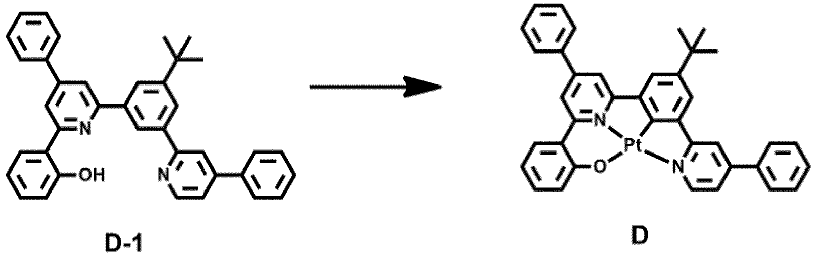

0.2 g (yield: 22%) of Compound D was obtained in the same manner as in Synthesis Example 4, except that Compound D-1 was used instead of Compound 741-1.

HRMS(MALDI) calcd for C₃₈H₃₀N₂OPt: m/z 725.2006 Found: 725.2001

### Example 1

An ITO (as an anode)-patterned glass substrate was cut to a size of 50 millimeters (mm) x 50 mm x 0.5 mm, sonicated with isopropyl alcohol and purified water (deionized water), each for 5 minutes, and then cleaned by irradiation of ultraviolet rays thereto and exposure to ozone for 30 minutes. The resultant glass substrate was loaded onto a vacuum deposition apparatus.

HT3 and F6TCNNQ were vacuum-codeposited on the anode at a weight ratio of 98 : 2 to form a hole injection layer having a thickness of 100 Å, and HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Next, H-H1, H-H2, and Compound 317 (dopant) were co-deposited on the electron blocking layer at a weight ratio of 42.5 : 42.5 : 15 to form an emission layer having a thickness of 400 Å.

Then, ET3 and ET-D1 were co-deposited on the emission layer at a volume ratio of 50 : 50 to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

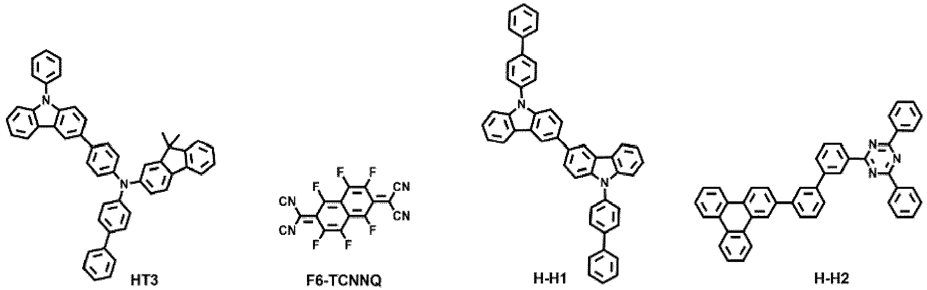

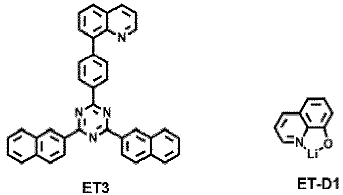

### Examples 2 to 4 and Comparative Examples A to D

Organic light-emitting devices were manufactured in the same manner as in Example 1, except that Compounds shown in Table 2 were each used instead of Compound 317 as a dopant in forming an emission layer.

### Evaluation Example 1: Characterization of organic light-emitting device

With respect to each of the organic light-emitting devices manufactured in Examples 1 to 4 and Comparative Examples A to D, a maximum value of external quantum efficiency (EQEₘₐₓ) (%) and lifespan (LT₉₇)(relative value, %) were evaluated, and results thereof are shown in Table 2. A current-voltage meter (Keithley 2400) and a luminance meter (Minolta Cs-1,000A) were used as apparatuses for evaluation, and the lifespan (LT₉₇) (at 18,000 candela per square meter (cd/m²) or nit) was obtained by measuring the amount of time (hours) that elapsed until luminance was reduced to 97% of the initial luminance of 100%, and the results are expressed as a relative value (%).

**Table 2**

| | Dopant Compound in emission layer | EQEₘₐₓ (%) | LT₉₇ (relative value, %) |
|---|---|---|---|
| Example 1 | 317 | 100% | 100% |
| Comparative Example A | A | 94% | 82% |
| Example 2 | 351 | 94% | 83% |
| Comparative Example B | B | 89% | 73 % |
| Example 3 | 592 | 90% | 65% |
| Comparative Example C | C | 84% | 41% |
| Example 4 | 741 | 100% | 55% |
| Comparative Example D | D | 96% | 45% |

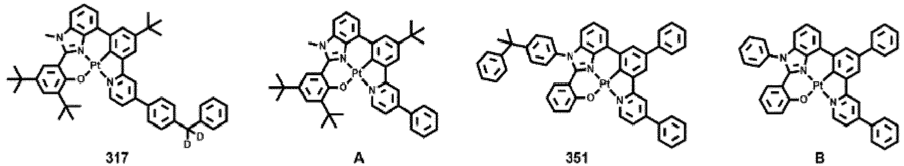

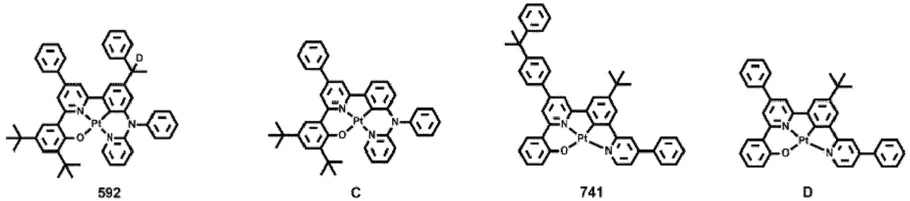

From Table 2, it is seen that each of the organic light-emitting devices of Examples 1 to 4 has higher external quantum efficiency and improved lifespan characteristics, compared to each of the organic light-emitting devices of Comparative Examples A to D.

The organometallic compound as described herein has excellent thermal stability and electrical characteristics. Accordingly, an electronic device, for example, an organic light-emitting device, using the organometallic compound may have improved external quantum efficiency and improved lifespan characteristics, and may emit light having a relatively small full width at half maximum (FWHM).

It should be understood that the exemplary embodiments described herein should be considered in a descriptive sense and not for purposes of limitation. Descriptions of features or aspects within each exemplary embodiment should typically be considered as available for other similar features or aspects in other exemplary embodiments. While one or more exemplary embodiments have been described with reference to the figure, it will be understood by a person having ordinary skill in the art that various changes in form and details may be made without departing from the scope as defined by the following claims.

## Claims

1. An organometallic compound represented by Formula 1: 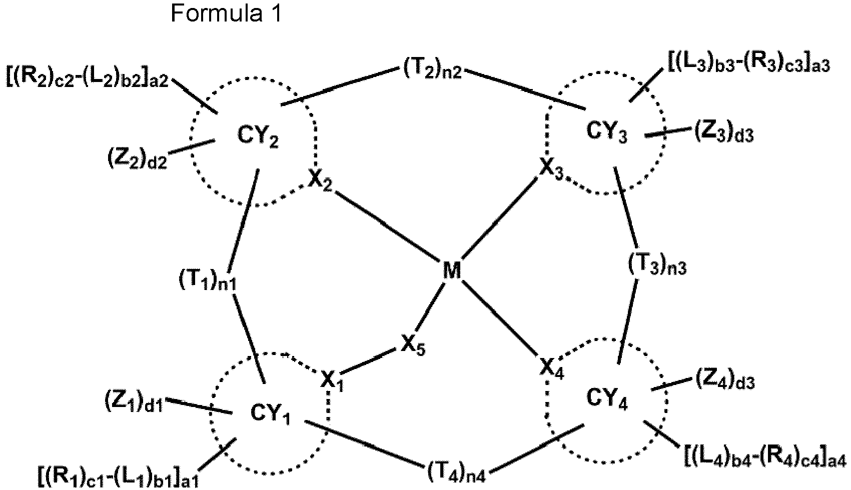
wherein, in Formula 1,
M is a transition metal,
X₁ to X₄ in Formula 1 are each independently C or N,
X₅ in Formula 1 is O, S, N(R'), C(R')(R"), or C(=O),
wherein,
a bond between X₅ and M in Formula 1 is a covalent bond, and
one of a bond between X₂ and M in Formula 1, a bond between X₃ and M in Formula 1, and a bond between X₄ and M in Formula 1 is a covalent bond, and the other two are each a coordinate bond,
ring CY₁ to ring CY₄ in Formula 1 are each independently a C₅-C₃₀ carbocyclic group or a C₁-C₃₀ heterocyclic group,
T₁ to T₄ in Formula 1 are each independently a single bond, a double bond, *-N(R₅ₐ)-*', *-B(R₅ₐ)-*', *-P(R₅ₐ)-*', *-C(R₅ₐ)(R_{5b})*', *-Si(R₅ₐ)(R_{5b})-*', *-Ge(R₅ₐ)(R_{5b})*', *-S-*', *-Se-*', *-O-*', *-C(=O)-*', *-S(=O)-*', *-S(=O)₂-*', *-C(R₅ₐ)-*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
n1 to n4 in Formula 1 are each independently 0 or 1, wherein at least three of n1 to n4 are each 1,
when n1 in Formula 1 is 0, T₁ is not present, when n2 in Formula 1 is 0, T₂ is not present, when n3 in Formula 1 is 0, T₃ is not present, and when n4 in Formula 1 is 0, T₄ is not present,
Z₁ to Z₄ in Formula 1 are each independently a group represented by Formula 51, 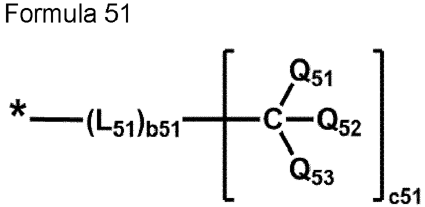
d1 to d4 in Formula 1 are each independently an integer from 0 to 20,
L₁ to L₄ and L₅₁ in Formulae 1 and 51 are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
b1 to b4 and b51 in Formulae 1 and 51 are each independently an integer from 1 to 10,
R₁ to R₄, R₅ₐ, R_{5b}, R', R", and Q₅₁ to Q₅₃ in Formulae 1 and 51 each independently a group represented by Formula 51, hydrogen, deuterium, -F, -CI, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅),-Ge(Q₃)(Q₄)(Q₅), -B(Q₆)(Q₇), -P(=O)(Q₈)(Q₉), or -P(Q₈)(Q₉),
provided that none of Q₅₁ to Q₅₃ is a group represented by Formula 51,
at least one of Q₅₁ to Q₅₃ in Formula 51 is independently a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
c1 to c4 and a1 to a4 in Formula 1 are each independently an integer from 0 to 20,
c51 in Formula 51 is an integer from 1 to 20,
Formula 1 satisfies at least one of Condition 1 and Condition 2,
Condition 1
a sum of d1 to d4 in Formula 1 is 1 or more.
Condition 2
at least one of T₁ to T₄ in Formula 1 is *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-C(R₅ₐ)=*', *=C(R₅ₐ)-*', or *-C(R₅ₐ)=C(R_{5b})-*', and
at least one of R₅ₐ and R_{5b} is a group represented by Formula 51,
two or more of a plurality of R₁(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₂(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₃(s) in Formula 1 are optionally bonded together to form a C₅-C₃₀carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₄(s) in Formula 1 are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of R₁ to R₄, R₅ₐ and one or more of R₁ to R₄, R_{5b} and one or more of R₁ to R₄ , or R₅ₐ and R_{5b} are each optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is the same as defined in connection with R₁,
* and *' each indicate a binding site to a neighboring atom, and
the substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂),-Si(Q₂₃)(Q₂₄)(Q₂₅), -Ge(Q₂₃)(Q₂₄)(Q₂₅), -B(Q26)(Q27), -P(=O)(Q₂₈)(Q₂₉), -P(Q28)(Q29), or a combination thereof;
-N(Q31)(Q32), -Si(Q₃₃)(Q₃₄)(Q₃₅), -Ge(Q₃₃)(Q₃₄)(Q₃₅), -B(Q36)(Q37), - P(=O)(Q₃₈)(Q₃₉), or -P(Q38)(Q39); or
a combination thereof,
wherein Q₁ to Q₉, Q₁₁ to Q₁₉, Q₂₁ to Q₂₉, and Q₃₁ to Q₃₉ are each independently: hydrogen; deuterium; -F; -CI; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or a combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or a combination thereof; a C₆-C₆₀ aryloxy group; a C₆-C₆₀ arylthio group; a C₁-C₆₀ heteroaryl group; a C₁-C₆₀ heteroaryloxy group; a C₁-C₆₀ heteroarylthio group; a monovalent non-aromatic condensed polycyclic group; or a monovalent non-aromatic condensed heteropolycyclic group.

2. The organometallic compound of claim 1, wherein M in Formula 1 is Pt, Pd, or Au.

3. The organometallic compound of claims 1 or 2, wherein
X₂ is N, and
ring CY₂ is:
a benzimidazole group, a pyridine group, a pyrimidine group, a pyridazine group, a pyrazine group, a triazine group, a quinoline group, an isoquinoline group, a quinoxaline group, or a quinazoline group; or
a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, or a combination thereof.

4. The organometallic compound of any of claims 1-3,
wherein T₁ and T₂ in Formula 1 are each a single bond, and
T₃ in Formula 1 is a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

5. The organometallic compound of any of claims 1-4, wherein n1 to n3 in Formula 1 are each 1, and n4 in Formula 1 is 0; and/or
wherein the organometallic compound satisfies at least one of Condition 1A and Condition 2A:
Condition 1A
in Formula 1,
i) d1 is 1, and each of d2, d3, and d4 is 0;
ii) d2 is 1, and each of d1, d3, and d4 is 0;
iii) d3 is 1, and each of d1, d2, and d4 is 0;
iv) d4 is 1, and each of d1, d2, and d3 is 0;
v) each of d1 and d2 is 1, and each of d3 and d4 is 0;
vi) each of d2 and d3 is 1, and each of d1 and d4 is 0; or
vii) each of d2 and d4 is 1, and each of d1 and d3 is 0,
Condition 2A
in Formula 1, n3 is 1, and
i) T₃ is *-N(R₅ₐ)-*', *-B(R₅ₐ)-*', *-P(R₅ₐ)-*', *-C(R₅ₐ)=*', or *=C(R₅ₐ)-*', wherein R₅ₐ is a group represented by Formula 51; or
ii) T₃ is *-C(R₅ₐ)(R_{5b})-*', *-Si(R₅ₐ)(R_{5b})-*', *-Ge(R₅ₐ)(R_{5b})-*', or *-C(R₅ₐ)=C(R_{5b})-*', wherein at least one of R₅ₐ and R_{5b} is a group represented by Formula 51.

6. The organometallic compound of any of claims 1-5, wherein a group represented by *-C(Q₅₁)(Q₅₂)(Q₅₃) in Formula 51 is a group represented by one of Formulae 51-1 to 51-25: 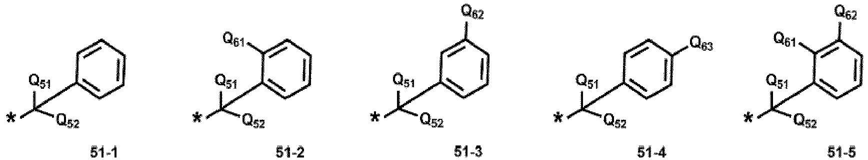 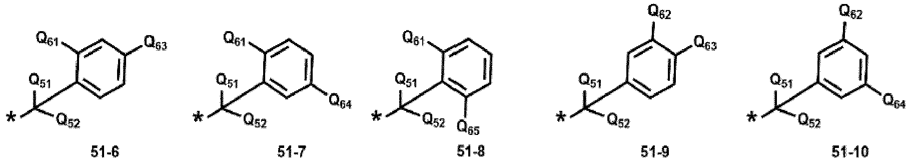 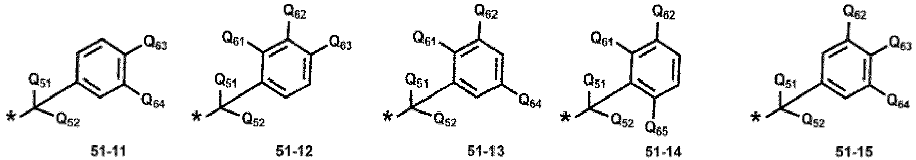 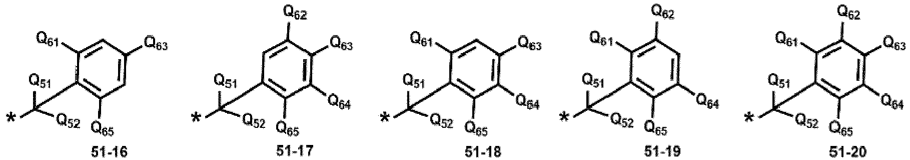 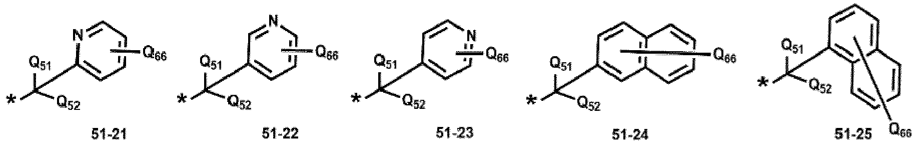 wherein,
Q₅₁ and Q₅₂ in Formulae 51-1 to 51-25 are as defined in claim 1,
Q₆₁ to Q₆₆ in Formulae 51-1 to 51-25 are each independently as defined in connection with R₁₀ₐ in claim 1, provided that none of Q₆₁ to Q₆₅ in Formulae 51-1 to 51-25 is hydrogen, and
* in Formulae 51-1 to 51-25 indicates a binding site to L₅₁ in Formula 51.

7. The organometallic compound of any of claims 1-6, wherein L₅₁ in Formula 51 is a single bond; or
wherein a group represented by Formula 51 is a group represented by one of Formulae 51(1) to 51(19): 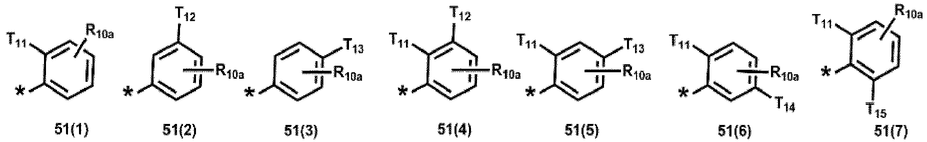 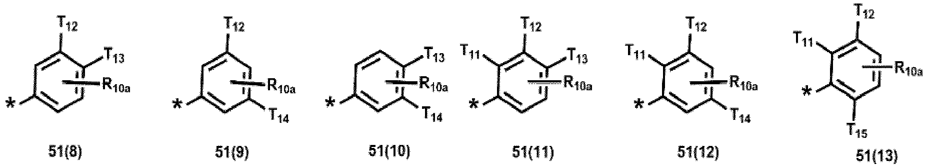 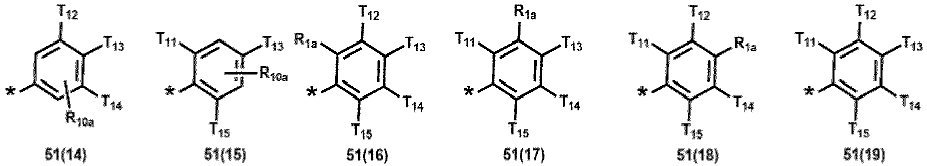 wherein,
T₁₁ to T₁₅ in Formulae 51(1) to 51(19) are each a group represented by *-C(Q₅₁)(Q₅₂)(Q₅₃) in Formula 51,
T₁₁ to T₁₅ in Formulae 51(1) to 51(19) are identical to or different from each other,
R₁₀ₐ in Formulae 51(1) to 51(19) is as defined in connection with R₁ in claim 1, and
* in Formulae 51(1) to 51(19) indicates a binding site to a neighboring atom.

8. The organometallic compound of any of claims 1-7, wherein, in Formula 1,
n1 is 1,
n4 is 0, and
a group represented by 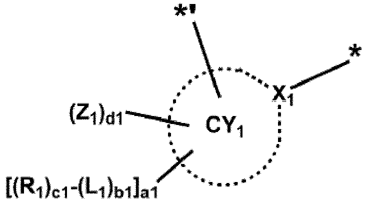 is a group represented by one of Formulae CY1-1 to CY1-18 or ZCY1-1 to ZCY1-32: 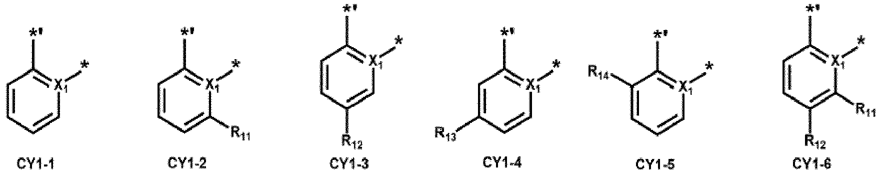 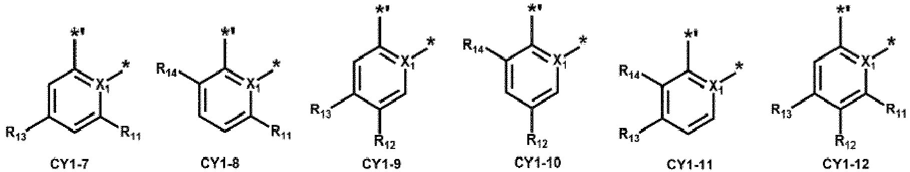 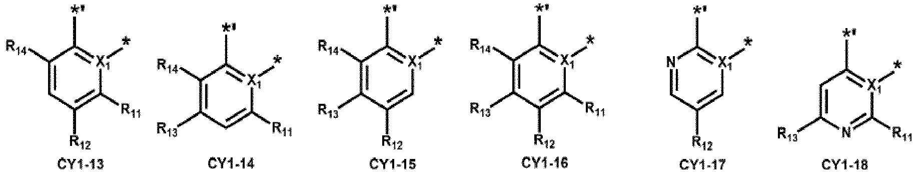 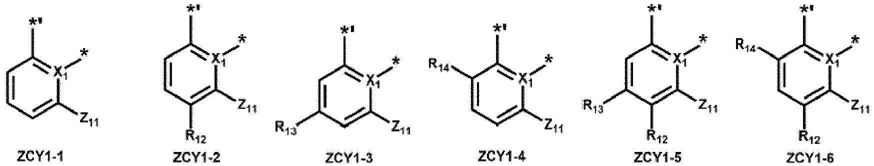 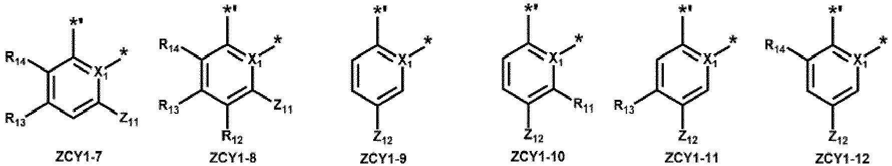 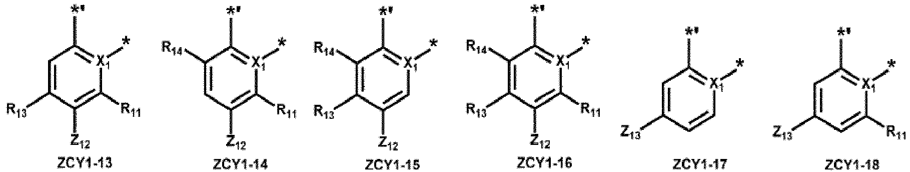 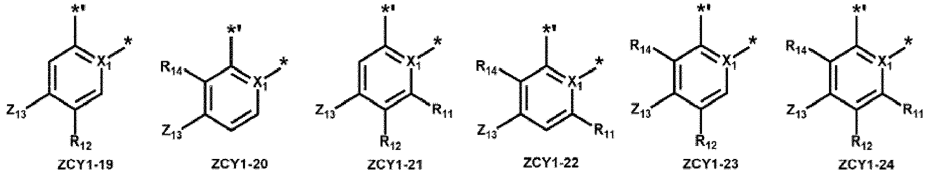 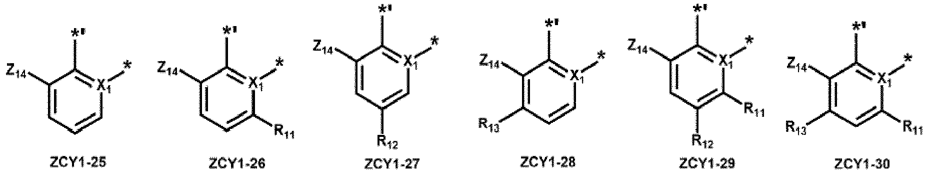 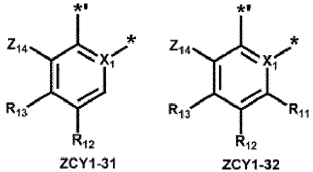 wherein, in Formulae CY1-1 to CY1-18 and ZCY1-1 to ZCY1-32,
X₁ is as defined in claim 1,
R₁₁ to R₁₄ are each independently as defined in connection with R₁ in claim 1, provided that each of R₁₁ to R₁₄ is not hydrogen,
Z₁₁ to Z₁₄ are each independently as defined in connection with Z₁ in claim 1,
* indicates a binding site to X₅ in Formula 1, and
*' indicates a binding site to T₁ in Formula 1.

9. The organometallic compound of any of claims 1-8, wherein, in Formula 1,
each of n1 and n2 is 1, and
a group represented by 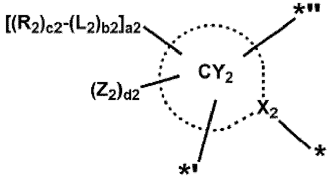 is a group represented by one of Formulae CY2-1 to CY2-16 or ZCY2-1 to ZCY2-19: 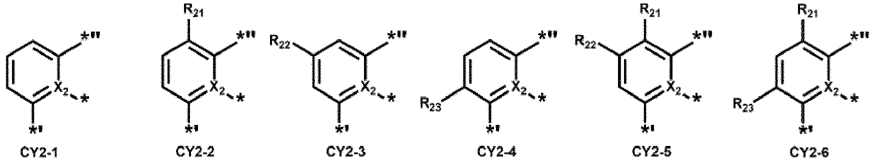 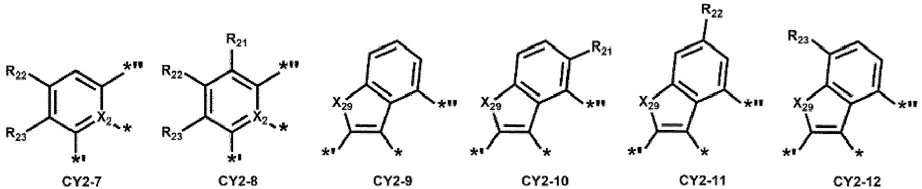 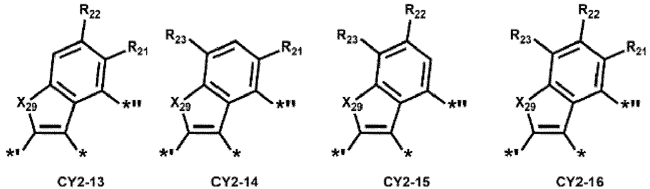 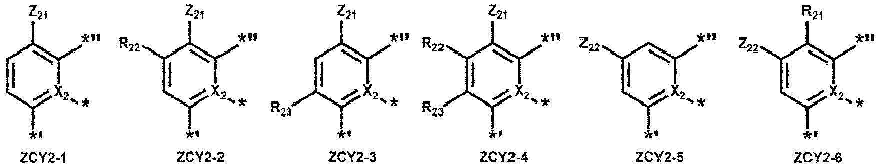 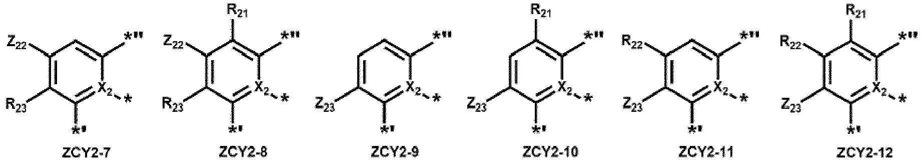 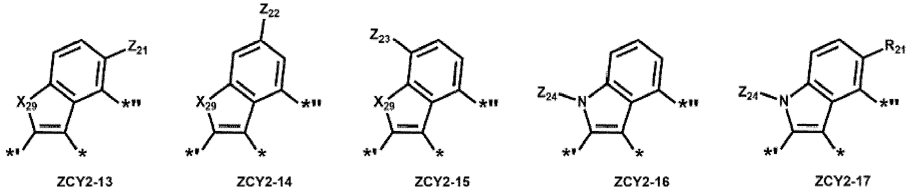 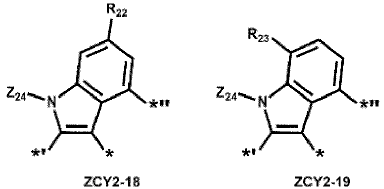 wherein, in Formulae CY2-1 to CY2-16 and ZCY2-1 to ZCY2-19,
X₂ is as defined in claim 1,
X₂₉ is O, S, N-[(L₂)_{b2}-(R₂)_{c2}], C(R₂₉ₐ)(R_{29b}), or Si(R₂₉ₐ)(R_{29b}),
L₂, b2, R₂, and c2 are each independently as defined in claim 1,
Z₂₁ to Z₂₄ are each independently as defined in connection with Z₂ in claim 1,
R₂₁ to R₂₃, R₂₉ₐ, and R_{29b} are each independently as defined in connection with R₂ in claim 1, provided that each of R₂₁ to R₂₃ is not hydrogen,
*' indicates a binding site to T₁ in Formula 1,
* indicates a binding site to M in Formula 1, and
*" indicates a binding site to T₂ in Formula 1.

10. The organometallic compound of any of claims 1-9, wherein, in Formula 1,
each of n2 and n3 is 1, and
a group represented by 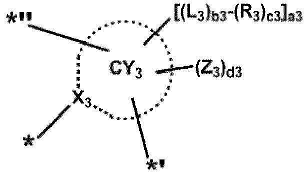 is a group represented by one of Formulae CY3-1 to CY3-13 or ZCY3-1 to ZCY3-12: 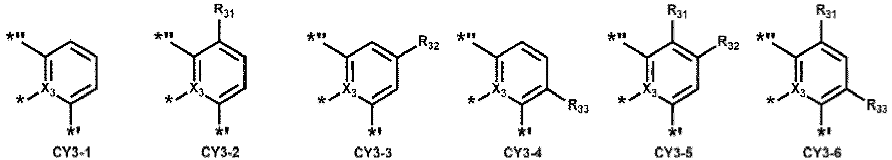 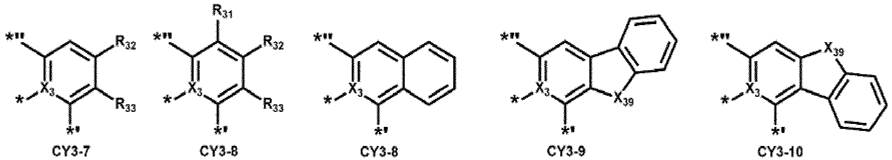 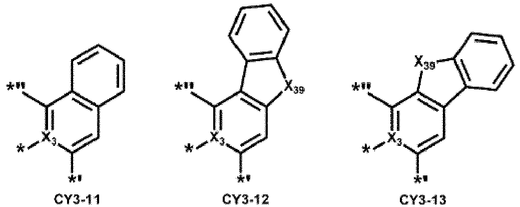 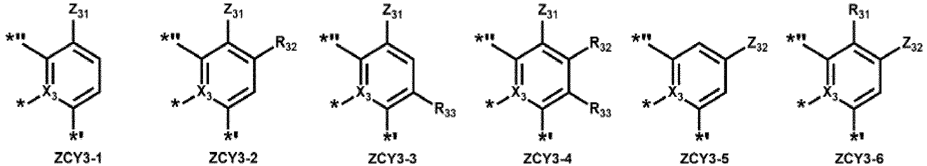 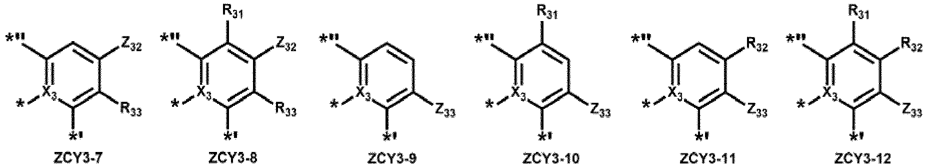 wherein, in Formulae CY3-1 to CY3-13 and ZCY3-1 to ZCY3-12,
X₃ is as defined in claim 1,
X₃₉ is O, S, N-[(L₃)_{b3}-(R₃)_{c3}], C(R₃₉ₐ)(R_{39b}), or Si(R₃₉ₐ)(R_{39b}),
L₃, b3, R₃, and c3 are each independently as defined in claim 1,
R₃₁ to R₃₃, R₃₉ₐ, and R_{39b} are each independently as defined in connection with R₃ in claim 1, provided that each of R₃₁ to R₃₃ is not hydrogen,
Z₃₁ to Z₃₃ are each independently as defined in connection with Z₃ in claim 1,
*" indicates a binding site to T₂ in Formula 1,
* indicates a binding site to M in Formula 1, and
*' indicates a binding site to T₃ in Formula 1.

11. The organometallic compound of any of claims 1-10, wherein, in Formula 1,
n3 is 1 and n4 is 0, and
a group represented by 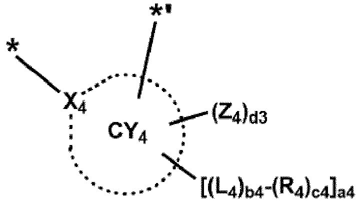 is a group represented by one of Formulae CY4-1 to CY4-16 or ZCY4-1 to ZCY4-32: 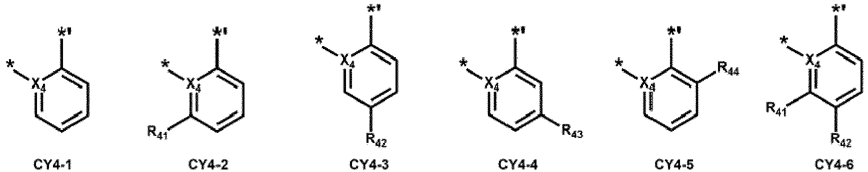 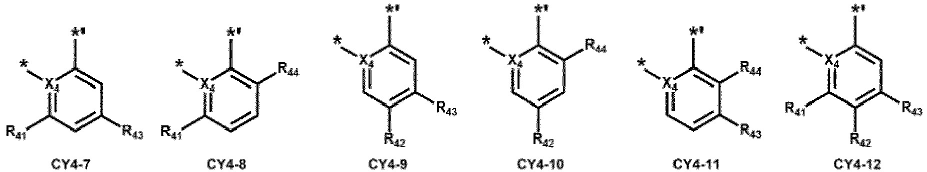 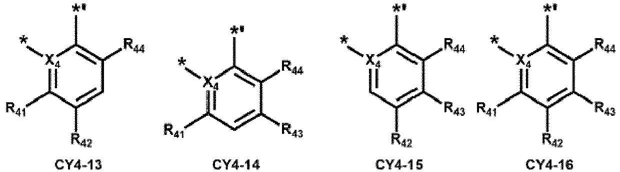 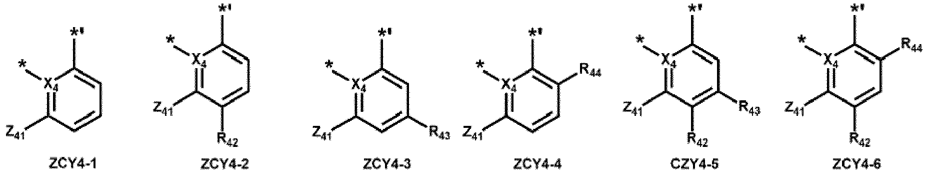 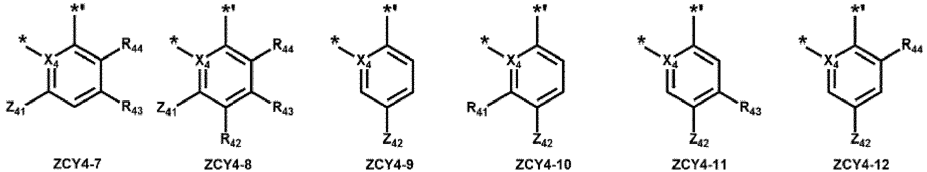 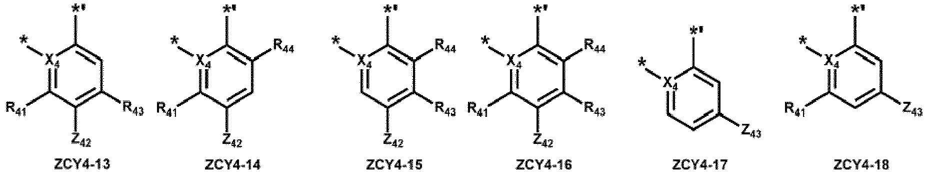 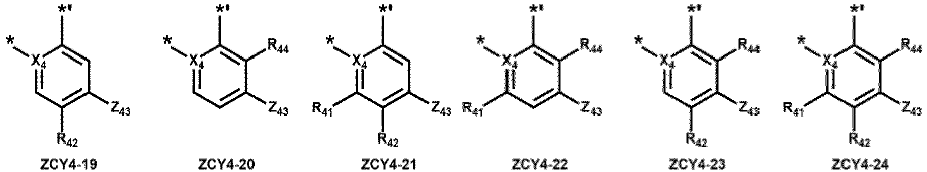 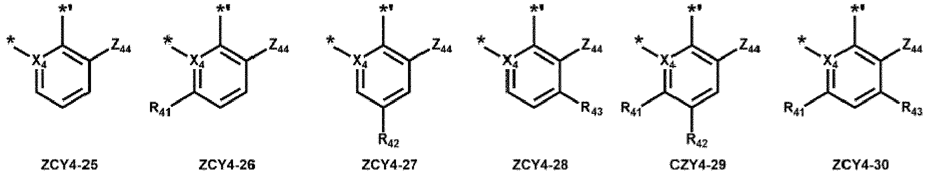 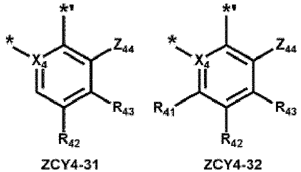 wherein, in Formulae CY4-1 to CY4-16 and ZCY4-1 to ZCY4-32,
X₄ is as defined in claim 1,
R₄₁ to R₄₄ are each independently as defined in connection with R₄ in claim 1, provided that each of R₄₁ to R₄₄ is not hydrogen,
Z₄₁ to Z₄₄ are each independently as defined in connection with Z₄ in claim 1,
*' indicates a binding site to T₃ in Formula 1, and
* is a binding site to M in Formula 1.

12. The organometallic compound of any of claims 1-11, wherein the organometallic compound is represented by one of Formulae 1-1 to 1-4: 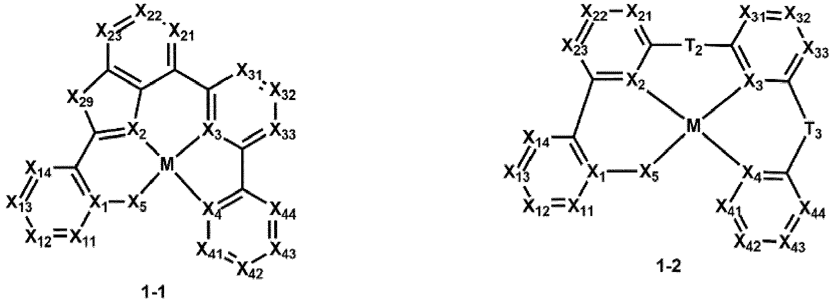 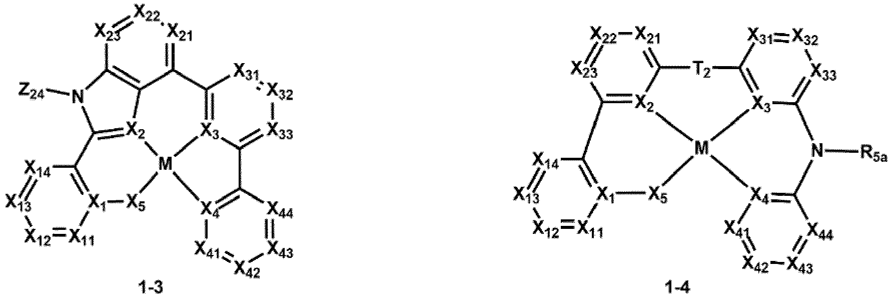
wherein, in Formulae 1-1 to 1-4,
M, X₁ to X₅, T₂, and T₃ are each independently as defined in claim 1,
X₁₁ is N, C(R₁₁), or C(Z₁₁), X₁₂ is N, C(R₁₂), or C(Z₁₂), X₁₃ is N, C(R₁₃), or C(Z₁₃), and X₁₄ is N, C(R₁₄), or C(Z₁₄),
R₁₁ to R₁₄ are each independently as defined in connection with R₁ in claim 1,
Z₁₁ to Z₁₄ are each independently as defined in connection with Z₁ in claim 1,
two or more of R₁₁ to R₁₄ are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
X₂₁ is N, C(R₂₁), or C(Z₂₁),
X₂₂ is N, C(R₂₂), or C(Z₂₂),
X₂₃ is N, C(R₂₃), or C(Z₂₃),
X₂₉ is O, S, N-[(L₂)_{b2}-(R₂)_{c2}], C(R₂₉ₐ)(R_{29b}), or Si(R₂₉ₐ)(R_{29b}),
L₂, b2, R₂, and c2 are each independently as defined in claim 1,
R₂₁ to R₂₃, R₂₉ₐ, and R_{29b} are each independently as defined in connection with R₂ in claim 1,
Z₂₁ to Z₂₄ are each independently as defined in connection with Z₂ in claim 1,
two or more of R₂₁ to R₂₃ are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
X₃₁ is N, C(R₃₁), or C(Z₃₁),
X₃₂ is N, C(R₃₂), or C(Z₃₂),
X₃₃ is N, C(R₃₃), or C(Z₃₃),
R₃₁ to R₃₃ are each independently as defined in connection with R₃ in claim 1,
Z₃₁ to Z₃₃ are each independently as defined in connection with Z₃ in claim 1,
two or more of R₃₁ to R₃₃ are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
X₄₁ is N, C(R₄₁), or C(Z₄₁),
X₄₂ is N, C(R₄₂), or C(Z₄₂),
X₄₃ is N, C(R₄₃), or C(Z₄₃),
X₄₄ is N, C(R₄₄), or C(Z₄₄),
R₄₁ to R₄₄ are each independently as defined in connection with R₄ in claim 1,
Z₄₁ to Z₄₄ are each independently as defined in connection with Z₄ in claim 1,
two or more of R₄₁ to R₄₄ are optionally bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
wherein Formulae 1-1 and 1-2 each include one of Z₁₁ to Z₁₄, one of Z₂₁ to Z₂₃, one of Z₃₁ to Z₃₃, one of Z₄₁ to Z₄₄, or a combination thereof, and
R₅ₐ in Formula 1-4 is a group represented by Formula 51;
preferably wherein
i) the organometallic compound is represented by Formula 1-1 or 1-2, and Formulae 1-1 and 1-2 each satisfy at least one of Condition (1') to Condition (3');
ii) the organometallic compound is represented by Formula 1-3 or 1-4; or
iii) the organometallic compound is represented by Formula 1-3 or 1-4, and Formulae 1-3 and 1-4 each satisfy at least one of Condition (1') to Condition (3'):
Condition (1')
X₂₂ is C(Z₂₂)
Condition (2')
X₃₂ is C(Z₃₂)
Condition (3')
X₄₃ is C(Z₄₃),
wherein,
Z₂₂, Z₃₂, and Z₄₃ are each independently as defined in claim 12

13. An organic light-emitting device, comprising:
a first electrode;
a second electrode; and
an organic layer located between the first electrode and the second electrode,
wherein the organic layer comprises an emission layer, and
wherein the organic layer comprises the at least one organometallic compound of any of claims 1-12;
preferably wherein
the first electrode is an anode,
the second electrode is a cathode,
the organic layer further comprises a hole transport region located between the first electrode and the emission layer, and an electron transport region located between the emission layer and the second electrode,
the hole transport region comprises a hole injection layer, a hole transport layer, an electron blocking layer, or a combination thereof, and
the electron transport region comprises a hole blocking layer, an electron transport layer, an electron injection layer, or a combination thereof.

14. The organic light-emitting device of claim 13, wherein the at least one organometallic compound is included in the emission layer;
preferably wherein
the emission layer further comprises a host, and
an amount of the host is greater than an amount of the at least one organometallic compound in the emission layer.

15. An electronic apparatus, comprising the organic light-emitting device of any of claims 13 or 14.
